# EUROPEAN PATENT APPLICATION

(11) **EP 4 530 709 A1**
(43) Date of publication of application: **02.04.2025**
(21) Application number: 23200213.9
(22) Date of filing: 27.09.2023
(51) Int. Cl.: G02F 1/00, G02B 5/28, G02B 6/13, G02F 1/035, H01L 31/0392

(54) **METHOD FOR PRODUCING PLANARIZED SURFACES IN LAYERED STRUCTURES USED FOR PRODUCING OPTO-ELECTRONIC DEVICES**

(71) Applicant: Black Semiconductor GmbH, 52072 Aachen (DE)
(72) Inventor: HUYGHEBAERT, Cedric, 52072 Aachen (DE)
(74) Representative: Herzog IP Patentanwalts GmbH

(57) **Abstract**

A method for producing a layered structure, comprising the steps of
a. providing an intermediate layered structure that comprises
i. an element of a first kind, wherein the element of the first kind has a first surface and a thickness *d₁*, measured along a first direction, wherein *d₁* ≤ 1.5 µm;
ii. a layer of a second kind superimposed on at least the first surface of the element of the first kind, wherein the layer of the second kind has a first surface and a thickness *d₂*, measured along the first direction, wherein *d₂* ≤ 100 nm;
iii. a first layer of a further kind that at least partially surrounds the element of the first kind, wherein a first section of the first layer of the further kind is superimposed on the first surface of the layer of the second kind, and a further section of the first layer of the further kind is arranged at a first distance *l₃* from the element of the first kind, wherein the first distance *l₃* is measured along a further direction, wherein the further direction is perpendicular to the first direction, and *l₃* ≤ 100 nm, and the first section has a first thickness *d_{3A}* and the further section has a further thickness *d_{3B}*, measured along the first direction;

b. reducing the first thickness *d_{3A}*, and preferably the further thickness *d_{3B}*, of the first layer of the further kind, using a first thickness-reducing technique, wherein at least one or all of the following applies:
i. *d_{3A}* is reduced by at least 20 %, preferably at least 50 %, more preferably at least 70 %, further preferably at least 90 %, and even further preferably at least 99 %,
ii. after reduction, *d_{3A}* ≤ 100 nm;

wherein at least one property varies between the layer of the second kind and the element of the first kind, the layer of the second kind and the first layer of the further kind, or both.

## Description

### FIELD OF THE INVENTION

The invention pertains to methods for producing a layered structure, wherein said layered structure preferably comprises a waveguide. The invention also pertains to a method for producing an opto-electronic device using the layered structure, wherein said opto-electronic device preferably comprises one or more graphene layers.

### BACKGROUND

Opto-electronic devices such as modulators and photodetectors are important electronic components for optical communication systems, *e.g.,* data transmission via fibre optics. Some of the important parameters for these devices are bandwidth, operation speed, extinction ratio, insertion loss, energy consumption, and footprint. One option is silicon-based modulators. However, silicon modulators have a number of disadvantages. For example, silicon-based modulators have a narrow bandwidth. Furthermore, in order to integrate a silicon-based modulator with other electronic components, such as CMOS integrated circuits, silicon-based modulators have to be produced as part of a front-end-of-line process. In addition, silicon-based modulators cannot easily be integrated with newer technologies that are being developed in the electronic industry. This is in contrast to graphene-based modulators, which have a number of advantages. For example, graphene-based modulators have a broader bandwidth compared to silicon-based modulators. Furthermore, graphene-based modulators can be integrated with other electronic components as part of a back-end-of-line process, without requiring significant development to enable the integration. Graphene-based modulators can also be more easily integrated with newer technologies in the electronic industry. Graphene-based modulators further allow for a better use of surface area, and thus a more compact electronic device or system. Examples of graphene-based modulators are disclosed in, *e.g.,* Liu et al. (2011), A graphene-based broadband optical modulator, Nature, 474, 65, and Liu et al. (2012), Double-layer graphene optical modulator, Nano Letter, 12, 1482.

Producing graphene-based opto-electronic devices remains challenging. In particular, it is required that any surface onto which the graphene is deposited is highly planarized. Discontinuities in said surface, such as step discontinuities, can lead to stresses in the graphene layer, which in turn can lead to the graphene layer breaking. This is especially the case if the graphene layer is not conformal with the discontinuities. However, due to local strain variations, a graphene layer that is conformal with the discontinuities also leads to problems with controlling electrical properties, such as potential difference and electric fields, in the opto-electronic device. It is also highly desirable to have the one or more graphene layers as close as possible to the waveguide of the opto-electronic device. However, to obtain a sufficiently planarized surface that also reduces the distances between the waveguide and the one or more graphene layers is still an open problem to be solved.

### OBJECTS

An object of the present invention is to at least partially overcome at least one of the disadvantages encountered in the state of the art.

It is a further object of the invention to provide a method for producing a layered structure, wherein the layered structure is used for the production of an opto-electronic device.

It is a further object of the invention to provide a method for producing a layered structure, wherein the layered structure is used for the production of an opto-electronic device, and wherein the layered structure has a flatter surface.

It is a further object of the invention to provide a method for producing a layered structure, wherein the layered structure is used for the production of an opto-electronic device, and wherein the largest discontinuity of the layered structure is reduced.

It is a further object of the invention to provide a method for producing a layered structure, wherein the layered structure is used for the production of an opto-electronic device, and wherein use of the layered structure reduces the damage of electrically conducting elements deposited on the layered structure. An example of an electrically conducting element is a graphene layer or a perovskite layer.

It is a further object of the invention to provide a method for producing a layered structure, wherein the layered structure is used for the production of an opto-electronic device, and wherein use of the layered structure allows for a reduction in the distance between an element of the first kind and an electrically conducting element. An example of an element of the first kind is a waveguide adapted and arranged for the propagation of electromagnetic waves.

An example of an electrically conducting element is a graphene layer or a perovskite layer.

It is a further object of the invention to provide a method for producing a layered structure, wherein the layered structure is used for the production of an opto-electronic device, and wherein use of the layered structure allows for the production of a plurality of opto-electronic devices that are more uniform.

It is an object of the invention to provide an opto-electronic device that has an increased bit-rate.

It is an object of the invention to provide a modulator that has a reduced insertion loss.

It is an object of the invention to provide a modulator that uses less energy.

It is an object of the invention to provide a photodetector that has an improved responsivity.

It is an object of the invention to provide a photodetector wherein the distance between the maximum intensity of the electromagnetic waves, propagating in the waveguide of the photodetector, and the graphene layer of the photodetector is reduced.

### PREFERRED EMBODIMENTS OF THE INVENTION

A contribution to at least partially fulfilling at least one of the above-mentioned objects is made by any of the embodiments of the invention.

A 1^{st} embodiment of the invention is a first method for producing a layered structure, comprising the steps of
a. providing an intermediate layered structure that comprises
   i. an element of a first kind, wherein the element of the first kind
      A. has a first surface,
      B. has a thickness *d₁,* measured along a first direction, wherein *d₁* ≤ 1.5 µm;
   ii. a layer of a second kind superimposed on at least the first surface of the element of the first kind, wherein the layer of the second kind
      A. has a first surface,
      B. has a thickness *d₂,* measured along the first direction, wherein *d₂* ≤ 100 nm;
   iii. a first layer of a further kind that at least partially surrounds the element of the first kind, wherein
      A. a first section of the first layer of the further kind is superimposed on the first surface of the layer of the second kind,
      B. a further section of the first layer of the further kind is arranged at a first distance *l*₃ from the element of the first kind, wherein
         I./ the first distance *l*₃ is measured along a further direction, wherein the further direction is perpendicular to the first direction, and
         II./ *l*₃ ≤ 100 nm,
      C. the first section has a first thickness *d_{3A}* and the further section has a further thickness *d_{3B},* measured along the first direction;
b. reducing the first thickness *d_{3A},* and preferably the further thickness *d_{3B},* of the first layer of the further kind, using a first thickness-reducing technique, wherein at least one or all of the following applies:
   i. *d_{3A}* is reduced by at least 20 %, preferably at least 50 %, more preferably at least 70 %, further preferably at least 90 %, and even further preferably at least 99 %,
   ii. after reduction, *d_{3A}* ≤ 100 nm;
   wherein
   at least one property varies between the layer of the second kind and the element of the first kind,
   the layer of the second kind and the first layer of the further kind, or both.

In an aspect of the 1^{st} embodiment, it is preferred that the layered structure is obtained after the reduction step has been completed. In another aspect of the 1^{st} embodiment, it is preferred that the layered structure is obtained following the completion of the reduction step and at least one further method step. In an aspect of the 1^{st} embodiment, it is preferred that a cross-sectional cut of the intermediate layered structure, made at the position of the element of the first kind, has the following layers and element, in this order: the element of the first kind, the layer of the second kind, and the first section of the first layer of the further kind. In an aspect of the 1^{st}, it is preferred that at least two, more preferably all, of the following match by less than 90 wt-%, more preferably by less than 80 wt-%, even more preferably less than 70 wt-%, even more preferably less than 60 wt-%, even more preferably less than 50 wt-%, and further preferably by less than 40 wt-% in their chemical composition: the element of the first kind, the layer of the second kind, and the first layer of the further kind. In an aspect of the 1^{st} embodiment, feature b., the following combinations are preferred aspects of the embodiment: b.i; b.ii; b.i + b.ii. The combination b.i + b.ii is particularly preferred. In an aspect of the 1^{st} embodiment, it is particularly preferred that the first thickness-reducing technique is chemical-mechanical polishing. In an aspect of the 1^{st} embodiment, it is particularly preferred that the first thickness *d_{3A}* is reduced such that the layer of the second kind is at least partially exposed. In an aspect of the 1^{st} embodiment, it is particularly preferred that the element of the first kind is a waveguide that is adapted and arranged for the propagation of electromagnetic waves. In an aspect of the 1^{st} embodiment, it is particularly preferred that the layered structure that is obtainable from the 1^{st} embodiment is suitable to be used for the production of an opto-electronic device, more preferably an opto-electronic device comprising graphene. In an aspect of the 1^{st} embodiment, it is particularly preferred that the at least one property varies between the layer of the second kind and the first layer of the further kind.

In a preferred embodiment of the first method for producing a layered structure, the at least one property is at least one or all of the following:
a. a hardness, *e.g.,* a scratch hardness, an indentation hardness, a rebound hardness, or a combination of at least two thereof;
b. a chemical reaction rate, preferably a chemical reaction rate of a chemical reaction involving a processing chemical substance used in chemical-mechanical polishing;
c. an etch rate;
d. a material removal rate, preferably a material removal rate during employment of a method adapted and arranged for reducing the first thickness *d_{3A}* of the first layer of the further kind, the further thickness *d_{3B}* of the first layer of the further kind, or both. It is particularly preferred that the material removal rate is during chemical-mechanical polishing;
e. a chemical composition;
f. an oxidation rate;
g. an optical attenuation coefficient;
h. a refractive index;
i. an electrical conductivity;
j. a thermal conductivity;
k. a laser ablation rate.

This preferred embodiment is a 2^{nd} embodiment of the invention, that preferably depends on the 1^{st} embodiment of the invention.

In an aspect of the 2^{nd} embodiment, all combinations of the features a. to k. are preferred aspects of the embodiment. In an aspect of the 2^{nd} embodiment, the combination of the features a. to f. are more preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f. In another aspect of the 2^{nd} embodiment, all possible combination of the features b. to d. are particularly preferred aspects of the embodiment. These combinations are, *e.g.,* b; c; d; b+c; b+d; c+d; b+c+d.

In a preferred embodiment of the first method for producing a layered structure, at least one or all of the following applies:
a. the at least one property is a first etch rate, preferably during employment of the first thickness-reducing technique, wherein the first etch rate of the first layer of the further kind is larger than the first etch rate of the layer of the second kind;
b. the at least one property is a first chemical reaction rate, preferably during employment of the first thickness-reducing technique, wherein the first chemical reaction rate of the first layer of the further kind is larger than the first chemical reaction rate of the layer of the second kind;
c. the at least one property is a first material removal rate, preferably during employment of the first thickness-reducing technique, wherein the first material removal rate of the first layer of the further kind is larger than the first material removal rate of the layer of the second kind;
d. the at least one property is a hardness, preferably during employment of the first thickness-reducing technique, wherein the hardness of the first layer of the further kind is less than the hardness of the layer of the second kind.

This preferred embodiment is a 3^{rd} embodiment of the invention, that preferably depends on any of the 1^{st} to 2^{nd} embodiments of the invention.

In an aspect of the 3^{rd} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 3^{rd} embodiment, all possible combination of the features b. and c. are particularly preferred aspects of the embodiment. These combinations are *e.g.,* b; c; b+c. In yet another aspect of the 3^{rd} embodiment, feature c. is particularly preferred.

In a preferred embodiment of the first method for producing a layered structure, at least one or all of the following applies:
a. the at least one property is a first etch rate, preferably during employment of the first thickness-reducing technique, wherein the first etch rate of the element of the first kind is larger than the first etch rate of the layer of the second kind;
b. the at least one property is a first chemical reaction rate, preferably during employment of the first thickness-reducing technique, wherein the first chemical reaction rate of the element of the first kind is larger than the first chemical reaction rate of the layer of the second kind;
c. the at least one property is a first material removal rate, preferably during employment of the first thickness-reducing technique, wherein the first material removal rate of the element of the first kind is larger than the first material removal rate of the layer of the second kind;
d. the at least one property is a hardness, preferably during employment of the first thickness-reducing technique, wherein the hardness of the element of the first kind is less than the hardness of the layer of the second kind.

This preferred embodiment is a 4^{th} embodiment of the invention, that preferably depends on any of the 1^{st} to 3^{rd} embodiments of the invention.

In an aspect of the 4^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 4^{th} embodiment, all possible combination of the features b. and c. are particularly preferred aspects of the embodiment. These combinations are *e.g.,* b; c; b+c. In yet another aspect of the 4^{th} embodiment, feature c. is particularly preferred.

In a preferred embodiment of the first method for producing a layered structure, at least one or all of the following applies:
a. the first etch rate of the first layer of the further kind is at least 1.1 times, preferably at least 1.5 times, more preferably at least 3 times, more preferably at least 5 times, more preferably at least 10 times, more preferably at least 20 times, more preferably at least 50 times, more preferably at least 100 times, further preferably at least 200 times, further preferably at least 500 times, and even further preferably at least 1000 times larger than the first etch rate of the layer of the second kind;
b. the first material removal rate of the first layer of the further kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the first material removal rate of the layer of the second kind;
c. the first etch rate of the element of the first kind is at least 1.1 times, preferably at least 1.5 times, more preferably at least 3 times, more preferably at least 5 times, more preferably at least 10 times, more preferably at least 20 times, more preferably at least 50 times, more preferably at least 100 times, further preferably at least 200 times, further preferably at least 500 times, and even further preferably at least 1000 times larger than the first etch rate of the layer of the second kind;
d. the first material removal rate of the element of the first kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the first material removal rate of the layer of the second kind.

This preferred embodiment is a 5^{th} embodiment of the invention, that preferably depends on any of the 3^{rd} to 4^{th} embodiments of the invention.

In an aspect of the 5^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In another aspect of the 5^{th} embodiment, all possible combination of the features a. and b. are more preferred aspects of the embodiment. These combinations are *e.g.,* a; b; a+b. In yet another aspect of the 5^{th} embodiment, feature b. is particularly preferred. In an aspect of the 5^{th} embodiment, aspect a., it is preferred that the first etch rate of the first layer of the further kind is in the range of 4 to 200 times, more preferably in the range of 5 to 150 times, and further preferably in the range of 10 to 100 times larger than the first etch rate of the layer of the second kind. In an aspect of the 5^{th} embodiment, aspect b., it is preferred that the first material removal rate of the first layer of the further kind is in the range of 1.5 to 200 times, more preferably in the range of 5 to 150 times, and further preferably in the range of 10 to 100 times larger than the first material removal rate of the layer of the second kind. In an aspect of the 5^{th} embodiment, aspect c., it is preferred that the first etch rate of the element of the first kind is in the range of 4 to 200 times, more preferably in the range of 5 to 150 times, and further preferably in the range of 10 to 100 times larger than the first etch rate of the layer of the second kind. In an aspect of the 5^{th} embodiment, aspect d., it is preferred that the first material removal rate of the element of the first kind is in the range of 1.5 to 200 times, more preferably in the range of 5 to 150 times, and further preferably in the range of 10 to 100 times larger than the first material removal rate of the layer of the second kind.

In a preferred embodiment of the first method for producing a layered structure, after the reduction step in the 1^{st} embodiment has been completed (step b.), the first section has a first thickness *d_{3A}* ≤ 50 nm, more preferably *d_{3A}* ≤ 20 nm, even more preferably *d_{3A}* ≤ 10 nm, further preferably *d_{3A}* ≤ 5 nm, further preferably *d_{3A}* ≤ 2 nm, and even further preferably *d_{3A}* ≤ 1 nm. This preferred embodiment is a 6^{th} embodiment of the invention, that preferably depends on any of the 1^{st} to 5^{th} embodiments of the invention.

In an aspect of the 6^{th} embodiment, it is preferred that the thickness *d₂* of the layer of the second kind is also reduced as part of the "reducing" step. In this aspect, it is however, preferred that the thickness d₂ of the layer of the second kind *d*₂ > 0 nm after completion of the "reduction step". In this aspect, it is preferred that the thickness *d*₂ is reduced by less than 20 %, more preferably by less than 10 %, and further preferably by less than 5 %. In an aspect of the 6^{th} embodiment, it is preferred that the first section is removed, *i.e., d_{3A}* = 0 nm.

In a preferred embodiment of the first method for producing a layered structure, at least one or all of the following applies:
a. the thickness *d*₂ of the layer of the second kind is *d₂* ≤ 80 nm, preferably *d₂* ≤ 60 nm, more preferably *d₂* ≤ 40 nm, even more preferably *d₂* ≤ 20 nm, further preferably *d₂* ≤ 10 nm, further preferably *d₂* ≤ 5 nm, further preferably *d₂* ≤ 2 nm, and even further preferably *d₂* ≤ 1 nm;
b. the first distance *l*₃ is *l*₃ ≤ 80 nm, preferably *l*₃ ≤ 60 nm, more preferably *l*₃ ≤ 40 nm, even more preferably *l*₃ ≤ 20 nm, further preferably *l*₃ ≤ 10 nm, further preferably *l*₃ ≤ 5 nm, further preferably *l*₃ ≤ 2 nm, and even further preferably *l*₃ ≤ 1 nm.

This preferred embodiment is a 7^{th} embodiment of the invention, that preferably depends on any of the 1^{st} to 6^{th} embodiments of the invention.

In an aspect of the 7^{th} embodiment, all possible combination of the features a. and b. are preferred aspects of the embodiment. These combinations are *e.g.,* a; b; a+b. In an aspect of the 7^{th} embodiment, it is preferred that the thickness *d₂* is measured prior to the start of the reduction step in the 1^{st} embodiment (step b.). In an aspect of the 7^{th} embodiment, it is preferred that the thickness *d₂* of the layer of the second kind is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm. In an aspect of the 7^{th} embodiment, it is preferred that the first distance *l*₃ is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm. In another aspect of the 7^{th} embodiment, it is preferred that the element of the first kind touches the further section of the first layer of the further kind (*l*₃ = 0 nm).

In a preferred embodiment of the first method for producing a layered structure, at least one or all of the following applies:
a. the thickness *d₁* of the element of the first kind is in the range of 1 nm to 1500 nm, preferably in the range of 1 nm to 1250 nm, preferably in the range of 1 nm to 1100 nm, preferably in the range of 1 nm to 900 nm, preferably in the range of 10 nm to 700 nm, more preferably in the range of 20 nm to 600 nm, even more preferably in the range of 40 nm to 500 nm, and further preferably in the range of 50 nm to 400 nm;
b. the first thickness *d_{3A}* of the first section of the first layer of the further kind is in the range of 0.5 to 5 times, preferably in the range of 1 to 4 times, and more preferably in the range of 2 to 3 times larger than the thickness *d₁* of the element of the first kind;
c. the further thickness *d_{3B}* of the further section of the first layer of the further kind is in the range of 0.5 to 5 times, preferably in the range of 1 to 4 times, and more preferably in the range of 2 to 3 times larger than the thickness *d₁* of the element of the first kind.

This preferred embodiment is an 8^{th} embodiment of the invention, that preferably depends on any of the 1^{st} to 7^{th} embodiments of the invention.

In an aspect of the 8^{th} embodiment, all possible combination of the features a. to c. are preferred aspects of the embodiment. These combinations are *e.g.,* a; b; c; a+b; a+c; b+c; a+b+c. In an aspect of the 8^{th} embodiment, it is preferred that at least one, preferably all thickness are prior to the start of the reduction step in the 1^{st} embodiment (step b.). In this aspect, these thicknesses include *d₁, d_{3A},* and *d_{3B}.*

In a preferred embodiment of the first method for producing a layered structure, during the step of reducing the first thickness *d_{3A},* both the first thickness *d_{3A}* and the further thickness *d_{3B}* of the first layer of the further kind are reduced using the first thickness-reducing technique, wherein the first thickness *d_{3A}* is reduced by a value *V_{3A},* the further thickness *d_{3B}* is reduced by a value *V_{3B},* and wherein *V_{3A}* and *V_{3B}* vary by less than 20 %, preferably by less than 10 %, and more preferably by less than 5 %. This preferred embodiment is a 9^{th} embodiment of the invention, that preferably depends on any of the 1^{st} to 8^{th} embodiments of the invention.

In a preferred embodiment of the first method for producing a layered structure, the first thickness-reducing technique is at least one of the following:
a. chemical-mechanical polishing;
b. wet etching;
c. dry etching;
d. laser ablation.

This preferred embodiment is a 10^{th} embodiment of the invention, that preferably depends on any of the 1^{st} to 9^{th} embodiments of the invention.

In an aspect of the 10^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In another aspect of the 10^{th} embodiment, chemical-mechanical polishing is particularly preferred.

In a preferred embodiment of the first method for producing a layered structure, prior to the method step of providing the intermediate layered structure, the method further comprises the steps of:
I.) providing the element of the first kind, wherein the element of the first kind is preferably provided by the following sub-steps:
   A1. providing a layer of the first kind;
   A2. optionally,
      i. depositing a masking layer on the layer of the first kind, and
      ii. removing at least one section of the masking layer to at least partially expose the layer of the first kind;
   A3. reducing a thickness of at least one section of the layer of the first kind to obtain the element of the first kind;
   A4. optionally, at least partially removing the masking layer;
II.) depositing the layer of the second kind such that the layer of the second kind is superimposed on at least the first surface of the element of the first kind, and wherein the layer of the second kind is preferably deposited such that
   (a) preferably, the layer of the second kind at least partially surrounds the element of the first kind, more preferably partially surrounds the element of the first kind;
   (b) preferably, the layer of the second kind is superimposed on at least 50 %, more preferably at least 75 %, and further preferably at least 95 % of a surface area of the first surface of the element of the first kind;
III.) depositing the first layer of the further kind such that the first layer of the further kind at least partially surrounds the element of the first kind and preferably the layer of the second kind, and wherein the first layer of the further kind is deposited such that
   (a) the first section of the first layer of the further kind is superimposed on at least 50 %, more preferably at least 75 %, and further preferably at least 95 % of a surface area of the first surface of the layer of the second kind,
   (b) the further section of the first layer of the further kind is arranged at the first distance *l*₃ from the element of the first kind.

This preferred embodiment is an 11^{th} embodiment of the invention, that preferably depends on any of the 1^{st} to 10^{th} embodiments of the invention.

In an aspect of the 11^{th} embodiment, it is preferred that the intermediate layered structure is obtained following the completion of the steps of the embodiment.

In a preferred embodiment of the first method for producing a layered structure, prior to the method steps of providing the intermediate layered structure, the method further comprises the steps of:
I.) providing a layer of the first kind;
II.) depositing the layer of the second kind such that the layer of the second kind is superimposed on at least the first surface of the layer of the first kind, preferably on at least 50 %, more preferably on at least 75 %, and further preferably on at least 95 % of a surface area of the first surface of the layer of the first kind;
III.) optionally
   (a) depositing a masking layer on the layer of the second kind, and
   (b) removing at least one section of the masking layer to at least partially expose the layer of the second kind;
IV.) reducing a thickness of
   (a) at least one section of the layer of the first kind to obtain the element of the first kind, and
   (b) preferably reducing a thickness of at least one section of the layer of the second kind;
V.) optionally, at least partially removing the masking layer;
VI.) depositing the first layer of the further kind such that the first layer of the further kind at least partially surrounds the element of the first kind and preferably the layer of the second kind, and wherein the first layer of the further kind is deposited such that
   (a) the first section of the first layer of the further kind is superimposed on at least 50 %, more preferably at least 75 %, and further preferably at least 95 % of a surface area of the first surface of the layer of the second kind,
   (b) the further section of the first layer of the further kind is arranged at the first distance *l*₃ from the element of the first kind.

This preferred embodiment is a 12^{th} embodiment of the invention, that preferably depends on any of the 1^{st} to 10^{th} embodiments of the invention.

In an aspect of the 12^{th} embodiment, it is preferred that the intermediate layered structure is obtained following the completion of the steps of the embodiment.

In a preferred embodiment of the first method for producing a layered structure, the thickness of at least one section of the layer of the first kind, the thickness of at least one section of the layer of the second kind, or both, are reduced using at least one or all of the following:
a. wet etching;
b. dry etching;
c. laser ablation.

This preferred embodiment is a 13^{th} embodiment of the invention, that preferably depends on any of the 11^{th} to 12^{th} embodiments of the invention.

In an aspect of the 13^{th} embodiment, all possible combination of the features a. to c. are preferred aspects of the embodiment. These combinations are *e.g.,* a; b; c; a+b; a+c; b+c; a+b+c.

In a preferred embodiment of the first method for producing a layered structure, the method further comprises the following steps, performed after the step of reducing the first thickness *d_{3A}* and preferably the further thickness *d_{3B}* of the first layer of the further kind (step b. in the 1^{st} embodiment):
A.] reducing the thickness *d₂* of the of the layer of the second kind using a further thickness-reducing technique,
   (i) preferably such that at least one recess is formed in the first layer of the further kind, wherein the at least one recess has a depth *D_{R}*, measured along the first direction;
   (ii) preferably such that at least a part of the first surface of the element of the first kind is exposed;
B.] depositing a further layer of the further kind, such that the further layer of the further kind is superimposed on at least the first surface of the element of the first kind, preferably on at least 50 %, more preferably on at least 75 %, and further preferably on at least 95 % of the surface area of the first surface of the element of the first kind;
C.] optionally, reducing a thickness *d₄* of the further layer of the further kind.

This preferred embodiment is a 14^{th} embodiment of the invention, that preferably depends on any of the 1^{st} to 13^{th} embodiments of the invention.

In the aspect of the 14^{th} embodiment wherein at least one recess if formed in the first layer of the further kind, it is preferred that the thickness *d₄* of the further layer of the further kind, prior to being reducing in step C.], is at least 1.1 times, more preferably at least 1.5 times, even more preferably at least 2 times, and further preferably at least 4 times larger than the depth *D_{R}* of the recess.

In a preferred embodiment of the first method for producing a layered structure, the first surface of the further section of the first layer of the further kind is arranged at a height *h_{3B},* a first surface of the further layer of the further kind is arranged at a height *h₄,* and wherein
a. the heights *h_{3B}* and *h₄* are measured along the first direction,
b. |*h_{3B}* - *h₄*| ≤ 10 nm, preferably |*h_{3B}* - *h₄*| ≤ 8 nm, more preferably |*h_{3B}* - *h₄*| ≤ 6 nm, even more preferably |*h_{3B}* - *h₄*| ≤ 4 nm, further preferably |*h_{3B}* - *h₄*| ≤ 2 nm, and even further preferably |*h_{3B}* - *h₄*| ≤ 1 nm.

This preferred embodiment is a 15^{th} embodiment of the invention, that preferably depends on the 14^{th} embodiments of the invention.

In an aspect of the 15^{th} embodiment, it is preferred that the height difference given in aspect b. applies after the reduction step C.] in the 14^{th} preferred embodiment has been completed.

In a preferred embodiment of the first method for producing a layered structure, at least one or all of the following applies:
a. a further etch rate of the layer of the second kind is larger than a further etch rate of the first layer of the further kind, preferably during employment of the further thickness-reducing technique;
b. a further chemical reaction rate of the layer of the second kind is larger than a further chemical reaction rate of the first layer of the further kind, preferably during employment of the further thickness-reducing technique;
c. a further material removal rate of the layer of the second kind is larger than a further material removal rate of the first layer of the further kind, preferably during employment of the further thickness-reducing technique.

This preferred embodiment is a 16^{th} embodiment of the invention, that preferably depends on any of the 14^{th} to 15^{th} embodiments of the invention.

In an aspect of the 16^{th} embodiment, all possible combination of the features a. to c. are preferred aspects of the embodiment. These combinations are *e.g.,* a; b; c; a+b; a+c; b+c; a+b+c. In an aspect of the 16^{th} embodiment, feature a. is particularly preferred.

In a preferred embodiment of the first method for producing a layered structure, at least one or all of the following applies:
a. a further etch rate of the layer of the second kind is larger than a further etch rate of the element of the first kind, preferably during employment of the further thickness-reducing technique;
b. a further chemical reaction rate of the layer of the second kind is larger than a further chemical reaction rate of the element of the first kind, preferably during employment of the further thickness-reducing technique;
c. a further material removal rate of the layer of the second kind is larger than a further material removal rate of the element of the first kind, preferably during employment of the further thickness-reducing technique.

This preferred embodiment is a 17^{th} embodiment of the invention, that preferably depends on any of the 14^{th} to 16^{th} embodiments of the invention.

In an aspect of the 17^{th} embodiment, all possible combination of the features a. to c. are preferred aspects of the embodiment. These combinations are *e.g.,* a; b; c; a+b; a+c; b+c; a+b+c. In another aspect of the 17^{th} embodiment, feature a. is particularly preferred.

In a preferred embodiment of the first method for producing a layered structure, at least one or all of the following applies:
a. the further etch rate of the layer of the second kind is at least 1.1 times, preferably at least 1.5 times, more preferably at least 3 times, more preferably at least 5 times, more preferably at least 10 times, more preferably at least 20 times, more preferably at least 50 times, more preferably at least 100 times, further preferably at least 200 times, further preferably at least 500 times, and even further preferably at least 1000 times larger than the further etch rate of the first layer of the further kind;
b. the further material removal rate of the layer of the second kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the further material removal rate of the first layer of the further kind;
c. the further etch rate of the layer of the second kind is at least 1.1 times, preferably at least 1.5 times, more preferably at least 3 times, more preferably at least 5 times, more preferably at least 10 times, more preferably at least 20 times, more preferably at least 50 times, more preferably at least 100 times, further preferably at least 200 times, further preferably at least 500 times, and even further preferably at least 1000 times larger than the further etch rate of the element of the first kind;
d. the further material removal rate of the layer of the second kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the further material removal rate of the element of the first kind.

This preferred embodiment is an 18^{th} embodiment of the invention, that preferably depends on any of the 16^{th} to 17^{th} embodiments of the invention.

In an aspect of the 18^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In another aspect of the 18^{th} embodiment, all possible combination of the features a. and c. are more preferred aspects of the embodiment. These combinations are *e.g.,* a; c; a+c. In yet another aspect of the 18^{th} embodiment, feature a. is particularly preferred. In an aspect of the 18^{th} embodiment, aspect a., it is preferred that the further etch rate of the layer of the second kind is in the range of 4 to 200 times, more preferably in the range of 5 to 150 times, and further preferably in the range of 10 to 100 times larger than the further etch rate of the first layer of the further kind. In an aspect of the 18^{th} embodiment, aspect b., it is preferred that the further material removal rate of the layer of the second kind is in the range of 1.5 to 200 times, more preferably in the range of 5 to 150 times, and further preferably in the range of 10 to 100 times larger than the further material removal rate of the first layer of the further kind. In an aspect of the 18^{th} embodiment, aspect c., it is preferred that the further etch rate of the layer of the second kind is in the range of 4 to 200 times, more preferably in the range of 5 to 150 times, and further preferably in the range of 10 to 100 times larger than the further etch rate of the element of the first kind. In an aspect of the 18^{th} embodiment, aspect d., it is preferred that the further material removal rate of the layer of the second kind is in the range of 1.5 to 200 times, more preferably in the range of 5 to 150 times, and further preferably in the range of 10 to 100 times larger than the further material removal rate of the element of the first kind.

In a preferred embodiment of the first method for producing a layered structure, the further thickness-reducing technique is at least one or all of the following:
a. wet etching;
b. dry etching;
c. laser ablation;
d. chemical-mechanical polishing.

This preferred embodiment is a 19^{th} embodiment of the invention, that preferably depends on any of the 14^{th} to 18^{th} embodiments of the invention.

In an aspect of the 19^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 19^{th} embodiment, all possible combination of the features a. to c. are particularly preferred aspects of the embodiment. These combinations are *e.g.,* a; b; c; a+b; a+c; b+c; a+b+c. In an aspect of the 19^{th} embodiment, wet etching is particularly preferred.

In a preferred embodiment of the first method for producing a layered structure, the thickness *d₄* of the further layer of the further kind is reduced using at least one of the following:
a. chemical-mechanical polishing, wherein the chemical-mechanical polishing is preferably performed for less than 1 minute, more preferably for less than 50 seconds, and more preferably for less than 40 seconds;
b. wet etching;
c. dry etching;
d. laser ablation.

This preferred embodiment is a 20^{th} embodiment of the invention, that preferably depends on any of the 14^{th} to 19^{th} embodiments of the invention.

In an aspect of the 20^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 20^{th} embodiment, if the thickness *d₄* of the further layer of the further kind is reduced used chemical-mechanical polishing, and the first thickness-reducing technique of the 10^{th} embodiment is also chemical-mechanical polishing, then it is preferred that the duration of the chemical-mechanical polishing of the first thickness-reducing technique is longer than the duration of the chemical-mechanical polishing of the 20^{th} embodiment. In another aspect of the 20^{th} embodiment, chemical-mechanical polishing is particularly preferred.

In a preferred embodiment of the first method for producing a layered structure, at least one or all of the following applies to the intermediate layered structure that is provided:
a. the layer of the second kind touches the element of the first kind;
b. the layer of the second kind at least partially surrounds the element of the first kind, more preferably partially surrounds the element of the first kind;
c. at least the first section of the first layer of the further kind touches the layer of the second kind.

This preferred embodiment is a 21^{st} embodiment of the invention, that preferably depends on any of the 1^{st} to 20^{th} embodiments of the invention.

In an aspect of the 21^{st} embodiment, all possible combination of the features a. to c. are preferred aspects of the embodiment. These combinations are *e.g.,* a; b; c; a+b; a+c; b+c; a+b+c. In an aspect of the 21^{st} embodiment, feature a. is particularly preferred.

In a preferred embodiment of the first method for producing a layered structure, at least one layer is deposited using at least one or all of the following:
a. chemical vapour deposition;
b. physical vapour deposition;
c. atomic layer deposition;
d. spin coating;
e. molecular epitaxy.

This preferred embodiment is a 22^{nd} embodiment of the invention, that preferably depends on any of the 1^{st} to 21^{st} embodiments of the invention.

In an aspect of the 22^{nd} embodiment, all possible combination of the features a. to e. are preferred aspects of the embodiment. These combinations are *e.g.,* a; b; c; d; e; a+b; a+c; a+d; a+e; b+c; b+d; b+e; c+d; c+e; d+e; a+b+c; a+b+d; a+b+e; a+c+d; a+c+e; a+d+e; b+c+d; b+c+e; b+d+e; c+d+e; a+b+c+d; a+b+c+e; a+b+d+e; a+c+d+e; b+c+d+e; a+b+c+d+e. In the 22^{nd} embodiment, "the at least one layer" should preferably be understood to mean at least one or all of the following: the layer of the first kind, the layer of the second kind, the first layer of the further kind, and the further layer of the further kind.

In a preferred embodiment of the first method for producing a layered structure, at least one or all of the following applies:
a. the element of the first kind comprises at least one or all of the following: silicon, oxygen, aluminium, iridium, tantalum, titanium, nitrogen, lithium, niobium, indium, phosphorus, gallium, arsenic, barium, at least one lanthanide (preferably lanthanum), a chalcogenide, at least one polymer, a resin, a combination of at least two thereof;
b. the element of the first kind is an optical element, preferably a waveguide adapted and arranged for the propagation of electromagnetic waves;
c. the element of the first kind is adapted and arranged for the propagation of electromagnetic waves that have wavelengths in the range from 300 nm to 3000 nm, preferably in the range of 800 nm to 2100 nm, and more preferably in the range of 1250 nm to 1650 nm.

This preferred embodiment is a 23^{rd} embodiment of the invention, that preferably depends on any of the 1^{st} to 22^{nd} embodiments of the invention.

In an aspect of the 23^{rd} embodiment, all possible combination of the features a. to c. are preferred aspects of the embodiment. These combinations are *e.g.,* a; b; c; a+b; a+c; b+c; a+b+c. In an aspect of the 23^{rd} embodiment, the combination of the features b. and c. are particularly preferred. In an aspect of the 23^{rd} embodiment, feature a., it is particularly preferred that the element of the first kind comprises at least 50 wt-%, more preferably at least 65 wt-%, even more preferably at least 75 wt-%, further preferably at least 85 wt-%, and even further preferably at least 95 wt-%, based on a total weight of the element of the first kind, of a nitride, more preferably silicon nitride.

In a preferred embodiment of the first method for producing a layered structure, at least one or all of the following applies:
a. the layer of the second kind comprises at least one or all of the following: at least one metal, at least one metal alloy, at least one oxide, at least one nitride, at least one carbide, a combination of at least two thereof. An example of a preferred carbide is silicon carbide. Examples of nitrides include titanium nitride and silicon oxynitride.
b. the layer of the second kind comprises at least one or all of the following: titanium, tungsten, aluminium, molybdenum, carbon, nitrogen, oxygen, silicon, germanium, a combination of at least two thereof. Examples of a combination of at least two thereof include silicon germanium and silicon carbon oxynitride. An example of silicon is amorphous silicon.
c. a refractive index of the layer of the second kind is larger than a refractive index of the element of the first kind. In this aspect it is preferred that the refractive index of the layer of the second kind is at least 1.05 times larger, more preferably at least 1.3 times larger, and further preferably at least 1.6 times larger than the refractive index of the element of the first kind.
d. the layer of the second kind has a refractive index that is in the range of 1.5 to 6, preferably in the range of 2 to 5, and further preferably in the range of 2.5 to 4.

This preferred embodiment is a 24^{th} embodiment of the invention, that preferably depends on any of the 1^{st} to 23^{rd} embodiments of the invention.

In an aspect of the 24^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 24^{th} embodiment, all possible combination of the features a. and b. are particularly preferred aspects of the embodiment. These combinations are *e.g.,* a; b; a+b. In another aspect of the 24^{th} embodiment, feature c., it is preferred that the refractive index of the layer of the second kind is in the range of 1.05 to 4 times larger, more preferably in the range of 1.3 to 3.7 times larger, and further preferably in the range of 1.6 to 2.7 times larger than the refractive index of the element of the first kind. In an aspect of the 24^{th} embodiment, features a. and/or b., it is particularly preferred that the layer of the second kind comprises less than 20 wt-%, more preferably less than 15 wt-%, even more preferably less than 10 wt-%, further preferably less than 5 wt-%, and even further preferably less than 1.5 wt-%, based on a total weight of the layer of the second kind, of a nitride, more preferably silicon nitride.

In a preferred embodiment of the first method for producing a layered structure, at least one or all of the following applies to the first layer of the further kind, the further layer of the further kind, or both:
a. comprises at least one or all of the following: at least one oxide, at least one nitride, at least one lanthanide (preferably lanthanum), a combination of at least two thereof. Examples of an oxide include silicon dioxide, aluminium oxide, zirconium dioxide, hafnium oxide, titanium dioxide, niobium pentoxide, tantalum pentoxide, lanthanum oxide. An example of a nitride is silicon nitride, aluminium nitride, and silicon oxynitride. Silicon dioxide is particularly preferred;
b. has an electrical conductivity that is less than 10⁻⁵ S/m, preferably less than 10⁻⁶ S/m, more preferably less than 10⁻⁷ S/m, further preferably less than 10⁻⁹ S/m, and even further preferably less than 10⁻¹¹ S/m;
c. has a dielectric constant of at least 3, more preferably at least 5, and further preferably at least 7.

This preferred embodiment is a 25^{th} embodiment of the invention, that preferably depends on any of the 1^{st} to 24^{th} embodiments of the invention.

In an aspect of the 25^{th} embodiment, all possible combination of the features a. to c. are preferred aspects of the embodiment. These combinations are *e.g.,* a; b; c; a+b; a+c; b+c; a+b+c.

In a preferred embodiment of the first method for producing a layered structure, the intermediate layered structure is superimposed on a wafer layer. This preferred embodiment is a 26^{th} embodiment of the invention, that preferably depends on any of the 1^{st} to 25^{th} embodiments of the invention.

A 27^{th} embodiment of the invention is a second method for producing a layered structure, comprising the steps of
a. providing an intermediate layered structure that comprises
   i. an element of a first kind, wherein the element of the first kind
      A. has a first surface that is arranged at height *h_{1X},* wherein *h_{1X}* is measured along a first direction,
      B. has a thickness *d₁,* measured along the first direction, wherein *d₁* ≤ 1.5 µm;
   ii. a first layer of a further kind, wherein
      A. a further section of the first layer of the further kind is arranged at a first distance *l*₃ from the element of the first kind, wherein
         I./ the first distance *l*₃ is measured along a further direction, wherein the further direction is perpendicular to the first direction, and
         II./ *l*₃ ≤ 100 nm,
      B. the further section has a first surface that is arranged at a height *h_{3B},* wherein *h_{3B}* is measured along the first direction,
      C. |*h_{3B}* - *h_{1X}*| > 0 nm;
b. oxidising at least a part of the element of the first kind to form a layer of an even-further kind on the first surface of the element of the first kind, wherein
   I. the layer of the even-further kind has a first surface that is arranged at a height *h₅,* wherein the height *h₅* is measured along the first direction, and
   II. |*h_{3B}* - *h₅*| ≤ |*h_{3B}* - *h_{1X}*|, with *h_{1X}* being the height of the first surface of the element of the first kind prior to the oxidation step.

In an aspect of the 27^{th} embodiment, it is preferred that the layered structure is obtained after the oxidising step has been completed. In another aspect of the 27^{th} embodiment, it is preferred that the layered structure is obtained following the completion of the oxidising step and at least one further method step. In an aspect of the 27^{th} embodiment, it is preferred that the oxidising step b. is performed in an environment that has at a pressure of at least 1 atmosphere, more preferably at least 2 atmospheres, and further preferably at least 3 atmospheres. In an aspect of the 27^{th} embodiment, it is preferred that the oxidising step b. is performed in an environment that has a temperature in the range of 200 °C to 1000 °C, more preferably in the range of 300 °C to 900 °C, and further preferably in the range of 350 °C to 850 °C. In this aspect, if the oxidising step b. is performed in an environment that comprises at least 50 wt-% of at least one oxygen radical, it is preferred that the temperature of the environment is 500 °C or less, more preferably 450 °C or less, and further preferably 400 °C or less. In an aspect of the 27^{th} embodiment, it is particularly preferred that the element of the first kind is a waveguide that is adapted and arranged for the propagation of electromagnetic waves. In an aspect of the 27^{th} embodiment, it is particularly preferred that the layered structure that is obtainable from the 27^{th} embodiment is suitable to be used for the production of an opto-electronic device, more preferably an opto-electronic device comprising graphene.

In a preferred embodiment of the second method for producing a layered structure, the oxidising step is performed using at least one or all of the following:
a. exposing the intermediate layered structure to oxygen, preferably in an environment that comprises at least 85 wt-%, more preferably at least 90 wt-%, even more preferably at least 95 wt-%, and further preferably at least 98 wt-% oxygen; the wt-% is based on the weight of the environment;
b. exposing the intermediate layered structure to water, preferably in an environment that comprises at least 85 %, more preferably at least 90 %, even more preferably at least 95 %, and further preferably at least 98 % water saturation;
c. oxygen plasma, preferably oxygen plasma bombardment.

This preferred embodiment is a 28^{th} embodiment of the invention, that preferably depends on the 27^{th} embodiment of the invention.

In an aspect of the 28^{th} embodiment, all possible combination of the features a. to c. are preferred aspects of the embodiment. These combinations are *e.g.,* a; b; c; a+b; a+c; b+c; a+b+c. In an aspect of the 28^{th} embodiment, feature a., it is preferred that the oxygen is in the form of at least one oxygen radical. Examples of an oxygen radical include a peroxide, a superoxide, a hydroxyl radical, singlet oxygen, and alpha-oxygen. In an aspect of the 28^{th} embodiment, feature b., it is preferred that the water is in the form of a gas, *e.g.,* water vapour.

In a preferred embodiment of the second method for producing a layered structure, an oxidation rate of the element of the first kind is larger than an oxidation rate of the further section of the first layer of the further kind. This preferred embodiment is a 29^{th} embodiment of the invention, that preferably depends on any of the 27^{th} to 28^{th} embodiments of the invention.

In an aspect of the 29^{th} embodiment, it is preferred that the oxidation rate of the element of the first kind is at least 1.1 times, preferably at least 5 times, more preferably at least 10 times, more preferably at least 20 times, more preferably at least 50 times, more preferably at least 100 times, more preferably at least 200 times, more preferably at least 500 times, further preferably at least 1000 times, further preferably at least 2000 times, and even further preferably at least 5000 times larger than the oxidation rate of the further section of the first layer of the further kind.

In a preferred embodiment of the second method for producing a layered structure, at least one or all of the following applies:
a. |*h_{3B}* - *h_{1X}*| ≤ 10 nm, preferably |*h_{3B}* - *h_{1X}*| ≤ 8 nm, more preferably |*h_{3B}* - *h_{1X}*| ≤ 6 nm, even more preferably |*h_{3B}* - *h_{1X}*| ≤ 4 nm, and further preferably |*h_{3B}* - *h_{1X}*| ≤ 2 nm;
b. |*h_{3B}* - *h₅*| ≤ 8 nm, preferably |*h_{3B}* - *h₅*| ≤ 6 nm, more preferably |*h_{3B}* - *h₅*| ≤ 4 nm, even more preferably |*h_{3B}* - *h₅*| ≤ 2 nm, and further preferably |*h_{3B}* - *h₅*| ≤ 1 nm.

This preferred embodiment is a 30^{th} embodiment of the invention, that preferably depends on any of the 27^{th} to 29^{th} embodiments of the invention.

In an aspect of the 30^{th} embodiment, all possible combination of the features a. and b. are preferred aspects of the embodiment. These combinations are *e.g.,* a; b; a+b. In an aspect of the 30^{th} embodiment, it is preferred that |*h_{3B}*-*h_{1X}*| ≥ 4 nm, more preferably |*h_{3B}* - *h_{1X}*| ≥ 3 nm, even more preferably |*h_{3B}* - *h_{1X}*| ≥ 2 nm, and further preferably |*h_{3B} - h_{1X}*| ≥ 1 nm.

In a preferred embodiment of the second method for producing a layered structure, at least one or all of the following applies:
a. the layer of the even-further kind comprises an oxide;
b. the further section of the first layer of the further kind comprises an oxide;
c. the element of the first kind comprises less than 10 wt-%, preferably less than 5 wt-%, and more preferably less than 2 wt-% of an oxide, where the wt-% are based on a weight of element of the first kind.

This preferred embodiment is a 31^{st} embodiment of the invention, that preferably depends on any of the 27^{th} to 30^{th} embodiments of the invention.

In an aspect of the 3 1^{st} embodiment, all possible combination of the features a. to c. are preferred aspects of the embodiment. These combinations are *e.g.,* a; b; c; a+b; a+c; b+c; a+b+c. Examples of an oxide in the 3 1^{st} embodiment include silicon dioxide, aluminium oxide, zirconium dioxide, hafnium oxide, titanium dioxide, niobium pentoxide, tantalum pentoxide, lanthanum oxide.

In a preferred embodiment of the second method for producing a layered structure, at least 80 wt-%, preferably at least 90 wt-%, and further preferably at least 99 wt-% of the further section of the first layer of the further kind has the same chemical composition as the layer of the even-further kind. This preferred embodiment is a 32^{nd} embodiment of the invention, that preferably depends on any of the 27^{th} to 3 1^{st} embodiments of the invention.

In a preferred embodiment of the second method for producing a layered structure, at least one or all of the following applies:
a. an etch rate of the layer of the even-further kind is larger than an etch rate of the first layer of the further kind. In this aspect it is preferred that the etch rate of the layer of the even-further kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the etch rate of the first layer of the further kind;
b. a material removal rate of the layer of the even-further kind is larger than a material removal rate of the first layer of the further kind. In this aspect it is preferred that the material removal rate of the layer of the even-further kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the material removal rate of the first layer of the further kind;
c. a chemical reaction rate of the layer of the even-further kind is larger than a chemical reaction rate of the first layer of the further kind;
d. a hardness of the layer of the even-further kind is larger than a hardness of the first layer of the further kind.

This preferred embodiment is a 33^{rd} embodiment of the invention, that preferably depends on any of the 27^{th} to 32^{nd} embodiments of the invention.

In an aspect of the 33^{rd} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 33^{rd} embodiment, it is preferred that the etch rate is either a first etch rate or a further etch rate. In an aspect of the 33^{rd} embodiment, it is preferred that the material removal rate is either a first material removal rate or a further material removal rate. In an aspect of the 33^{rd} embodiment, it is preferred that the chemical reaction rate is either a first chemical reaction rate or a further chemical reaction rate.

In a preferred embodiment of the second method for producing a layered structure, at least one or all of the following applies:
a. an etch rate of the layer of the even-further kind is less than an etch rate of the first layer of the further kind. In this aspect it is preferred that the etch rate of the first layer of the further kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the etch rate of the layer of the even-further kind;
b. a material removal rate of the layer of the even-further kind is less than a material removal rate of the first layer of the further kind. In this aspect it is preferred that the material removal rate of the first layer of the further kind is at least 1.1 times larger, more preferably at least 1.5 times larger, even more preferably at least 3 times larger, further preferably at least 5 times larger, further preferably at least 10 times larger, further preferably at least 20 times larger, and even further preferably at least 50 times larger than the material removal rate of the layer of the even-further kind;
c. a chemical reaction rate of the layer of the even-further kind is less than a chemical reaction rate of the first layer of the further kind;
d. a hardness of the layer of the even-further kind is less than a hardness of the first layer of the further kind.

This preferred embodiment is a 34^{th} embodiment of the invention, that preferably depends on any of the 27^{th} to 32^{nd} embodiments of the invention.

In an aspect of the 34^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 34^{th} embodiment, it is preferred that the etch rate is either a first etch rate or a further etch rate. In an aspect of the 34^{th} embodiment, it is preferred that the material removal rate is either a first material removal rate or a further material removal rate. In an aspect of the 34^{th} embodiment, it is preferred that the chemical reaction rate is either a first chemical reaction rate or a further chemical reaction rate.

In a preferred embodiment of the second method for producing a layered structure, the etch rates of the layer of the even-further kind and the layer of the further kind differ by at least 2 times, preferably at least 3 times, more preferably at least 4 times, more preferably at least 5 times, more preferably at least 10 times, more preferably at least 20 times, more preferably at least 50 times, more preferably at least 100 times, further preferably at least 200 times, further preferably at least 500 times, and even further preferably at least 1000 times. This preferred embodiment is a 35^{th} embodiment of the invention, that preferably depends on any of the 33^{rd} to 34^{th} embodiments of the invention.

In an aspect of the 35^{th} embodiment, it is preferred that the etch rates differ by 4 to 200 times, more preferably by 5 to 150 times, and further preferably by 10 to 100 times.

In a preferred embodiment of the second method for producing a layered structure, the first distance *l*₃ is *l*₃ ≤ 80 nm, preferably *l*₃ ≤ 60 nm, more preferably *l*₃ ≤ 40 nm, even more preferably *l*₃ ≤ 20 nm, further preferably *l*₃ ≤ 10 nm, further preferably *l*₃ ≤ 5 nm, further preferably *l*₃ ≤ 2 nm, and even further preferably *l*₃ ≤ 1 nm. This preferred embodiment is a 36^{th} embodiment of the invention, that preferably depends on any of the 27^{th} to 35^{th} embodiments of the invention.

In an aspect of the 36^{th} embodiment, it is preferred that the first distance *l*₃ is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm. In another aspect of the 36^{th} embodiment, it is preferred that the element of the first kind touches the further section of the first layer of the further kind (*l*₃ = 0 nm).

In a preferred embodiment of the second method for producing a layered structure, at least one or all of the following applies:
a. the thickness *d₁* of the element of the first kind is in the range of 1 nm to 1500 nm, preferably in the range of 1 nm to 1250 nm, preferably in the range of 1 nm to 1100 nm, preferably in the range of 1 nm to 900 nm, preferably in the range of 10 nm to 700 nm, more preferably in the range of 20 nm to 600 nm, even more preferably in the range of 40 nm to 500 nm, and further preferably in the range of 50 nm to 400 nm;
b. the further thickness *d_{3B}* of the further section of the first layer of the further kind is in the range of 0.5 to 5 times, preferably in the range of 1 to 4 times, and more preferably in the range of 2 to 3 times larger than the thickness *d₁* of the element of the first kind.

This preferred embodiment is a 37^{th} embodiment of the invention, that preferably depends on any of the 27^{th} to 36^{th} embodiments of the invention.

In an aspect of the 37^{th} embodiment, all possible combination of the features a. and b. are preferred aspects of the embodiment. These combinations are *e.g.,* a; b; a+b. In an aspect of the 37^{th} embodiment, it is preferred that at least one, preferably all thickness are measured prior to the start of the oxidising step in the 27^{th} embodiment (step b.). These thicknesses include *d₁,* and *d_{3B}.*

In a preferred embodiment of the second method for producing a layered structure, the method further comprises the step of reducing a thickness *d₅* of the layer of the even-further kind. This preferred embodiment is a 38^{th} embodiment of the invention, that preferably depends on any of the 27^{th} to 37^{th} embodiments of the invention.

In an aspect of the 38^{th}embodiment, it is preferred that the thickness *d₅* is reduced after the oxidising step in the 27^{th} embodiment (step b.).

In a preferred embodiment of the second method for producing a layered structure, the thickness *d₅* is reduced using least one of the following:
a. chemical-mechanical polishing;
b. wet etching;
c. dry etching;
d. laser ablation.

This preferred embodiment is a 39^{th} embodiment of the invention, that preferably depends on the 38^{th} embodiment of the invention.

In an aspect of the 39^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d.

In a preferred embodiment of the second method for producing a layered structure, prior to the method steps of providing the intermediate layered structure, the method further comprises the steps of:
I.) providing the element of the first kind, wherein the element of the first kind is preferably provided by the following sub-steps:
   A1. providing a layer of the first kind;
   A2. optionally,
      i. depositing a masking layer on the layer of the first kind, and
      ii. removing at least one section of the masking layer to at least partially expose the layer of the first kind;
   A3. reducing a thickness of at least one section of the layer of the first kind to obtain the element of the first kind;
   A4. optionally, at least partially removing the masking layer;
II.) depositing the first layer of the further kind such that the first layer of the further kind at least partially surrounds the element of the first kind, and such that
   (a) a first section of the first layer of the further kind is superimposed on at least 50 %, more preferably at least 75 %, and further preferably at least 95 % of a surface area of the first surface of the element of the first kind,
   (b) the further section of the first layer of the further kind is arranged at the first distance *l*₃ from the element of the first kind;
III.) reducing a thickness of the first section of the first layer of the further kind,
   (a) preferably such that at least one recess is formed in the first layer of the further kind, wherein the at least one recess has a depth *D_{R}*, measured along the first direction;
   (b) preferably such that at least a part of the first surface of the element of the first kind is exposed.

This preferred embodiment is a 40^{th} embodiment of the invention, that preferably depends on any of the 27^{th} to 39^{th} embodiments of the invention.

In an aspect of the 40^{th} embodiment, it is preferred that the intermediate layered structure is obtained following the completion of the steps of the embodiment.

In a preferred embodiment of the second method for producing a layered structure, at least one layer is deposited using at least one or all of the following:
a. chemical vapour deposition;
b. physical vapour deposition;
c. atomic layer deposition;
d. spin coating;
e. molecular epitaxy.

This preferred embodiment is a 41^{st} embodiment of the invention, that preferably depends on the 40^{th} embodiment of the invention.

In an aspect of the 41^{st} embodiment, all possible combination of the features a. to e. are preferred aspects of the embodiment. These combinations are *e.g.,* a; b; c; d; e; a+b; a+c; a+d; a+e; b+c; b+d; b+e; c+d; c+e; d+e; a+b+c; a+b+d; a+b+e; a+c+d; a+c+e; a+d+e; b+c+d; b+c+e; b+d+e; c+d+e; a+b+c+d; a+b+c+e; a+b+d+e; a+c+d+e; b+c+d+e; a+b+c+d+e. In the 41^{st} embodiment, "the at least one layer" should preferably be understood to mean at least one or all of the following: the layer of the first kind and the first layer of the further kind.

In a preferred embodiment of the second method for producing a layered structure, at least one or all of the following applies:
a. the element of the first kind comprises at least one or all of the following: silicon, oxygen, aluminium, iridium, tantalum, titanium, nitrogen, lithium, niobium, indium, phosphorus, gallium, arsenic, barium, at least one lanthanide (preferably lanthanum), a chalcogenide, at least one polymer, a resin, a combination of at least two thereof;
b. the element of the first kind is an optical element, preferably a waveguide adapted and arranged for the propagation of electromagnetic waves;
c. the element of the first kind is adapted and arranged for the propagation of electromagnetic waves that have wavelengths in the range from 300 nm to 3000 nm, preferably in the range of 800 nm to 2100 nm, and more preferably in the range of 1250 nm to 1650 nm.

This preferred embodiment is a 42^{nd} embodiment of the invention, that preferably depends on any of the 27^{th} to 41^{st} embodiments of the invention.

In an aspect of the 42^{nd} embodiment, all possible combination of the features a. to c. are preferred aspects of the embodiment. These combinations are *e.g.,* a; b; c; a+b; a+c; b+c; a+b+c. In an aspect of the 42^{nd} embodiment, the combination of the features b. and c are particularly preferred. In an aspect of the 42^{nd} embodiment, feature a., it is particularly preferred that the element of the first kind comprises at least 50 wt-%, more preferably at least 65 wt-%, even more preferably at least 75 wt-%, further preferably at least 85 wt-%, and even further preferably at least 95 wt-%, based on a total weight of the element of the first kind, of a nitride, more preferably silicon nitride.

In a preferred embodiment of the second method for producing a layered structure, at least one or all of the following applies to the first layer of the further kind, the layer of the even-further kind, or both:
a. comprises at least one or all of the following: at least one oxide, at least one nitride, at least one lanthanide (preferably lanthanum), a combination of at least two thereof. Examples of an oxide include silicon dioxide, aluminium oxide, zirconium dioxide, hafnium oxide, titanium dioxide, niobium pentoxide, tantalum pentoxide, lanthanum oxide. An example of a nitride is silicon nitride, aluminium nitride, and silicon oxynitride. Silicon dioxide is particularly preferred;
b. has an electrical conductivity that is less than 10⁻⁵ S/m, preferably less than 10⁻⁶ S/m, more preferably less than 10⁻⁷ S/m, further preferably less than 10⁻⁹ S/m, and even further preferably less than 10⁻¹¹ S/m;
c. has a dielectric constant of at least 3, more preferably at least 5, and further preferably at least 7.

This preferred embodiment is a 43^{rd} embodiment of the invention, that preferably depends on any of the 27^{th} to 42^{nd} embodiments of the invention.

In an aspect of the 43^{rd} embodiment, all possible combination of the features a. to c. are preferred aspects of the embodiment. These combinations are *e.g.,* a; b; c; a+b; a+c; b+c; a+b+c.

In a preferred embodiment of the second method for producing a layered structure, the intermediate layered structure is superimposed on a wafer layer. This preferred embodiment is a 44^{th} embodiment of the invention, that preferably depends on any of the 27^{th} to 43^{rd} embodiments of the invention.

A 45^{th} embodiment of the invention is a layered structure obtainable by any of the methods, according to the invention, for producing a layered structure, preferably a layered structure obtainable by any of the methods according to any of the 1^{st} to 44^{th} embodiments of the invention.

In an aspect of the 45^{th} embodiment, it is preferred that the layered structure is obtainable by the first method for producing a layered structure, more preferably the first method according to any of the 1^{st} to 26^{th} embodiments of the invention. In another aspect of the 45^{th} embodiment, it is preferred that the layered structure is obtainable by the second method for producing a layered structure, more preferably the second method according to any of the 27^{th} to 44^{th} embodiments of the invention.

A 46^{th} embodiment of the invention is a first layered structure comprising
a. an element of a first kind, wherein the element of the first kind
   i. has a first surface that is arranged at height *h₁,* wherein *h₁* is measured along a first direction,
   ii. has a thickness *d₁,* measured along the first direction, wherein *d₁* ≤ 1.5 µm;
b. a first layer of a further kind, wherein
   i. a further section of the first layer of the further kind is arranged at a first distance *l*₃ from the element of the first kind, wherein
      A. the first distance *l*₃ is measured along a further direction, wherein the further direction is perpendicular to the first direction, and
      B. *l*₃ ≤ 100 nm,
   ii. the further section of the first layer of the further kind has a first surface that is arranged at a height *h_{3B},* wherein *h_{3B}* is measured along the first direction,
   wherein at least one or all of the following applies:
   I. |*h_{3B}* - *h₁*| ≤ 15 nm, preferably |*h_{3B}* - *h₁*| ≤ 12 nm, more preferably |*h_{3B}* - *h₁*| ≤ 10 nm, even more preferably |*h_{3B}* - *h₁*| ≤ 8 nm, even more preferably |*h_{3B}* - *h₁*| ≤ 6 nm, preferably |*h_{3B} - h₁*| ≤ 4 nm, further preferably |*h_{3B}* - *h₁*| ≤ 2 nm, and even further preferably |*h_{3B}* - *h₁*| ≤ 1 nm;
   II. a gradient of the first surface of the layered structure is less than or equal to 0.1, preferably less than or equal to 0.08, more preferably less than or equal to 0.05, and further preferably less than or equal to 0.02.

In an aspect of the 46^{th} embodiment, all possible combination of the features I. and II. are preferred aspects of the embodiment. These combinations are *e.g.,* I; II; I+II. In aspect of the 46^{th} embodiment, it is particularly preferred that the element of the first kind is a waveguide adapted and arranged for the propagation of electromagnetic waves.

In a preferred embodiment of the first layered structure, at least one or all of the following applies:
a. a surface roughness *Rq* of the first surface of the element of the first kind varies by less than 15 %, more preferably by less than 10 %, even more preferably by less than 5 %, and further preferably by less than 2 % from a surface roughness *Rq* of the first surface of the further section of the first layer of the further kind;
b. the first surface of the element of the first kind has a surface roughness Rq that is less than or equal to 0.6 nm, preferably less than or equal to 0.5 nm, more preferably less than or equal to 0.4 nm, even more preferably less than or equal to 0.3 nm, further preferably less than or equal to 0.27 nm, further preferably less than or equal to 0.24 nm, further preferably less than or equal to 0.21 nm, further preferably less than or equal to 0.18 nm, and even further preferably less than or equal to 0.15 nm;
c. the first surface of the further section of the first layer of the further kind has a surface roughness *Rq* that is less than or equal to 0.6 nm, preferably less than or equal to 0.5 nm, more preferably less than or equal to 0.4 nm, even more preferably less than or equal to 0.3 nm, further preferably less than or equal to 0.27 nm, further preferably less than or equal to 0.24 nm, further preferably less than or equal to 0.21 nm, further preferably less than or equal to 0.18 nm, and even further preferably less than or equal to 0.15 nm.

This preferred embodiment is a 47^{th} embodiment of the invention, that preferably depends on the 46^{th} embodiment of the invention.

In an aspect of the 47^{th} embodiment, all possible combination of the features a. to c. are preferred aspects of the embodiment. These combinations are *e.g.,* a; b; c; a+b; a+c; b+c; a+b+c.

A 48^{th} embodiment of the invention is a second layered structure comprising
a. an element of a first kind, wherein the element of the first kind
   i. has a first surface that is arranged at height *h₁*, wherein *h₁* is measured along a first direction,
   ii. has a thickness *d₁,* measured along the first direction, wherein *d₁* ≤ 1.5 µm;
b. a levelling layer superimposed on the first surface of the element of the first kind, wherein the levelling layer
   i. has a first surface that is arranged at height *h_{L},* wherein *h_{L}* is measured along a first direction,
   ii. has a thickness *d_{L},* measured along the first direction, wherein *d_{L}* ≤ 100 nm;
c. a first layer of a further kind, wherein
   i. a further section of the first layer of the further kind is arranged at a first distance *l*₃ from the element of the first kind, wherein
      A. the first distance *l*₃ is measured along a further direction, wherein the further direction is perpendicular to the first direction, and
      B. *l*₃ ≤ 100 nm,
   ii. the further section of the first layer of the further kind has a first surface that is arranged at a height *h_{3B},* wherein *h_{3B}* is measured along the first direction,
wherein at least one or all of the following applies:
I. |*h_{3B}* - *h_{L}*| ≤ 15 nm, preferably |*h_{3B}* - *h_{L}*| ≤ 12 nm, more preferably |*h_{3B}* - *h_{L}*| ≤ 10 nm, even more preferably |*h_{3B}* - *h_{L}*| ≤ 8 nm, even more preferably |*h_{3B}* - *h_{L}*| ≤ 6 nm, preferably |*h_{3B}* - *h_{L}*| ≤ 4 nm, further preferably |*h_{3B}* - *h_{L}*| ≤ 2 nm, and even further preferably |*h_{3B}* - *h_{L}*| ≤ 1 nm;
II. a gradient of the first surface of the layered structure is less than or equal to 0.1, preferably less than or equal to 0.08, more preferably less than or equal to 0.05, and further preferably less than or equal to 0.02.

In an aspect of the 48^{th} embodiment, all possible combination of the features I. and II. are preferred aspects of the embodiment. These combinations are *e.g.,* I; II; I+II. In aspect of the 48^{th} embodiment, it is particularly preferred that the element of the first kind is a waveguide adapted and arranged for the propagation of electromagnetic waves.

In a preferred embodiment of the second layered structure, at least one or all of the following applies:
a. a surface roughness Rq of the first surface of the levelling layer varies by less than 15 %, more preferably by less than 10 %, even more preferably by less than 5 %, and further preferably by less than 2 % from a surface roughness Rq of the first surface of the further section of the first layer of the further kind;
b. the first surface of the levelling layer has a surface roughness *Rq* that is less than or equal to 0.6 nm, preferably less than or equal to 0.5 nm, more preferably less than or equal to 0.4 nm, even more preferably less than or equal to 0.3 nm, further preferably less than or equal to 0.27 nm, even further preferably less than or equal to 0.24 nm, further preferably less than or equal to 0.21 nm, further preferably less than or equal to 0.18 nm, and even further preferably less than or equal to 0.15 nm;
c. the first surface of the further section of the first layer of the further kind has a surface roughness *Rq* that is less than or equal to 0.6 nm, preferably less than or equal to 0.5 nm, more preferably less than or equal to 0.4 nm, even more preferably less than or equal to 0.3 nm, further preferably less than or equal to 0.27 nm, and even further preferably less than or equal to 0.24 nm, further preferably less than or equal to 0.21 nm, further preferably less than or equal to 0.18 nm, and even further preferably less than or equal to 0.15 nm.

This preferred embodiment is a 49^{th} embodiment of the invention, that preferably depends on the 48^{th} embodiment of the invention.

In an aspect of the 49^{th} embodiment, all possible combination of the features a. to c. are preferred aspects of the embodiment. These combinations are *e.g.,* a; b; c; a+b; a+c; b+c; a+b+c.

In a preferred embodiment of the second layered structure, at least one or all of the following differs between the levelling layer and the element of the first kind:
a. a hardness, *e.g.,* a scratch hardness, an indentation hardness, a rebound hardness, or a combination of at least two thereof;
b. a chemical reaction rate;
c. an etch rate;
d. a material removal rate;
e. a chemical composition;
f. an oxidation rate;
g. an optical attenuation coefficient;
h. a refractive index;
i. an electrical conductivity;
j. a thermal conductivity;
k. a laser ablation rate.

This preferred embodiment is a 50^{th} embodiment of the invention, that preferably depends on any of the 48^{th} to 49^{th} embodiments of the invention.

In an aspect of the 50^{th} embodiment, all combinations of the features a. to k. are preferred aspects of the embodiment. In an aspect of the 50^{th} embodiment, the combination of the features a. to f. are more preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f. In another aspect of the 50^{th} embodiment, all possible combination of the features b. to d. are particularly preferred aspects of the embodiment. These combinations are, *e.g.,* b; c; d; b+c; b+d; c+d; b+c+d.

In a preferred embodiment of the second layered structure, at least one or all of the following differs between the levelling layer and the further section of the first layer of the further kind:
a. a hardness, *e.g.,* a scratch hardness, an indentation hardness, a rebound hardness, or a combination of at least two thereof;
b. a chemical reaction rate;
c. an etch rate;
d. a material removal rate;
e. a chemical composition;
f. an oxidation rate;
g. an optical attenuation coefficient;
h. a refractive index;
i. an electrical conductivity;
j. a thermal conductivity;
k. a laser ablation rate.

This preferred embodiment is a 51^{st} embodiment of the invention, that preferably depends on any of the 48^{th} to 50^{th} embodiments of the invention.

In an aspect of the 51^{st} embodiment, all combinations of the features a. to k. are preferred aspects of the embodiment. In an aspect of the 51^{st} embodiment, the combination of the features a. to f. are more preferred aspects of the embodiment. These combinations are *e.g.,* a; b; c; d; e; f; a+b; a+c; a+d; a+e; a+f; b+c; b+d; b+e; b+f; c+d; c+e; c+f; d+e; d+f; e+f; a+b+c; a+b+d; a+b+e; a+b+f; a+c+d; a+c+e; a+c+f; a+d+e; a+d+f; a+e+f; b+c+d; b+c+e; b+c+f; b+d+e; b+d+f; b+e+f; c+d+e; c+d+f; c+e+f; d+e+f; a+b+c+d; a+b+c+e; a+b+c+f; a+b+d+e; a+b+d+f; a+b+e+f; a+c+d+e; a+c+d+f; a+c+e+f; a+d+e+f; b+c+d+e; b+c+d+f; b+c+e+f; b+d+e+f; c+d+e+f; a+b+c+d+e; a+b+c+d+f; a+b+c+e+f; a+b+d+e+f; a+c+d+e+f; b+c+d+e+f; a+b+c+d+e+f. In another aspect of the 51^{st} embodiment, all possible combination of the features b. to d. are particularly preferred aspects of the embodiment. These combinations are, *e.g.,* b; c; d; b+c; b+d; c+d; b+c+d.

In a preferred embodiment of the second layered structure, the levelling layer is one of the following:
a. a layer of a second kind;
b. a first section of the first layer of the further kind;
c. a further layer of the further kind;
d. a layer of an even-further kind.

This preferred embodiment is a 52^{nd} embodiment of the invention, that preferably depends on any of the 48^{th} to 51^{st} embodiments of the invention.

In a preferred embodiment of the second layered structure, at least one or all of the following applies:
a. the levelling layer touches the element of the first kind;
b. levelling layer at least partially surrounds the element of the first kind, more preferably partially surrounds the element of the first kind;
c. the thickness *d_{L}* of the levelling layer is *d_{L}* ≤ 80 nm, preferably *d_{L}* ≤ 60 nm, more preferably *d_{L}* ≤ 40 nm, even more preferably *d_{L}* ≤ 20 nm, further preferably *d_{L}* ≤ 10 nm, further preferably *d_{L}* ≤ 5 nm, further preferably *d_{L}* ≤ 2 nm, and even further preferably *d_{L}* ≤ 1 nm.

This preferred embodiment is a 53^{rd} embodiment of the invention, that preferably depends on any of the 48^{th} to 52^{nd} embodiments of the invention.

In an aspect of the 53^{rd} embodiment, all possible combination of the features a. to c. are preferred aspects of the embodiment. These combinations are *e.g.,* a; b; c; a+b; a+c; b+c; a+b+c. In an aspect of the 53^{rd} embodiment, feature a. is particularly preferred. In an aspect of the 53^{rd} embodiment, it is preferred that the thickness *d_{L}* of the levelling layer is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm. In an aspect of the 53^{rd} embodiment, it is preferred that the levelling layer is a layer of the second kind.

In a preferred embodiment of the second layered structure, the levelling layer is a layer of the second kind, and wherein at least one or all of the following applies:
a. the layer of the second kind comprises at least one or all of the following: at least one metal, at least one metal alloy, at least one oxide, at least one nitride, at least one carbide, a combination of at least two thereof. An example of a preferred carbide is silicon carbide. Examples of nitrides include titanium nitride and silicon oxynitride.
b. the layer of the second kind comprises at least one or all of the following: titanium, tungsten, aluminium, molybdenum, carbon, nitrogen, oxygen, and silicon, germanium, a combination of at least two thereof. Examples of a combination of at least two thereof include silicon germanium and silicon carbon oxynitride. An example of silicon is amorphous silicon.
c. a refractive index of the layer of the second kind is larger than a refractive index of the element of the first kind. In this aspect it is preferred that the refractive index of the layer of the second kind is at least 1.05 times larger, more preferably at least 1.3 times larger, and further preferably at least 1.6 times larger than the refractive index of the element of the first kind.
d. the layer of the second kind has a refractive index that is in the range of 1.5 to 6, preferably in the range of 2 to 5, and further preferably in the range of 2.5 to 4.

This preferred embodiment is a 54^{th} embodiment of the invention, that preferably depends on any of the 48^{th} to 53^{rd} embodiments of the invention.

In an aspect of the 54^{th} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In another aspect of the 54^{th} embodiment, feature c., it is preferred that the refractive index of the layer of the second kind is in the range of 1.05 to 4 times larger, more preferably in the range of 1.3 to 3.7 times larger, and further preferably in the range of 1.6 to 2.7 times larger than the refractive index of the element of the first kind. In an aspect of the 54^{th} embodiment, features a. and/or b., it is particularly preferred that the layer of the second kind comprises less than 20 wt-%, more preferably less than 15 wt-%, even more preferably less than 10 wt-%, further preferably less than 5 wt-%, and even further preferably less than 1.5 wt-%, based on a total weight of the layer of the second kind, of a nitride, more preferably silicon nitride.

In a preferred embodiment of the second layered structure, the levelling layer is a further layer of the further kind, and at least one or all of the following applies:
a. comprises at least one or all of the following: at least one oxide, at least one nitride, at least one lanthanide (preferably lanthanum), a combination of at least two thereof. Examples of an oxide include silicon dioxide, aluminium oxide, zirconium dioxide, hafnium oxide, titanium dioxide, niobium pentoxide, tantalum pentoxide, lanthanum oxide. An example of a nitride is silicon nitride, aluminium nitride, and silicon oxynitride. Silicon dioxide is particularly preferred;
b. has an electrical conductivity that is less than 10⁻⁵ S/m, preferably less than 10⁻⁶ S/m, more preferably less than 10⁻⁷ S/m, further preferably less than 10⁻⁹ S/m, and even further preferably less than 10⁻¹¹ S/m;
c. has a dielectric constant of at least 3, more preferably at least 5, and further preferably at least 7.

This preferred embodiment is a 55^{th} embodiment of the invention, that preferably depends on any of the 48^{th} to 53^{rd} embodiments of the invention.

In an aspect of the 55^{th} embodiment, all possible combination of the features a. to c. are preferred aspects of the embodiment. These combinations are *e.g.,* a; b; c; a+b; a+c; b+c; a+b+c. In an aspect of the invention, it is preferred that the 55^{th} embodiment, including all the preferred combinations of features, applies to the further section of the first layer of the further kind.

In a preferred embodiment of any of the layered structures, at least one or all of the following applies:
a. the thickness *d₁* of the element of the first kind is in the range of 1 nm to 1500 nm, preferably in the range of 1 nm to 1250 nm, preferably in the range of 1 nm to 1100 nm, preferably in the range of 1 nm to 900 nm, preferably in the range of 10 nm to 700 nm, more preferably in the range of 20 nm to 600 nm, even more preferably in the range of 40 nm to 500 nm, and further preferably in the range of 50 nm to 400 nm;
b. the first distance *l*₃ is *l*₃ ≤ 80 nm, preferably *l*₃ ≤ 60 nm, more preferably *l*₃ ≤ 40 nm, even more preferably *l*₃ ≤ 20 nm, further preferably *l*₃ ≤ 10 nm, further preferably *l*₃ ≤ 5 nm, further preferably *l*₃ ≤ 2 nm, and even further preferably *l*₃ ≤ 1 nm.

This preferred embodiment is a 56^{th} embodiment of the invention, that preferably depends on any of the 46^{th} to 55^{th} embodiments of the invention.

In an aspect of the 56^{th} embodiment, all possible combination of the features a. and b. are preferred aspects of the embodiment. These combinations are *e.g.,* a; b; a+b. In an aspect of the 56^{th} embodiment, it is preferred that the first distance *l*₃ is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm. In another aspect of the 56^{th} embodiment, it is preferred that the element of the first kind touches the further section of the first layer of the further kind (*l*₃ = 0 nm).

In a preferred embodiment of any of the layered structures, at least one or all of the following applies:
a. the element of the first kind comprises at least one or all of the following: silicon, oxygen, aluminium, iridium, tantalum, titanium, nitrogen, lithium, niobium, indium, phosphorus, gallium, arsenic, barium, at least one lanthanide (preferably lanthanum), a chalcogenide, at least one polymer, a resin, a combination of at least two thereof;
b. the element of the first kind is an optical element, preferably a waveguide adapted and arranged for the propagation of electromagnetic waves;
c. the element of the first kind is adapted and arranged for the propagation of electromagnetic waves that have wavelengths in the range from 300 nm to 3000 nm, preferably in the range of 800 nm to 2100 nm, and more preferably in the range of 1250 nm to 1650 nm.

This preferred embodiment is a 57^{th} embodiment of the invention, that preferably depends on any of the 46^{th} to 56^{th} embodiments of the invention.

In an aspect of the 57^{th} embodiment, all possible combination of the features a. to c. are preferred aspects of the embodiment. These combinations are *e.g.,* a; b; c; a+b; a+c; b+c; a+b+c. In an aspect of the 57^{th} embodiment, the combination of the features b. and c are particularly preferred. In an aspect of the 57^{th} embodiment, feature a., it is particularly preferred that the element of the first kind comprises at least 50 wt-%, more preferably at least 65 wt-%, even more preferably at least 75 wt-%, further preferably at least 85 wt-%, and even further preferably at least 95 wt-%, based on a total weight of the element of the first kind, of a nitride, more preferably silicon nitride.

In a preferred embodiment of any of the layered structures, the element of the first kind comprises less than 10 wt-%, preferably less than 5 wt-%, and more preferably less than 2 wt-% of an oxide, where the wt-% are based on a weight of element of the first kind. This preferred embodiment is a 58^{th} embodiment of the invention, that preferably depends on any of the 46^{th} to 57^{th} embodiments of the invention.

In a preferred embodiment of any of the layered structures of the 46^{th} to 58^{th} embodiments of the invention, the layered structures are obtainable by any of the methods, according to the invention, for producing a layered structure, preferably any of the methods according to any of the 1^{st} to 44^{th} embodiments of the invention.

In an aspect of the 59^{th} embodiment, it is preferred that any of the layered structures are obtainable by the first method for producing a layered structure, more preferably the first method according to any of the 1^{st} to 26^{th} embodiments of the invention. In another aspect of the 59^{th} embodiment, it is preferred that any of the layered structures are obtainable by the second method for producing a layered structure, more preferably the second method according to any of the 27^{th} to 44^{th} embodiments of the invention.

A 60^{th} embodiment of the invention is a method for producing an opto-electronic device, comprising the steps of
a. providing a layered structure according to the invention, preferably a layered structure according to any of the following:
   i. a layered structure obtained according to the first method for producing a layered structure, more preferably the first method according to any of the 1^{st} to 26^{th} embodiments of the invention;
   ii. a layered structure obtained according to the second method for producing a layered structure, more preferably the second method according to any of the 27^{th} to 44^{th} embodiments of the invention
   iii. a layered structure according to any of the 45^{th} to 59^{th} embodiments of the invention;
b. superimposing at least one electrically conducting element on the layered structure.

In an aspect of the 60^{th} embodiment, it is preferred that the step of providing the layered structure in feature a.i comprises the steps of the first method for producing a layered structure according to any of the 1^{st} to 26^{th} embodiments of the invention. For example, step a. in the 60^{th} embodiment can be replaced by the first method according to any of the 1^{st} to 26^{th} embodiments of the invention. In an aspect of the 60^{th} embodiment, it is preferred that the step of providing the layered structure in feature a.ii comprises the steps of the second method for producing a layered structure according to any of the 27^{th} to 44^{th} embodiments of the invention. For example, step a. in the 60^{th} embodiment can be replaced by the second method according to any of the 27^{th} to 44^{th} embodiments of the invention.

In a preferred embodiment of the method for producing an opto-electronic device, at least one or all of the following applies to the at least one electrically conducting element:
a. comprises at least one or all of the following: carbon, a nitride, at least one metal, at least one metal alloy, at least one conductive oxide, at least one conductive polymer, at least one chalcogen, at least one perovskite, a combination of at least two or more thereof;
b. has in the range of 1 to 10, preferably in the range of 1 to 6, and more preferably in the range of 1 to 3 atomic layers;
c. is adapted and arranged to have an optical attenuation coefficient in the range of 2 × 10⁻⁴ to 0.6 dB/µm, preferably in the range of 2 × 10⁻² to 0.40 dB/µm, and more preferably in the range of 0.15 to 0.25 dB/µm;
d. is adapted and arranged to have a variable optical attenuation coefficient;
e. has an electrical conductivity of at least 10⁴ S/m, preferably at least 10⁵ S/m, and further preferably at least 10⁶ S/m.

This preferred embodiment is a 61^{st} embodiment of the invention, that preferably depends on the 60^{th} embodiments of the invention.

In an aspect of the 61^{st} embodiment, all possible combination of the features a. to e. are preferred aspects of the embodiment. These combinations are *e.g.,* a; b; c; d; e; a+b; a+c; a+d; a+e; b+c; b+d; b+e; c+d; c+e; d+e; a+b+c; a+b+d; a+b+e; a+c+d; a+c+e; a+d+e; b+c+d; b+c+e; b+d+e; c+d+e; a+b+c+d; a+b+c+e; a+b+d+e; a+c+d+e; b+c+d+e; a+b+c+d+e. In an aspect of the 61^{st} embodiment, it is preferred that the at least one electrically conducting element is adapted and arranged to have a variable optical attenuation coefficient, wherein said optical attenuation coefficient can be varied to fall within at least one of the ranges of feature c. in the 61^{st} embodiment. In an aspect of the 61^{st} embodiment, it is preferred that the at least one electrically conducting element comprises at least one perovskite. In another aspect of the 61^{st} embodiment, it is particularly preferred that the at least one electrically conducting element comprises carbon, more preferably graphene. In an aspect of the 61^{st} embodiment, feature b., it is preferred that the at least one electrically conducting element has a single atomic layer.

In a preferred embodiment of the method for producing an opto-electronic device, a distance between the first surface of the layered structure and the at least one electrically conducting element is less than or equal to 50 nm, preferably less than or equal to 20 nm, more preferably less than or equal to 10 nm, even more preferably less than or equal to 5 nm, and further preferably less than or equal to 2 nm. This preferred embodiment is a 62^{nd} embodiment of the invention, that preferably depends on any of the 60^{th} to 61^{st} embodiments of the invention.

In a preferred embodiment of the method for producing an opto-electronic device, the opto-electronic device is adapted and arranged to modify the electric field of an electromagnetic wave. This preferred embodiment is a 63^{rd} embodiment of the invention, that preferably depends on any of the 60^{th} to 62^{nd} embodiments of the invention.

In a preferred embodiment of the method for producing an opto-electronic device, the opto-electronic device is selected from the group consisting of a modulator; a photodetector; a detector adapted and arranged for the detection of viruses, antibodies, biomarkers, biomolecules, a combination of at least two thereof; a combination of at least two thereof. This preferred embodiment is a 64^{th} embodiment of the invention, that preferably depends on any of the 60^{th} to 63^{rd} embodiments of the invention.

A 65^{th} embodiment of the invention is an opto-electronic device obtainable according to the method, according to the invention, for producing an opto-electronic device, preferably the method according to any of the 60^{th} to 64^{th} embodiments of the invention.

A 66^{th} embodiment of the invention is an electronic device comprising
a. an opto-electronic device according to the invention, preferably an opto-electronic device according to the 65^{th} embodiment;
b. at least one electronic constituent in electrical connection with the opto-electronic device. Examples of the electronic constituent include a processing unit (e.g., a central processing unit), a memory unit (*e.g.,* random access memory, static random access memory, synchronous dynamic random-access memory, a transistor, a capacitor, a semiconductor device, or a combination of at least two thereof.

Electrical connection should preferably be understood to mean that an electrical current can flow between the opto-electronic device and the at least one electronic constituent. Electrical connection should preferably be understood to mean that a maximum resistance between the opto-electronic device and the at least one electronic constituent is 100 MΩ.

A 67^{th} embodiment of the invention is a use of the layered structure according to the invention, preferably a layered structure according to any of the 45^{th} to 59^{th} embodiments of the invention, for producing an opto-electronic device. In an aspect of the 67^{th} embodiment, it is preferred that the opto-electronic device comprises at least one electrically conducting element, and more preferably that the opto-electronic device comprises at least one electrically conducting element that comprises graphene.

In a preferred embodiment of the use of the layered structure, the opto-electronic device is selected from the group consisting of a modulator; a photodetector; a detector adapted and arranged for the detection of viruses, antibodies, biomarkers, biomolecules, or a combination of at least two thereof; a combination of at least two thereof. This preferred embodiment is a 68^{th} embodiment of the invention, that preferably depends on the 67^{th} embodiments of the invention.

A 69^{th} embodiment of the invention is a device, preferably adapted and arranged for modifying at least one property of electromagnetic waves, more preferably adapted and arranged for at least partially absorbing electromagnetic waves, comprising
a. an element of a first kind, wherein the element of the first kind is a waveguide adapted and arranged for the propagation of electromagnetic waves;
b. a layer of a second kind, wherein a first section of the layer of the second kind is superimposed on at least a first surface of the waveguide,
c. a first electrically conducting element superimposed on the waveguide, wherein
   i. in a cross-sectional cut of the device, the first section of the layer of the second kind is arranged between the waveguide and the first electrically conducting element,
   ii. the first electrically conducting element is adapted and arranged to be electrically charged and discharged.

In an aspect of the 69^{th} embodiment, it is preferred that the first electrically conducting element is adapted and arranged to be electrically charged and/or discharged as a result of an electromagnetic wave propagating in the waveguide. In an aspect of the 69^{th} embodiment, the device should preferably be understood as a photodetector.

In a preferred embodiment of the device, the layer of the second kind is arranged to at least partially surround the waveguide, more preferably to surround at least 40 %, even more preferably at least 50 %, further preferably at least 60 %, and even further preferably at least 70 % of a surface of the waveguide. This preferred embodiment is a 70^{th} embodiment of the invention, that preferably depends on the 69^{th} embodiment of the invention.

In an aspect of the 70^{th}, it is preferred that the layer of the second kind is arranged to partially surround the waveguide. In this aspect, it is preferred that the layer of the second kind is arranged to surround in the range of 40 % to 95 %, more preferably in the range of 50 % to 90 %, further preferably in the range of 60 % to 85 %, and even further preferably in the range of 70 % to 80 % of the surface of the waveguide.

In a preferred embodiment of the device, at least one or all of the following applies:
a. the layer of the second kind comprises at least one or all of the following: at least one metal, at least one metal alloy, at least one oxide, at least one nitride, at least one carbide, a combination of at least two thereof. An example of a preferred carbide is silicon carbide. Examples of nitrides include titanium nitride and silicon oxynitride.
b. the layer of the second kind comprises at least one or all of the following: titanium, tungsten, aluminium, molybdenum, carbon, nitrogen, oxygen, silicon, germanium, a combination of at least two thereof. Examples of a combination of at least two thereof include silicon germanium and silicon carbon oxynitride. An example of silicon is amorphous silicon.
c. a refractive index of the layer of the second kind is larger than a refractive index of the waveguide. It is preferred that the refractive index of the layer of the second kind is at least 1.05 times larger, more preferably at least 1.3 times larger, and further preferably at least 1.6 times larger than the refractive index of the waveguide.
d. the layer of the second kind has a refractive index that is in the range of 1.5 to 6, preferably in the range of 2 to 5, and further preferably in the range of 2.5 to 4.

This preferred embodiment is a 71^{st} embodiment of the invention, that preferably depends on any of the 69^{th} to 70^{th} embodiments of the invention.

In an aspect of the 71^{st} embodiment, all possible combination of the features a. to d. are preferred aspects of the embodiment. These combinations are *e.g.,* a; b; c; d; a+b; a+c; a+d; b+c; b+d; c+d; a+b+c; a+b+d; a+c+d; b+c+d; a+b+c+d. In an aspect of the 71^{st} embodiment, all possible combination of the features a. and b. are particularly preferred aspects of the embodiment. These combinations are *e.g.,* a; b; a+b. In another aspect of the 71^{st} embodiment, feature c., it is preferred that the refractive index of the layer of the second kind is in the range of 1.05 to 4 times larger, more preferably in the range of 1.3 to 3.7 times larger, and further preferably in the range of 1.6 to 2.7 times larger than the refractive index of the waveguide. In an aspect of the 71^{st} embodiment, features a. and/or b., it is particularly preferred that the layer of the second kind comprises less than 20 wt-%, more preferably less than 15 wt-%, even more preferably less than 10 wt-%, further preferably less than 5 wt-%, and even further preferably less than 1.5 wt-%, based on a total weight of the layer of the second kind, of a nitride, more preferably silicon nitride.

In a preferred embodiment of the device, the waveguide is adapted and arranged to be in opto-electronic interaction with the first electrically conducting element. This preferred embodiment is a 72^{nd} embodiment of the invention, that preferably depends on any of the 69^{th} to 71^{st} embodiments of the invention.

In a preferred embodiment of the device, a thickness *d*_{*R*, *MAX*} of the layer of the second kind is *d_{R}*, *_{MAX}* ≤ 80 nm, preferably *d*_{*R,* MAX} ≤ 60 nm, more preferably *d_{R, MAX}* ≤ 40 nm, even more preferably *d_{R, MAX}* ≤ 20 nm, further preferably *d*_{*R*, *MAX*} ≤ 10 nm, further preferably *d_{R, MAX}* ≤ 5 nm, further preferably *d_{R, MAX}* ≤ 2 nm, and even further preferably *d*_{*R*, *MAX*} ≤ 1 nm. This preferred embodiment is a 73^{rd} embodiment of the invention, that preferably depends on any of the 69^{th} to 72^{nd} embodiments of the invention.

In an aspect of the 73^{rd} embodiment, the thickness *d_{R}* should preferably be understood as a thickness of the layer of the second kind, measured perpendicular to a surface of the waveguide. In this aspect, *d_{R, MAX}* should preferably be understood as the maximum value of *d_{R}.* In an aspect of the 73^{rd} embodiment, it is preferred that the thickness *d*_{*R*, *MAX*} of the layer of the second kind is in the range of 0.1 nm to 80 nm, more preferably in the range of 0.2 nm to 60 nm, even more preferably in the range of 0.5 nm to 40 nm, even more preferably in the range from 1 nm to 30 nm, further preferably in the range of 2 nm to 25 nm, further preferably in the range of 5 nm to 20 nm, and even further preferably in the range of 5 nm to 10 nm.

In a preferred embodiment of the device, at least one or all of the following applies to the first electrically conducting element:
a. comprises at least one or all of the following: carbon, a nitride, at least one metal, at least one metal alloy, at least one conductive oxide, at least one conductive polymer, at least one chalcogen, at least one perovskite, a combination of at least two or more thereof;
b. has in the range of 1 to 10, preferably in the range of 1 to 6, and more preferably in the range of 1 to 3 atomic layers.

This preferred embodiment is a 74^{th} embodiment of the invention, that preferably depends on any of the 69^{th} to 73^{rd} embodiments of the invention.

In an aspect of the 74^{th} embodiment, all possible combination of the features a. and b. are preferred aspects of the embodiment. These combinations are *e.g.,* a; b; a+b. In an aspect of the 74^{th} embodiment, it is preferred that the first electrically conducting element comprises at least one perovskite. In another aspect of the74^{th} embodiment, it is particularly preferred that the first electrically conducting element comprises carbon, more preferably graphene. In an aspect of the 74^{th} embodiment, feature b., it is preferred that the first electrically conducting element has a single atomic layer.

In a preferred embodiment of the device, at least one or all of the following applies to the first electrically conducting element:
a. is adapted and arranged to have an optical attenuation coefficient in the range of 2 × 10⁻⁴ to 0.6 dB/µm, preferably in the range of 2 × 10⁻² to 0.40 dB/µm, and more preferably in the range of 0.15 to 0.25 dB/µm;
b. is adapted and arranged to have a variable optical attenuation coefficient;
c. has an electrical conductivity of at least 10⁴ S/m, preferably at least 10⁵ S/m, and further preferably at least 10⁶ S/m.

This preferred embodiment is a 75^{th} embodiment of the invention, that preferably depends on any of the 69^{th} to 74^{th} embodiments of the invention.

In an aspect of the 75^{th} embodiment, all possible combination of the features a. to c. are preferred aspects of the embodiment. These combinations are *e.g.,* a; b; c; a+b; a+c; b+c; a+b+c. In an aspect of the 75^{th} embodiment, it is preferred that the first electrically conducting element is adapted and arranged to have a variable optical attenuation coefficient, wherein said optical attenuation coefficient can be varied to fall within at least one of the ranges of feature a. in the 75^{th} embodiment.

In a preferred embodiment of the device, the waveguide and the layer of the second kind match by less than 90 wt-%, more preferably by less than 80 wt-%, even more preferably less than 70 wt-%, even more preferably less than 60 wt-%, even more preferably less than 50 wt-%, and further preferably by less than 40 wt-% in their chemical composition. This preferred embodiment is a 76^{th} embodiment of the invention, that preferably depends on any of the 69^{th} to 75^{th} embodiments of the invention.

In a preferred embodiment of the device, at least one or all of the following applies:
a. the thickness *d₁* of the waveguide, measured along a first direction, is in the range of 1 nm to 1500 nm, preferably in the range of 1 nm to 1250 nm, preferably in the range of 1 nm to 1100 nm, preferably in the range of 1 nm to 900 nm, preferably in the range of 10 nm to 700 nm, more preferably in the range of 20 nm to 600 nm, even more preferably in the range of 40 nm to 500 nm, and further preferably in the range of 50 nm to 400 nm;
b. the waveguide comprises at least one or all of the following: silicon, oxygen, aluminium, iridium, tantalum, titanium, nitrogen, lithium, niobium, indium, phosphorus, gallium, arsenic, barium, at least one lanthanide (preferably lanthanum), a chalcogenide, at least one polymer, a resin, a combination of at least two thereof;
c. the waveguide is adapted and arranged for the propagation of electromagnetic waves that have wavelengths in the range from 300 nm to 3000 nm, preferably in the range of 800 nm to 2100 nm, and more preferably in the range of 1250 nm to 1650 nm.

This preferred embodiment is a 77^{th} embodiment of the invention, that preferably depends on any of the 69^{th} to 76^{th} embodiments of the invention.

In an aspect of the 77^{th} embodiment, all possible combination of the features a. to c. are preferred aspects of the embodiment. These combinations are *e.g.,* a; b; c; a+b; a+c; b+c; a+b+c. In an aspect of the 77^{th} embodiment, feature b., it is particularly preferred that the element of the first kind comprises at least 50 wt-%, more preferably at least 65 wt-%, even more preferably at least 75 wt-%, further preferably at least 85 wt-%, and even further preferably at least 95 wt-%, based on a total weight of the element of the first kind, of a nitride, more preferably silicon nitride.

In a preferred embodiment of the device, at least one or all of the following applies:
a. the layer of the second kind touches the waveguide, preferably at least the first section of the layer of the second kind touches the waveguide;
b. at first electrically conducting element touches the layer of the second kind, preferably the first section of the layer of the second kind.

This preferred embodiment is a 78^{th} embodiment of the invention, that preferably depends on any of the 69^{th} to 77^{th} embodiments of the invention.

In an aspect of the 78^{th} embodiment, all possible combination of the features a. and b. are preferred aspects of the embodiment. These combinations are *e.g.,* a; b; a+b. In an aspect of the 78^{th} embodiment, feature a. is particularly preferred.

In a preferred embodiment of the device, at least one or all of the following is at least partially surrounded by a layer of a further kind:
a. the waveguide;
b. the layer of the second kind;
c. the first electrically conducting element.

This preferred embodiment is a 79^{th} embodiment of the invention, that preferably depends on any of the 69^{th} to 78^{th} embodiments of the invention.

In an aspect of the 79^{th} embodiment, all possible combination of the features a. to c. are preferred aspects of the embodiment. These combinations are *e.g.,* a; b; c; a+b; a+c; b+c; a+b+c.

In a preferred embodiment of the device, at least one or all of the following applies to the layer of the further kind:
a. comprises at least one or all of the following: at least one oxide, at least one nitride, at least one lanthanide (preferably lanthanum), a combination of at least two thereof. Examples of an oxide include silicon dioxide, aluminium oxide, zirconium dioxide, hafnium oxide, titanium dioxide, niobium pentoxide, tantalum pentoxide, lanthanum oxide. An example of a nitride is silicon nitride, aluminium nitride, and silicon oxynitride. Silicon dioxide is particularly preferred;
b. has an electrical conductivity that is less than 10⁻⁵ S/m, preferably less than 10⁻⁶ S/m, more preferably less than 10⁻⁷ S/m, further preferably less than 10⁻⁹ S/m, and even further preferably less than 10⁻¹¹ S/m;
c. has a dielectric constant of at least 3, more preferably at least 5, and further preferably at least 7.

This preferred embodiment is an 80^{th} embodiment of the invention, that preferably depends on the 79^{th} embodiment of the invention.

In an aspect of the 80^{th} embodiment, all possible combination of the features a. to c. are preferred aspects of the embodiment. These combinations are *e.g.,* a; b; c; a+b; a+c; b+c; a+b+c. In an aspect of the 80^{th} embodiment, it is preferred that the device comprises a first section of a layer of the further kind, a further section of the layer of the further kind, or both.

In a preferred embodiment of the device, the device is superimposed on a wafer layer. This preferred embodiment is an 81^{st} embodiment of the invention, that preferably depends on any of the 69^{th} to 80^{th} embodiments of the invention.

In a preferred embodiment of the device, the device comprises a layered structure obtainable by a method, according to the invention, for producing a layered structure, preferably a layered structure obtainable by the first method for producing a layered structure, and more preferably a layered structure obtainable according to any of the 1^{st} to 11^{th}, and 13^{th} to 26^{th} embodiments of the invention. This preferred embodiment is an 82^{nd} embodiment of the invention, that preferably depends on any of the 69^{th} to 81^{st} embodiments of the invention.

In a preferred embodiment of the device, the device comprises a layered structure according to the invention, preferably the layered structure according to any of the 48^{th} to 59^{th} embodiments of the invention. This preferred embodiment is an 83^{rd} embodiment of the invention, that preferably depends on any of the 69^{th} to 82^{nd} embodiments of the invention.

In a preferred embodiment of the device, the device is obtainable by a method, according to the invention, for producing an opto-electronic device, preferably the method according to any of the 60^{th} to 64^{th} embodiments of the invention. This preferred embodiment is an 84^{th} embodiment of the invention, that preferably depends on any of the 69^{th} to 83^{rd} embodiments of the invention.

An 85^{th} embodiment of the invention is an electronic device comprising
a. a device according to the invention, preferably the device according to any of the 69^{th} to 84^{th} embodiments of the invention;
b. at least one electronic constituent in electrical connection with the opto-electronic device. Examples of the electronic constituent include a processing unit (*e.g.,* a central processing unit), a memory unit (*e.g.,* random access memory, static random access memory, synchronous dynamic random-access memory, a transistor, a capacitor, a semiconductor device, or a combination of at least two thereof.

Electrical connection should preferably be understood to mean that an electrical current can flow between the device and the at least one electronic constituent. Electrical connection should preferably be understood to mean that a maximum resistance between the opto-electronic device and the at least one electronic constituent is 100 MΩ.

### DETAILED DESCRIPTION OF THE INVENTION

Features described as preferred in one category of the invention, for example according to the first method for producing a layered structure, are analogously preferred in an embodiment of the other categories according to the invention, such as the device and the uses.

Throughout this document, disclosures of ranges should preferably be understood to include both end points of the range. Furthermore, each disclosure of a range in the document should preferably be understood as also disclosing preferred sub-ranges in which one end point is excluded or both end points are excluded. For example, a disclosure of a range from *X₁* to *X₂* is to be understood as disclosing a range that includes both of the end points *X₁* and *X₂.*

Furthermore, it is to be understood as also disclosing a range that includes the end point *X₁* but excludes the end point *X₂,* a range that excludes the end point *X₁* but includes the end point *X₂,* and a range that excludes both end points *X₁* and *X₂*.

Some preferred embodiments and preferred aspects have various combinations of features as alternatives. Where the various combinations are disclosed, these combinations are separated by a semi-colon (";"). For example, the list "a; a+b; a+c+d" should be understood to disclose a preferred embodiment that comprises the feature "a", an alternative of the preferred embodiment that comprises the features "a" and "b", and a further alternative of the preferred embodiment that comprises the features "a", "c", and "d".

### Elements, lavers, and components

Throughout this document, "a component" is used to collectively refer to "an element" and "a layer". *I.e.,* an element and a layer are examples of a component. If, for example, it is disclosed that a component has a first surface, this should preferably be understood to disclose at least one or all of the following: the component is an element that has a first surface; the component is a layer that has a first surface.

Throughout this document, where reference is made to a component without any qualification (examples of a qualification include "of the first kind", "of a second kind", "of the further kind", "of the even-further kind", "masking", "wafer", "electrically conducting"), this should preferably be understood as disclosing at least one or all of the following: a layer of the first kind, a layer of the second kind, a layer of the further kind, a layer of the even-further kind, a masking layer, a wafer layer, an element of the first kind, and an electrically conducting element. For example, if it is disclosed that a thickness of a component may be reduced using etching, this should preferably be understood as disclosing that the thickness of at least one or all the following may be reduced using etching: a layer of the first kind, a layer of the second kind, a layer of the further kind, a layer of the even-further kind, a masking layer, a wafer layer, an element of the first kind, and an electrically conducting element.

Throughout this document, "component X", "component Y", and "component Z" are used to distinguish between components of a different kind in a given context. Examples of the components X, Y, and Z include a layer of the first kind, a layer of the second kind, a layer of the further kind, a layer of the even-further kind, a masking layer, a wafer layer, an element of the first kind, and an electrically conducting element. For example, if it is disclosed that component Y is superimposed on component X, this should be understood to disclose, *inter alia,* the following: a layer of the second kind superimposed on an element of the first kind; a layer of the further kind superimposed on a layer of the second kind; a layer of the further kind superimposed on an element of the first kind. Note that, *e.g.,* a component X may represent a component of one kind in a first context, and a component of a different kind in another context.

Layers of different kinds preferably have different chemical compositions, although this is not a requirement. However, the first layer of the further kind and the further layer of the further kind preferably have the same a chemical composition. In an aspect of the invention, it is preferred that a layer of an even-further kind has the same chemical composition as a layer of the further kind.

### Layer and element of a first kind

A layer of the first kind should preferably be understood as a layer of material from which an element of the first kind can be produced and/or that can be used as an element of the first kind. It is, however, preferred that an element of the first kind is obtained by reducing a thickness of at least one section of a layer of the first kind.

A preferred layer of the first kind and/or preferred element of the first kind comprises at least one or all of the following: silicon, oxygen, aluminium, iridium, tantalum, titanium, nitrogen, lithium, niobium, indium, phosphorus, gallium, arsenic, barium, a chalcogenide, at least one lanthanide (preferably lanthanum), at least one polymer, a resin, a combination of at least two thereof. Examples of combinations of the aforementioned materials include titanium dioxide, aluminium nitride, tantalum pentoxide, lanthanum oxide, silicon nitride, aluminium oxide, silicon oxynitride, lithium niobate, silica, indium phosphide, gallium arsenide, indium gallium arsenide, barium titanate, and aluminium gallium arsenide. A preferred chalcogenide is a dichalcogenide, more preferably a transition metal dichalcogenide.

In an aspect of the invention, if an element of the first kind is at least partially surrounded by a layer of a second kind, it is preferred that at least 40 %, more preferably at least 50 %, further preferably at least 60 %, and even further preferably at least 70 % of a surface of the element of the first kind is surrounded by the layer of the second kind. In another aspect of the invention, if an element of the first kind is partially surrounded by a layer of a second kind, it is preferred that in the range of 40 % to 95 %, more preferably in the range of 50 % to 90 %, further preferably in the range of 60 % to 85 %, and even further preferably in the range of 70 % to 80 % of a surface of the element of the first kind is surrounded by the layer of the second kind.

A preferred optical element is selected from the group consisting of a transmission optic, a conversion optic, a reflection optic, a combination of at least two thereof. A transmission optic should preferably be understood as an optic that is adapted and arranged for the transmission and/or propagation of electromagnetic waves. A preferred transmission optic is selected from the group consisting of a waveguide, a lens, a transmission grating, a combination of at least two thereof. Here, a waveguide is particularly preferred. A conversion optic should preferably be understood as an optic that is adapted and arranged to modify a wavelength of an electromagnetic wave. This may, for example, serve to adjust a colour of light. A reflective optic should preferably be understood as an optic that is adapted and arranged to reflect electromagnetic waves. A preferred reflective optic is a mirror or a reflection grating.

### Layers of a second kind, a further kind and an even-further kind

In an aspect of the invention, it is preferred that a layer of the second kind comprises less than 20 wt-%, more preferably less than 15 wt-%, even more preferably less than 10 wt-%, further preferably less than 5 wt-%, and even further preferably less than 1.5 wt-%, based on a total weight of the layer of the second kind, of an oxide, more preferably silicon dioxide.

In an aspect of the invention, it is preferred that a layer of the further kind comprises less than 20 wt-%, more preferably less than 15 wt-%, even more preferably less than 10 wt-%, further preferably less than 5 wt-%, and even further preferably less than 1.5 wt-%, based on a total weight of the layer of the further kind, of a nitride, more preferably silicon nitride.

In an aspect of the invention, it is preferred that a layer of the even-further kind comprises less than 20 wt-%, more preferably less than 15 wt-%, even more preferably less than 10 wt-%, further preferably less than 5 wt-%, and even further preferably less than 1.5 wt-%, based on a total weight of the layer of the even-further kind, of a nitride, more preferably silicon nitride.

In an aspect of the invention, it is particularly preferred that a layer of the further kind comprises at least 50 wt-%, more preferably at least 65 wt-%, even more preferably at least 75 wt-%, further preferably at least 85 wt-%, and even further preferably at least 95 wt-%, based on a total weight of the layer of the further, of an oxide, more preferably silicon dioxide.

In an aspect of the invention, it is particularly preferred that a layer of the even-further kind comprises at least 50 wt-%, more preferably at least 65 wt-%, even more preferably at least 75 wt-%, further preferably at least 85 wt-%, and even further preferably at least 95 wt-%, based on a total weight of the layer of the even-further, of an oxide, more preferably silicon dioxide.

In an aspect of the invention, it is preferred that a distance *D*_{SX} between the element of the first kind and the layer of the second kind is less than 20 nm, more preferably less than 15 nm, even more preferably less than 10 nm, further preferably less than 7 nm, further preferably less than 5 nm, further preferably less than 3 nm, and even further preferably less than 1 nm. Here the distance *D*_{SX} is measured along the first direction, and is defined as the maximum distance, measured along the first direction, between the element of the first kind and the layer of the second kind. This aspect is a preferred aspect of any of the embodiments of the first method for producing a layered structure, the first layered structure, the further layered structure, the method for producing an opto-electronic device, the device, and the use of the layered structure to produce an opto-electronic device.

In an aspect of the invention, it is particularly preferred that the layer of the second kind comprises at least one carbide, at least one metal alloy, at least one oxide, a combination of at least two thereof.

### Lavered structure

In an aspect of the invention, it is preferred that the layered structure comprises a plurality of elements of the first kind. In this aspect, it is preferred that the layered structure comprises at least 2, more preferably at least 10, even more preferably at least 20, further preferably at least 100, further preferably at least 500, and even further preferably at least 1000 elements of the first kind.

In the preferred aspect of the invention wherein the layered structure comprises a plurality of elements of the first kind, it is a preferred that a layer of a second kind is superimposed on at least 50 %, more preferably on at least 75 %, and further preferably on at least 95 % of the elements of the first kind. Here each element of the first kind may have a separate layer of the second kind superimposed thereon, or two or more elements may have the same layer of the second kind superimposed thereon.

In the preferred aspect of the invention wherein the layered structure comprises a plurality of elements of the first kind, it is a preferred that a further section of a first layer of the further kind is arranged at a first distance *l*₃ from at least 50 %, more preferably at least 75 %, and further preferably at least 95 % of the elements of the first kind. Here each element of the first kind may have a separate further section of a first layer of the further kind arranged at a first distance *l*₃, or two or more elements of the first kind may share the same further section of the first layer of the further kind.

### Chemical composition of components

Examples of transitional metals are molybdenum and tungsten. A chalcogen is defined as a chemical element in Group 16 of the periodic table (e.g., S, Se, and Te). An example of a combination of at least one transitional metal and at least one chalcogen is a transition metal dichalcogenide (*e.g.,* MoS₂, WS₂, MoSe₂, WSe₂, MoTe₂).

A conductive polymer should preferably be understood as an organic polymer that is adapted and arranged to conduct electricity. A preferred conductive polymer has an electrical conductivity, at 20 °C, of at least 10⁴ S/m, more preferably of at least 10⁵ S/m, even more preferably of at least 10⁶ S/m.

A conductive oxide should preferably be understood as an oxide that is adapted and arranged to conduct electricity. A preferred conductive oxide has an electrical conductivity, at 20 °C, of at least 10⁴ S/m, more preferably of at least 10⁵ S/m, even more preferably of at least 10⁶ S/m.

In an aspect of the invention, a preferred form of carbon is graphene. In an aspect of the invention, a preferred metal is a transitional metal. In an aspect of the invention, a preferred nitride is boron nitride, more preferably hexagonal boron nitride.

A perovskite should preferably be understood as a chemical compound that has the same crystal structure as calcium titanate (CaTiO₃). An example of a perovskite is a calcium titanium oxide mineral composed of calcium titanate

A 2D material should preferably be understood as a solid, preferably a crystalline solid. In one aspect of the invention, it is preferred that a 2D material consists of a single layer of atoms. In another aspect of the invention, it is preferred that the 2D material comprises more than one layer of atoms (*e.g.,* more than one individual atomic plane), where these layers are bonded to each other by van der Waals forces.

### Waveguide

In an aspect of the invention, it is preferred that the element of the first kind is a waveguide that is adapted and arranged for the propagation of electromagnetic waves. Preferred waveguides include, but at not limited to, strip waveguides, rib waveguides, slot wave-guides, buried waveguides, and diffused waveguides.

A preferred waveguide is adapted and arranged for the propagation of electromagnetic waves that have wavelengths in at least one or all of the following ranges: 1260 nm to 1360 nm (also known as the Original Band or O-Band), 1360 nm to1460 nm (also known as the Extend Band or E-Band), 1460 nm to1530 nm (also known as the Short Band or S-Band), 1530 nm to 1565 nm (also known as the Conventional Band or C-Band), and 1565 nm to 1625 nm (also known as the Long Band or L-Band). In an aspect of the invention, it is particularly preferred that an element of the first kind is a waveguide that is adapted and arranged for the propagation of electromagnetic waves that have wavelengths in the O-band, the C-band, or both.

Where it is disclosed that the waveguide is adapted and arranged for the propagation of electromagnetic waves that have wavelengths in a given wavelength range, this should not be understood to mean that the waveguide is only adapted for the propagation of electromagnetic waves in that given wavelength range. Rather, it should preferably be understood to mean that the waveguide is at least adapted and arranged for the propagation of electromagnetic waves in the given wavelength range.

A preferred waveguide has a length in the range of 100 nm to 400 µm, preferably in the range of 500 nm to 250 µm, and more preferably in the range of 10 µm to 100 µm. A preferred waveguide has a width in the range of 100 nm to 400 µm, preferably in the range of 500 nm to 100 µm, and more preferably in the range of 1 µm to 10 µm.

### Masking layer

A preferred masking layer is adapted and arranged for at least partially protecting a first section of a component, onto which the masking layer is superimposed, during a process of reducing a thickness of a further section of the component. It is preferred that the masking layer is adapted and arranged to be used during at least one or all of the following: etching, patterning, laser ablation, chemical-mechanical polishing, or a combination of at least two thereof. A preferred masking layer is a photoresist, more preferably a positive photoresist. Photoresists are well-known to the skilled person, and are commercially available from, *e.g.,* MicroChemicals GmbH, Germany (such as AZ^{®} MIR 701).

### Wafer layer

A wafer layer should preferably be understood as a layer of material from which a wafer can be produced and/or that can be used as a wafer. A preferred wafer layer is used for the production of integrated circuits. A preferred wafer layer comprises a semiconductor substrate, more preferably a monolithic semiconductor substrate. A preferred semiconductor substrate comprises silicon, more preferably crystalline silicon. A preferred wafer layer comprises at least one integrated electronic element, preferably at least one integrated electronic element arranged on the semiconductor substrate, at least partially arranged in the semiconductor substrate, or both.

A preferred wafer layer has a thickness in the range from 200 µm to 1100 µm, more preferably in the range from 250 µm to 975 µm, and further preferably in the range from 300 µm to 900 µm.

Preferably, when a wafer layer is viewed in cross-section, the wafer layer's vertical structure can be divided into different sub-layers. The lowest sub-layer is preferably the Front-End-of-Line (FEOL). A preferred FEOL sub-layer comprises one or more integrated electronics elements. Examples of integrated electronic elements include transistors, capacitors, and resistors. Preferably, a back-end-of-line (BEOL) sub-layer is superimposed on the FEOL sub-layer. A preferred BEOL sub-layer comprises at least one or more metal layers, by means of which the integrated electronic elements of the FEOL are electrically connected.

Wafer layers suitable for the present invention are well-known to the skilled person, and are commercially available from, *e.g.,* United Microelectronics Corporation (Taiwan) and Taiwan Semiconductor Manufacturing Company Limited (Taiwan).

If the layered structure and/or the intermediate layer structure comprise a wafer layer, it is preferred, but not required, that the first direction is oriented perpendicular to the wafer layer. If the layered structure and/or the intermediate layer structure comprise a wafer layer, it is preferred, but not required, that a first surface of a component faces away from the wafer layer.

### Electrically conducting element

A preferred electrically conducting element has a width in the range of 10 nm to 40 µm, more preferably in the range of 100 nm to 20 µm, and further preferably in the range of 500 nm to 1 µm. A preferred electrically conducting element has a length in the range of 100 nm to 400 µm, more preferably in the range of 500 nm to 250 µm, and further preferably in the range of 10 µm to 100 µm. A preferred electrically conducting element has a thickness in the range of 0.1 nm to 100 nm, more preferably in the range of 0.7 nm to 50 nm, and further preferably in the range of 1.5 nm to 10 nm.

A preferred electrically conducting element has an electrical conductivity, at 20 °C, of at least 10⁴ S/m, more preferably at least 10⁵ S/m, even more preferably at least 10⁶ S/m, and further preferably at least 10⁷ S/m. The values for the electrical conductivity are preferably for an electrically conducting element that has a thickness of 0.35 nm. A preferred electrically conducting element is in the form of a layer. A preferred electrically conducting element comprises graphene, at least one perovskite, or a combination thereof. Graphene is particularly preferred.

### The at least one property

A hardness should preferably be understood as at least one or all of the following: a scratch hardness, an indentation hardness, a rebound hardness, or a combination of at least two thereof. A scratch hardness should preferably be understood as a measure of how resistant a component is to fracture and/or plastic deformation, preferably due to friction. Indention hardness should preferably be understood as a measure of how resistant a component is to deformation, preferably due to a constant compression load. Rebound hardness should preferably be understood as a measure of an elasticity of a component.

A chemical reaction rate should preferable be understood as the rate at which a chemical reaction, that involves at least one processing chemical substance and at least one component as reactants, takes place. A chemical reaction rate is preferably determined by measuring the amount of at least one product that is formed per unit time. Here the at least one product is formed as a result of the chemical reaction.

A processing chemical substance should preferably be understood as a chemical substance that is used in a thickness-reducing technique.

A first chemical reaction rate should preferably be understood as a chemical reaction rate of a chemical reaction that involves a first processing chemical substance as a reactant. A further chemical reaction rate should preferably be understood as a chemical reaction rate of a chemical reaction that involves a further processing chemical substance as a reactant.

If a first chemical reaction rate of a component of one kind is larger than a first chemical reaction rate of a component of another kind, this should preferably be understood as follows: a chemical reaction rate of a chemical reaction that involves a first processing chemical substance and the component of one kind is larger than a chemical reaction rate of a chemical reaction that involves the same, first processing chemical substance and the component of another kind. *E.g.,* a layer of the second kind and a layer of the further kind are both exposed to the same slurry, with the chemical reaction rate between the layer of the further kind and the slurry being larger than the chemical reaction rate between the layer of the second kind and the slurry.

If a further chemical reaction rate of a component of one kind is larger than a further chemical reaction rate of a component of another kind, this should preferably be understood as follows: a chemical reaction rate of a chemical reaction that involves a further processing chemical substance and the component of one kind is larger than a chemical reaction rate of a chemical reaction that involves the same, further processing chemical substance and the component of another kind. *E.g.,* a layer of the second kind and a layer of the further kind are both exposed to the same etchant, with the chemical reaction rate between the layer of the second kind and the etchant being larger than the chemical reaction rate between the layer of the further kind and the etchant.

An etch rate should preferable be understood as the rate at which a thickness of a component and/or a section of a component is reduced when the component and/or a section of a component is subjected to etching. A selectively should preferably be understood as the ratio of etch rates for two components, more preferably the ratio of etch rates for two components of different kinds. For example, when exposed to a first processing chemical substance, an element of a first kind has a first etch rate and a layer of a second kind has a second etch rate, with the ratio of the first etch rate to the second etch rate defining the selectivity.

A first etch rate should preferably be understood as the etch rate when a component and/or a section of a component is subjected to a first etching method, preferably be contacting the component and/or a section of a component with a first etchant. A further etch rate should preferably be understood as the etch rate when a component and/or a section of a component is subjected to a further etching method, preferably be contacting the component and/or a section of a component with a further etchant.

A material removal rate should preferably be understood as the rate at which a thickness of a component and/or a section of a component is reduced during employment of a method adapted and arranged to reduce the thickness of the component and/or the section of the component. An example of a material removal rate is a polishing rate in chemical-mechanical polishing.

A first material removal rate should preferably be understood as the material removal rate when a component and/or a section of a component is subjected to a first thickness-reducing technique. A further material removal rate should preferably be understood as the material removal rate when a component and/or a section of a component is subjected to a further thickness-reducing technique.

Two components should preferably be understood as having the same chemical composition when both of the two components comprise at least 95 wt-% of the same chemical substance. Two components should preferably be understood as having a different chemical composition when both of the two components comprise less than 95 wt-% of the same chemical substance.

An oxidation rate should preferably be understood as the rate at which the oxidation reaction, involving a component as a reactant, takes place.

Properties such as an optical attenuation coefficient and refractive index should preferably be understood as being wavelength dependent. In one or more preferred aspects of the invention wherein the at least one property that varies between two components includes an optical attenuation coefficient and/or a refractive index, this should preferably be understood to include one or all of the following
i. an optical attenuation coefficient measured for a first wavelength range;
ii. a refractive index measured for a further wavelength range.

In an aspect of the invention, it is preferred that the first wavelength range at least partially overlaps with the further wavelength range. In another aspect of the invention, it is preferred that the first wavelength range does not overlap with the further wavelength range.

A component according to the present invention preferably has a refractive index in the range of 0.1 to 10, more preferably in the range of 0.5 to 10, and further preferably in the range of 1 to 6.

A laser ablation rate should preferably be understood as the rate at which a thickness of a component and/or a section of a component is reduced during employment of laser ablation.

### Height of a component

The height of a component should preferably be understood as a maximum height, *i.e.,* the height is measured at a position where the component has a maximum height.

### Superimposed

A component according to the invention preferably has a first surface, and a further surface opposite the first surface. If a component Y is superimposed on a component X, this should preferably be understood to means that the component Y is superimposed on at least the first surface of the component X.

If a component Y is superimposed on a component X, this should preferably be understood to mean that the component Y at least partially covers a surface of the component X, preferably the first surface of component X. However, this should not be understood to mean that 100 % of a surface area of the component X, preferably the surface area of the first surface of component X, is necessarily covered by the component Y. *E.g.,* if component Y is superimposed on the first surface of component X, then component Y may cover 100 % of the surface area of the first surface of component X, or component Y may cover less than 100 % of the surface area of the first surface of component X.

If a component Y is superimposed on a component X, then the components Y and X may touch each other. However, if a component Y is superimposed on a component X, this should not be understood to mean that the components X and Y necessarily have to touch each other. *E.g.,* the component Y is superimposed on the component X, wherein a component Z is arranged between the components X and Y, *i.e.,* the components X and Y both touch the component Z, but the components X and Y do not touch each other. *E.g.,* the component Y is superimposed on the component X, and the components X and Y touch other.

### Thickness and reducing a thickness of a component

A component according to the invention preferably has a first surface, and a further surface opposite the first surface. The first and further surfaces preferably define a thickness of the component. A thickness should preferably be understood as a maximum thickness, *i.e.,* the thickness is measured at a position where the component has a maximum thickness. Where it is disclosed that a thickness of a component is reduced, this should preferably be understood to disclose both of the following: the thickness of the component is reduced, without complete removal of the component; the component is completely removed. Where it is disclosed that a thickness of a section of a component is reduced, this should preferably be understood to disclose both of the following: the thickness of the section of the component is reduced, without complete removal of the section of the component; the section of the component is completely removed.

### Thickness-reducing technique

A thickness-reducing technique should preferably be understood as a method that is adapted and arranged for reducing a thickness of a component and/or a section of a component. Various thickness-reducing techniques are well known in the art. Any method, which the skilled person deems suitable for the present invention, may be used. Examples of methods adapted and arranged for reducing a thickness of a component and/or a section of a component include etching, patterning, laser ablation, chemical-mechanical polishing, oxidation of the component, or a combination of at least two or more thereof.

A first thickness-reducing technique preferably uses a first processing chemical substance to reduce the thickness of a component and/or a section of a component. A preferred first thickness-reducing technique is chemical-mechanical polishing. If the first thickness-reducing technique is chemical-mechanical polishing, then the first processing chemical substance is preferably a slurry.

A further thickness-reducing technique preferably uses a further processing chemical substance to reduce the thickness of a component and/or a section of a component. A preferred further thickness-reducing technique is etching, such as wet etching, dry etching, or a combination thereof. If the further thickness-reducing technique is etching, then the further processing chemical substance is preferably an etchant. Wet etching is a particularly preferred further thickness-reducing technique.

When a layer and/or element is at least partially exposed, this should preferably be understood to mean that at least a part of a first surface of the layer and/or element is exposed.

### Etching

Various etching methods for, *e.g.,* reducing a thickness of a component and/or a section of a component, are well known in the art. Any etching method, which the skilled person deems suitable for the present invention, may be used. These etching methods include wet etching methods and dry etching methods. Examples of suitable dry etching methods include plasma etching, reactive-ion etching, ion beam etching, and vapour phase etching. A preferred etching method uses at least one masking layer to mask at least one section of the component being etched.

An etchant should preferably be understood as a processing chemical substance that is used during an etching method. A preferred etchant can be a liquid, a gas, or a combination thereof.

Preferred processing chemical substances that are suitable to be used for a wet etching method include, but are not limited to, hydrofluoric acid, buffered hydrofluoric acid, buffered oxide etch, ammonium fluoride, phosphoric acid, and combinations of at least two or more thereof. Preferred processing chemical substances that are suitable to be used for a dry etching method include, but are not limited to, boron trichloride (BCl₃), hydrofluoric acid, buffered hydrofluoric acid, buffered oxide etch, ammonium fluoride, phosphoric acid, chlorine (Cl₂), sulphur hexafluoride (SF₆), hydrobromic acid (HBr), tetrafluoromethane (CF₄), trifluoromethane (CHF₃), 1,2-difluoroethylene (C₂H₂F₂), methyl fluoride (CH₃F), and combinations of at least two or more thereof.

### Patterning

Various patterning methods for, *e.g.,* reducing a thickness of a component and/or a section of a component, are well known in the art. Any patterning method, which the skilled person deems suitable for the present invention, may be used.

A preferred patterning method uses lithography. Various lithography methods are also well known in the art. Any lithography method, which the skilled person deems suitable for the present invention, may be used. These lithography methods include, but are not limited to, photolithography (such as deep ultraviolet lithography, extreme ultraviolet lithography), electron beam lithography, nanoimprint lithography, interference lithography, magneto-lithography, scanning probe lithography, surface-charge lithography, and diffraction lithography.

A preferred patterning method comprises the steps of depositing a masking layer, such as a photoresist, on a component; removing at least one section of the making layer to expose at least one section of the component; etching the at least one exposed section of the component. After the at least one exposed section of the component has been etched, it is preferred to remove the masking layer.

### Chemical-mechanical polishing

Chemical-mechanical polishing (CMP) should preferably be understood as a method that uses a combination of chemical and mechanical forces, with CMP adapted and arranged for at least one or all of the following: to reduce a thickness of a component and/or a section of a component; to polish a surface, preferably a first surface, of a component and/or a section of a component.

A preferred CMP uses a slurry in combination with a rotating pad. A preferred pad comprises a polymer. A preferred slurry comprises at least one liquid and particles mixed with the at least one liquid. A preferred slurry is in the form of a colloid. The particles in a preferred slurry comprise at least one or all of the following: aluminium oxide, cerium oxide, zirconium oxide, titanium oxide, thorium oxide, silica, ceria, a combination of at least two thereof.

Any CMP process parameters, including the chemical composition of the slurry and the rotation rate of the rotating pad, which the skilled person deems suitable for the present invention, may be used. Suitable slurries are commercially available from, *e*.*g*., BASF SE (Germany) and Hitachi Chemical Co Ltd (Japan). Any CMP machine, which the skilled person deems suitable for the present invention, may be used. Examples of a CMP machine include the F-REX200M2 or F-REX300X, both commercially available from Ebara Engineering Singapore Pte Ltd.

### Vapour deposition

Various chemical vapour deposition (CVD) methods, *e*.*g*., for depositing a component Y onto a component X, are well known in the art. Any CVD method, which the skilled person deems suitable for the present invention, may be used. These CVD methods include, but are not limited to, atmospheric pressure CVD (APCVD), low-pressure CVD (LPCVD), ultrahigh vacuum CVD (UHCVD), plasma-enhanced CVD (PECVD), atomic-layer deposition (ALD), and metalorganic CVD (MOCVD).

Various physical vapour deposition (PVD) methods, *e*.*g*., for depositing a component Y onto a component X, are well known in the art. Any PVD method, which the skilled person deems suitable for the present invention, may be used. These PVD methods include, but are not limited to, sputtering and evaporation deposition methods. Evaporation deposition methods pertain to the evaporation and condensation of a chemical substance on a component. Suitable sputtering deposition methods include, but are not limited to, high-power impulse magnetron sputtering, high-target-utilisation sputtering, ion beam sputtering, reactive sputtering, ion-assisted deposition, and gas flow sputtering.

### Chemical substance

A chemical substance should preferably be understood as comprising at least one chemical element, at least one chemical compound, or a combination thereof. A preferred chemical substance may be a liquid, a solid, a gas, or a combination thereof. A preferred chemical substance may be in the form of a mixture, a sol, an emulsion, a colloid, or a combination of at least two thereof.

An example of a chemical substance is an etchant used for wet etching, and a slurry used for chemical-mechanical polishing.

### Modification

Modification of an electromagnetic wave should preferably be understood as the modification of one or more properties of an electromagnetic wave. Examples of the properties include amplitude, phase, frequency, and polarisation. In an aspect of the invention, it is preferred that an amplitude is modified by an opto-electronic device. Examples of modifying at least one property of an electromagnetic wave is a modulation of the electromagnetic wave, an at least partial absorption of the electromagnetic wave, or both.

In an aspect of the invention, it is preferred that the at least one property of an electromagnetic wave is modified by modulation, preferably for the transmission of information, more preferably by imposing a signal on the electromagnetic wave. In this aspect, it is preferred that an amplitude is modulated. In another aspect of the invention, it is preferred that the at least one property of an electromagnetic wave is modified by the at least partial absorption of the electromagnetic wave, preferably for the transmission of information.

### Optical attenuation coefficient

The optical attenuation coefficient should preferably be understood to be a measure that describes the extent to which a radiant flux of a beam of electromagnetic waves is reduced per unit length when it passes through a specific material.

### Variable optical attenuation coefficient

An electrically conducting element that is adapted and arranged to have a variable optical attenuation coefficient should preferably be understood to mean that an optical attenuation coefficient of the electrically conducting element can be modified, preferably when the electrically conducting element is placed in an external electrical field and/or an electric field is present between the electrically conducting element and at least one other component (e.g., another electrically conducting element). For example, the optical attenuation coefficient of an electrically conducting element can be increased or decreased when a first electrically conducting element and a second electrically conducting element are electrically charged such that an electric field is present between the first electrically conducting element and the second electrically conducting element. In an aspect of the invention, it is preferred that the optical attenuation coefficient can be reduced, preferably by at least 20 %, more preferably by at least 50 %, and further preferably by at least 85 %.

In an aspect of the invention, if an electrically conducting element is adapted and arranged to have a variable optical attenuation coefficient, it is preferred that the optical attenuation coefficient is modifiable for multiple wavelengths of electromagnetic waves, preferably for electromagnetic waves that have wavelengths in the range of 1200 nm to 1700 nm.

### Graphene

Graphene suitable for the present invention is commercially available from, *e*.*g*., Graphenea S.A. (Spain), Graphene Laboratories Inc. (USA), and Grolltex Inc (USA).

### Biomolecules and biomarkers

Example of biomolecules include DNA, amino acids, fat, constituents of animal or human cells, and proteins. A biomarker should preferably be understood as a marker for biomolecules, wherein the biomarker is adapted and arranged to attach to biomolecules, preferably to make the biomolecules detectable (e.g., by fluorescence).

### Opto-electronic interaction

A waveguide that is adapted and arranged for opto-electronic interaction with a component should preferably be understood to mean that electromagnetic waves that propagate in the waveguide can interact with the component. An example of the component includes an electrically conducting element. A preferred opto-electronic interaction modifies at least one property of the electromagnetic waves that propagate in the waveguide.

An opto-electronic device should preferably be understood as a device that controls and/or detects electromagnetic waves. An example of controlling electromagnetic waves is the modulation of electromagnetic waves. An example of detecting electromagnetic waves is the at least partial absorption of electromagnetic waves.

### Electrically charged and discharged

A component (e.g., the first electrically conducting element) that is adapted and arranged to be electrically charged should preferably be understood to mean that the component is adapted an arranged to store a net electrical charge, preferably on a surface of the component. A component that is adapted and arranged to be electrically charged can, for example, be charged by irradiating the component with photons.

A component (e.g., the first electrically conducting element) that is adapted and arranged to be electrically discharged should preferably be understood to mean that at least a fraction of any net charge stored by the component can be removed, thereby reducing the net electrical charge of the component.

### TEST METHODS

The test methods which follow were utilized within the context of the invention. Unless stated otherwise, the measurements were conducted at an ambient temperature of 23 °C, an ambient air pressure of 100 kPa (0.986 atm) and a relative air humidity of 50 %.

### Thickness and height

A thickness and a height of a component is measured using transmission electron microscopy (TEM). The TEM device used for the measurement is calibrated according to ISO 29301:2017.

### Surface roughness

The surface roughness *Rq* (also known as the root mean square average *Rms*) is measured using atomic force microscopy and according to the standard EN ISO 25178-6:2010-01.

### Material removal rate and etch rate

The material removal rate of a component is measured as follows: a component with a thickness of 500 nm is provided. The component is then subjected to a thickness-reducing technique, such as chemical-mechanical polishing. The time required to reduce the thickness of the component by 300 nm is measured (*i*.*e*., after the thickness-reducing technique has been completed, the component has a thickness of 200 nm). An intermediate material removal rate is then determined by dividing 300 nm with the measured time. The experiment is repeated 10 times to obtain 10 intermediate material removal rates. The material removal rate is then calculated by taking the average of the 10 intermediate material removal rates.

The etch rate is calculated in the same manner as described for the material removal rate, with the thickness-reducing technique being an etching method.

It will be understood that different thickness-reducing techniques, or variations of a thickness-reducing technique, may lead to different material removal rates and etch rates for the same component. Therefore, when comparing material removal rates and etch rates between two components of different kinds, *e.g.,* the etch rates of a layer of the second kind and a layer of a further kind, the material removal rates and the etch rates should be calculated using the same thickness-reducing techniques with the same process parameters.

### Oxidation rate

The oxidation rate of a component is measured as follows: a component with a thickness of 500 nm is provided. The component is then placed in an oxygen-rich environment for 10 minutes. The environment contains 98 wt-% oxygen and 100 % water saturation. The environment has a temperature of 800 °C and a pressure of 1 atmosphere. As a result of the oxidation, the thickness of the component will decrease. Following the oxidation step, the thickness of the component is measured to obtain a change in the thickness of the component (the thickness before oxidation minus the thickness after oxidation). An intermediate oxidation rate is then determined by dividing the change in thickness by 10 minutes. The experiment is repeated 10 times to obtain 10 intermediate oxidation rates. The oxidation rate is then calculated by taking the average of the 10 intermediate oxidation rates.

### Gradient of first surface of layered structure

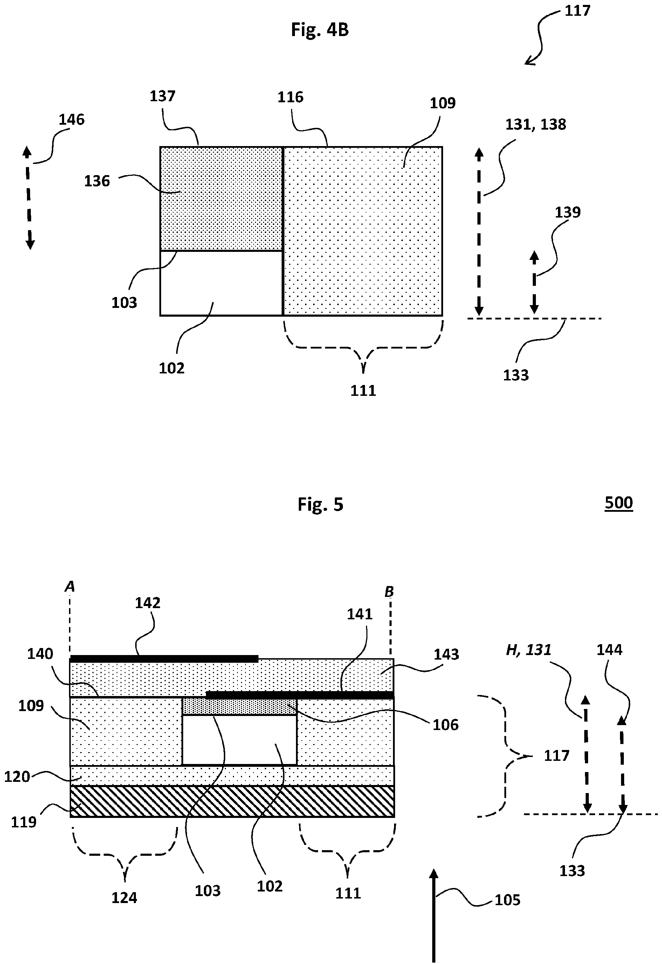

The gradient of the first surface of the layered structure is calculated as follows: a first point at an end of the layered structure is selected (see, *e.g.,* Point *A* in Fig. 5). The height *H₁* of the first surface of the layered structure is measured at the first point. The height *H₂* of the first surface is then measured at a second point. The second point is at a distance of 10 nm from the first point, with said distance measured along the further direction. The gradient for this measurement is calculated by *H₂₁* = |*H₂* - *H*₁|/10 nm. This procedure is repeated between the second point and a third point to obtain a gradient *H₃₂,* where the second point and the third point are also at a distance of 10 nm from each other. This procedure is again repeated along the length of the first surface of the layered structure. The maximum gradient calculated from the measurements is defined as the gradient of the layered structure.

### Element of the first kind (at least) partially surrounded

The % of the surface of the element of the first kind that is surrounded by the layer of the second kind is determined by making a cross-sectional cut of the layered structure, or opto-electronic device, where the layer of the second kind is superimposed on the element of the first kind. The % of the circumference of the element of the first kind, in the cross-sectional cut, that is covered by the layer of the second kind defined the % of the surface of the element of the first kind that is surrounded by the layer of the second kind

The invention is now illustrated by non-limiting examples and exemplifying embodiments.

### FIGURES

### List of figures

The figures serve to exemplify the present invention, and should not be viewed as limiting the invention. The figures are not drawn to scale.
Figs 1A to 1B: schematic illustration of a first method, according to the invention, for producing a layered structure.
Figs 2A to 2L: schematic illustration of a second method, according to the invention, for producing a layered structure.
Figs 3A to 3G: schematic illustration of a third method, according to the invention, for producing a layered structure.
Figs 4A to 4B: schematic illustration of a fourth method, according to the invention, for producing a layered structure.
Fig. 5: schematic illustration of a modulator, according to the invention, obtained using a layered structure according to the invention.
Figs 6A to 6D: examples of discontinuities in a first surface of the layered structure.
Fig. 7: flow diagram showing a fifth method, according to the invention, for producing a layered structure.
Fig. 8: flow diagram showing a sixth method, according to the invention, for producing a layered structure.
Fig. 9: schematic illustration of a photodetector, according to the invention.
Fig. 10: schematic illustration showing further details of the photodetector of Fig. 9.

### Description of figures

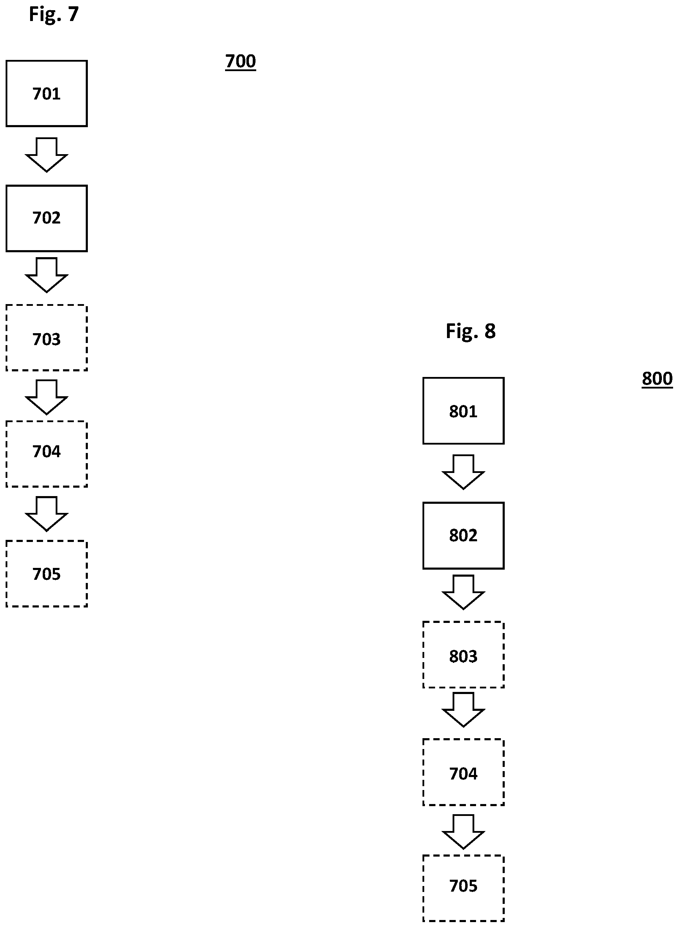

With the exception of Figs 7 and 8, the figures show cross-sectional cuts of intermediate layered structures, layered structures, modulators, and photo-detectors.

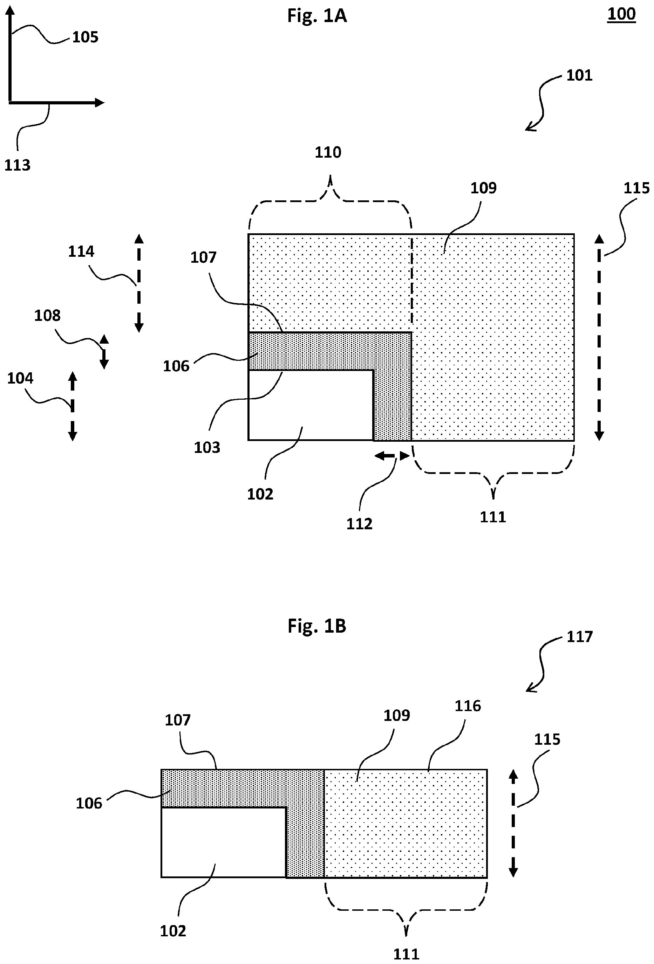

Fig. 1 shows the steps of a first method (100), according to the invention, for producing a layered structure (117). The first method comprises the steps illustrated in Figs 1A and 1B.

In Fig. 1A, an intermediate layered structure (101) is provided. The intermediate layered structure (101) comprises an element of a first kind (102) that has a first surface (103) and a thickness *d₁* (104), measured along a first direction (105). The element of the first kind (102) is preferably a waveguide. The intermediate layered structure (101) further comprises a layer of a second kind (106), superimposed on the first surface (103) of the element of the first kind (102). The layer of the second kind (106) partially surrounds the element of the first kind (102). The layer of the second kind (106) has a first surface (107) and a thickness d₂ (108), measured along the first direction (105). The intermediate layered structure (101) further comprises a first layer of a further kind (109) that partially surrounds the element of the first kind (102) and the layer of the second kind (106). The first layer of the further kind (109) has a first section (110) that is superimposed on the first surface (107) of the layer of the second kind (106), and a further section (111) that is arranged at a first distance *l₃* (112) from the element of the first kind (102). The first distance *l₃* (112) is measured along a further direction (113), which is perpendicular to the first direction (105). The first section (110) and the further section (111) of the first layer of the further kind (109) has a first thickness *d_{3A}* (114) and a further thickness *d_{3B}* (115), respectively, wherein said thicknesses (114) and (115) are measured along the first direction (105).

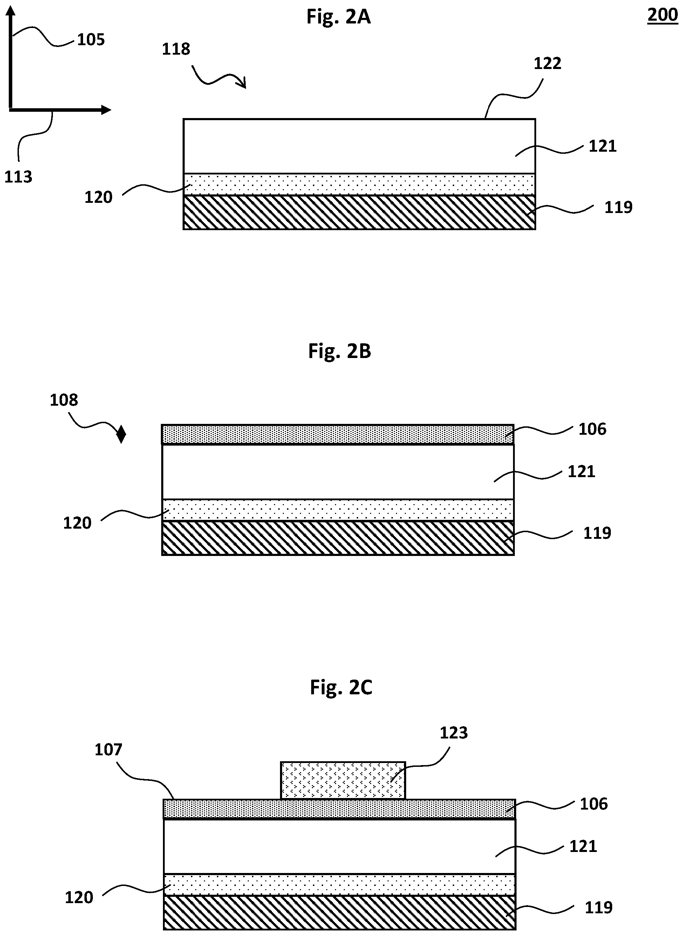

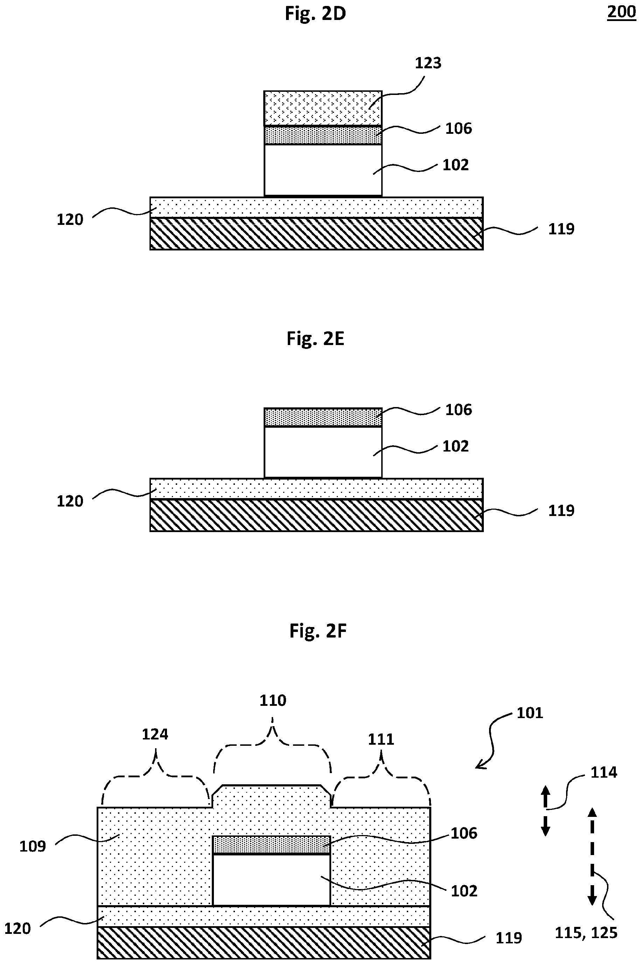

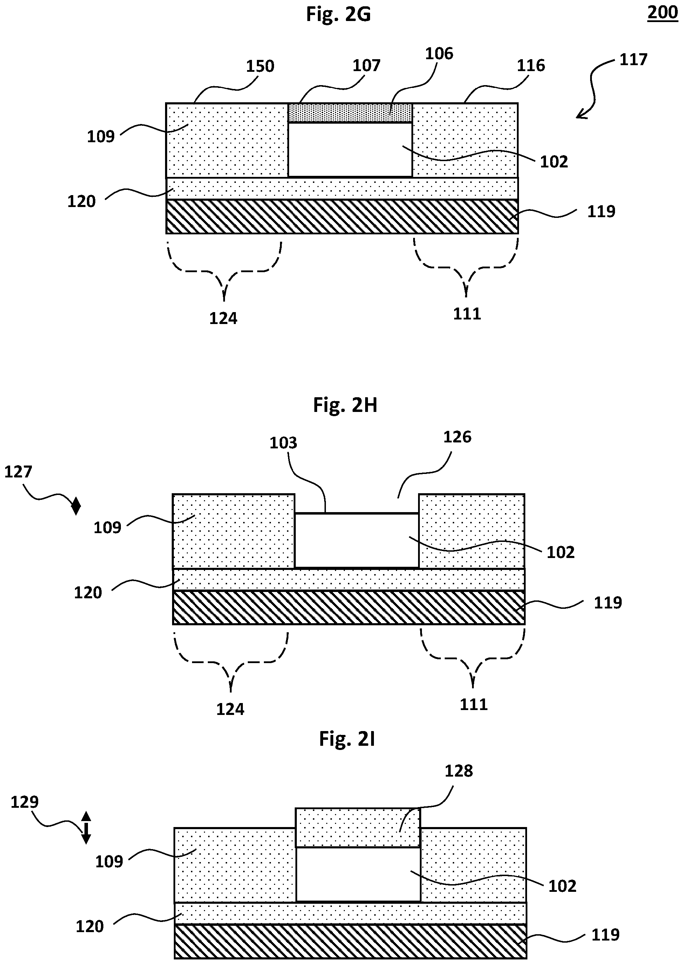

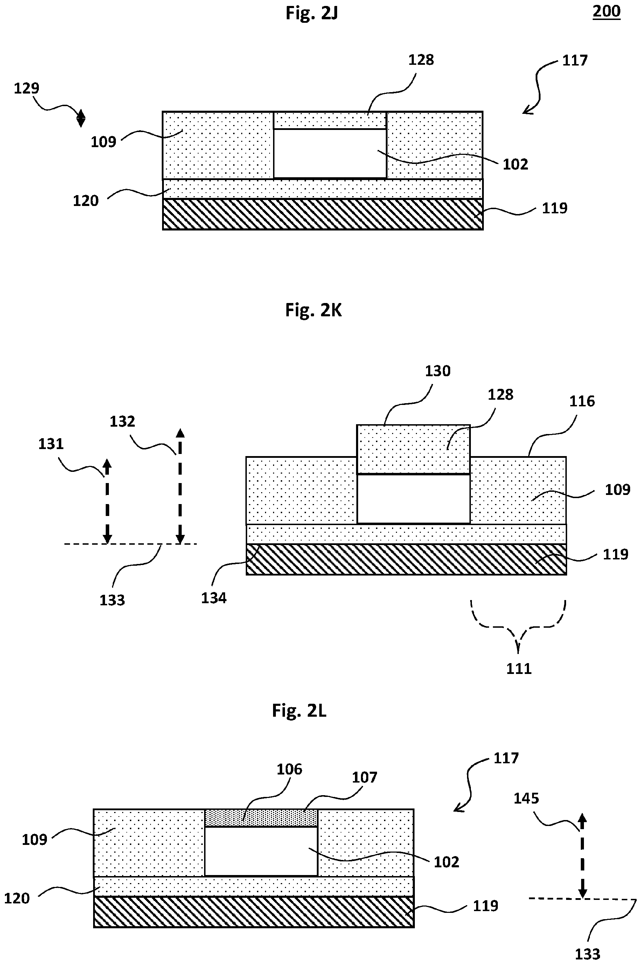

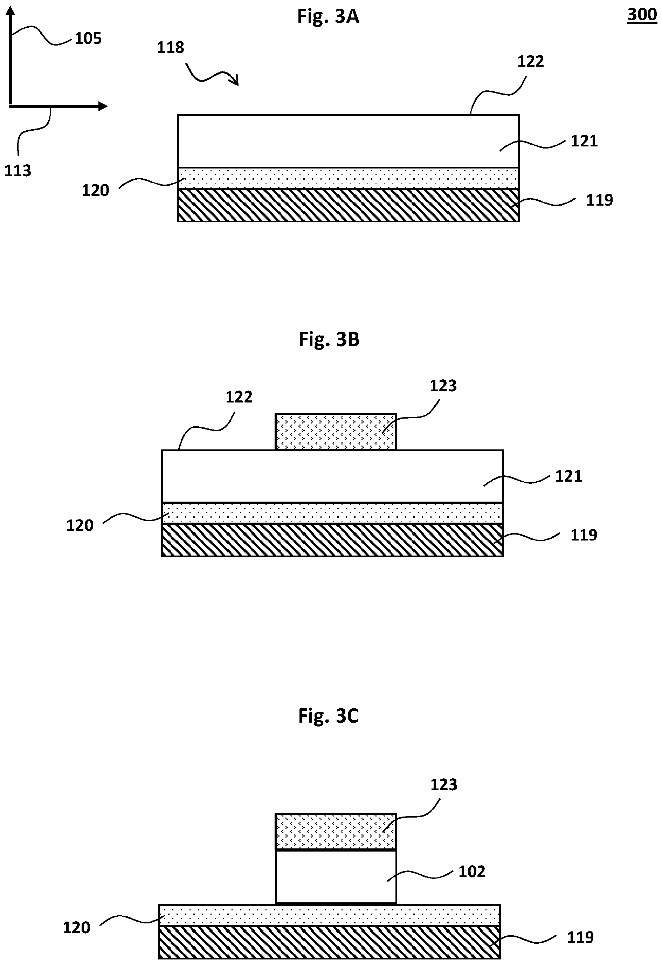

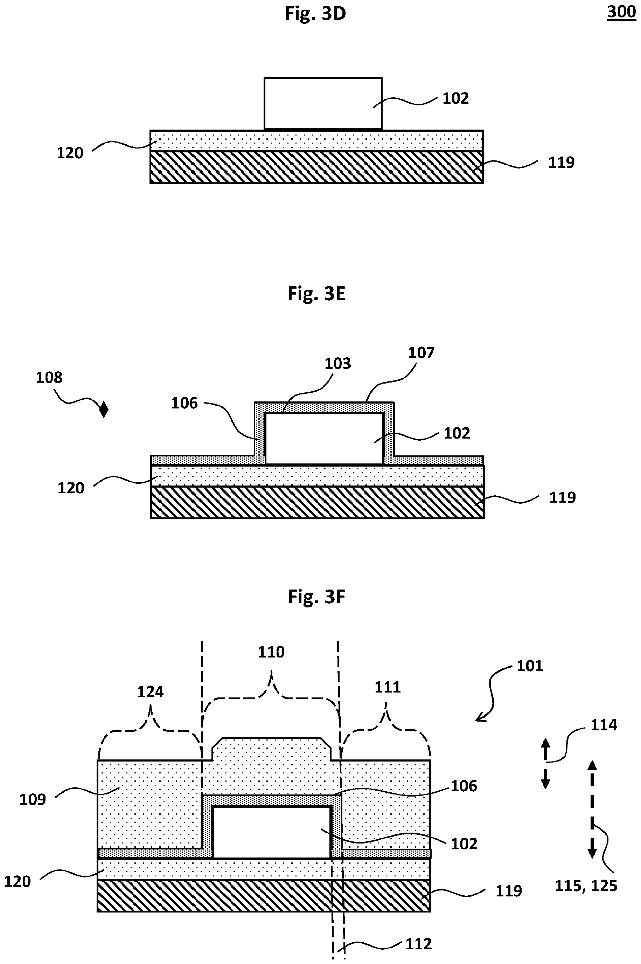

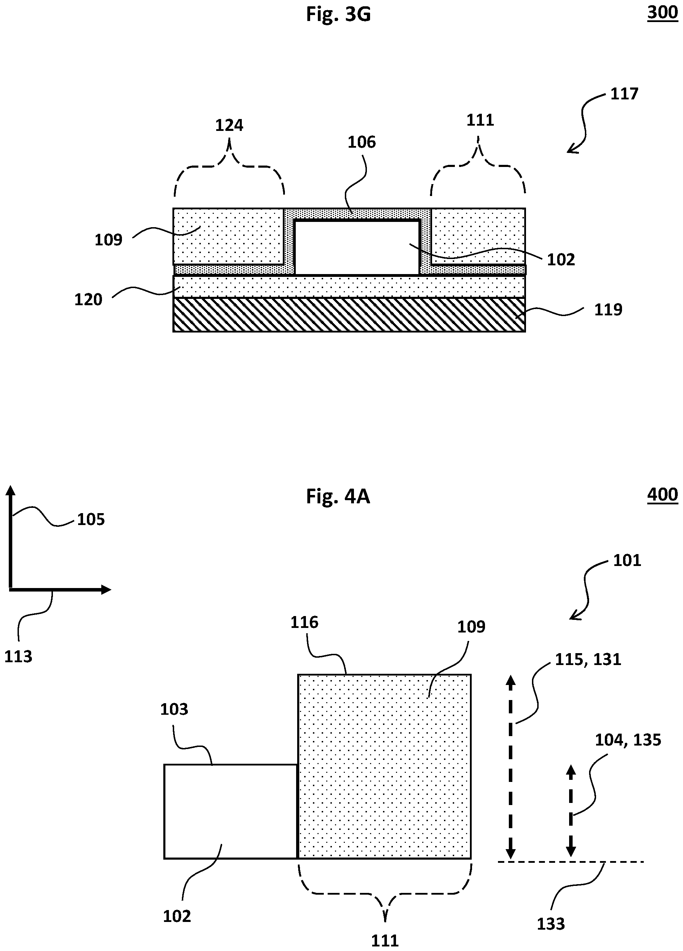

It should be understood that Fig. 1A is an exemplary embodiment, and various other embodiments of the intermediate layered structure (101) are also possible. For example, the layer of the second kind (106) may also be arranged as shown in Figs 2 and 3. The first layer of the further kind (109) may also have an even-further section arranged as shown in Figs 2 and 3.

In Fig. 1B, the first thickness *d_{3A}* (114) and the further thickness *d_{3B}* (115) of the first layer of the further kind (109) are reduced using chemical-mechanical polishing (a first thickness-reducing technique). As shown in Fig. 1B, the first section (110) of the first layer of the further kind (109) is completely removed, *i.e., d_{3A}* = 0 nm.

In Figs 1A and 1B, at least one property varies between the element of the first kind (102) and the layer of the second kind (106), and between the layer of the second kind (106) and the first layer of the further kind (109). This at least one property includes a chemical composition. For example, the element of the first kind (102) is made from silicon nitride, the layer of the second kind (106) is made from silicon carbide, while the first layer of the further kind (109) is made from silicon dioxide. Furthermore, when subjected to the chemical-mechanical polishing described in Fig. 1B, the first layer of the further kind (109) has a larger material removal rate than the layer of the second kind (106).

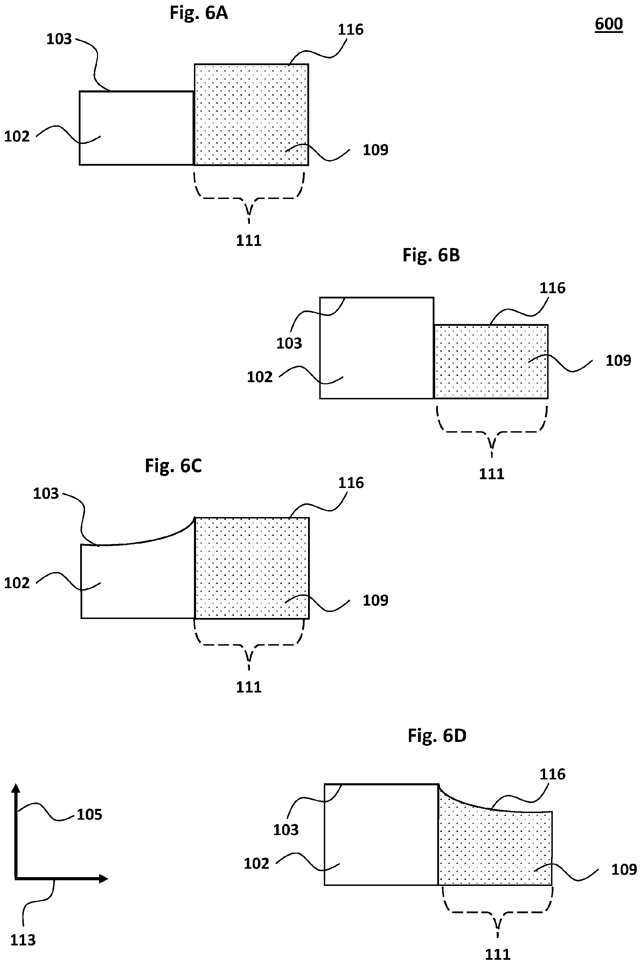

In order to obtain a desired planarization of, *e.g.,* the further section (111) of the first layer of the further kind (109), the intermediate layered structure is subjected to chemical-mechanical polishing. However, this leads to the creation of a discontinuity between the element of the first kind (102) and the further section (111) of the first layer of the first kind (109). Examples of possible discontinuities are shown in Figs 6A to 6D. The layer of the second kind (106) allows, amongst others, for an improved planarization, as discontinuities that would normally be created by the chemical-mechanical polishing can be reduced. This includes discontinuities between, *e*.*g*., the first surface (107) of the layer of the second kind (106), and a first surface (116) of the further section (111) of the first layer of the further kind (109). Simultaneously, the layer of the second kind (106) protects the element of the first kind (102) during the chemical-mechanical polishing. Upon completion of the chemical-mechanical polishing, the layered structure (117) is obtained.

Fig. 2 shows the steps of a second method (200), according to the invention, for producing a layered structure (117). The second method comprises the steps illustrated in Figs 2A to 2J.

In Fig. 2A, an initial layered structure (118) is provided. The initial layered structure (118) comprises a wafer layer (119) and a layer of a first kind (121) superimposed on the wafer layer (119). The layer of a first kind (121) has a first surface (122). One or more layers of an additional kind (120) (e.g., a layer comprising silicon dioxide, layers comprising a metal) may be arranged between the wafer layer (119) and the layer of the first kind (121).

In Fig. 2B, a layer of the second kind (106) is deposited on the layer of the first kind (121) such that the layer of the second kind (106) is superimposed on a first surface (122) of layer of the first kind (121). The layer of the second kind (106) is deposited using, *e*.*g*., chemical vapour deposition. The layer of the second kind (106) has a thickness d₂ (108).

In Fig. 2C, a masking layer (123) is deposited on the first surface (107) of the layer of the second kind (106), and at least one section of the masking layer (123) is removed to partially expose the layer of the second kind (106). The depositing of the masking layer (123) and the removal of the at least one section of the masking layer (123) can be done using, *e*.*g*., photolithography. In Fig. 2C, the masking layer (123) is a photoresist.

In Fig. 2D, the thickness of at least one section of the layer of the second kind (106) has been reduced. The thickness of at least one section of the layer of the first kind (121) has also been reduced, with the element of the first kind (102) obtained thereby. In Fig. 2D, the sections of the layer of the second kind (106) and the layer of the first kind (121) have been completely removed. It is also possible for the masking layer to be adapted arranged such that a plurality of elements of the first kind (102) can be obtained. For the purposes of illustration, however, Fig. 2D shows only on element of the first kind (102).

In Fig. 2E, the masking layer (123) is removed.

In Fig. 2F, a first layer of a further kind (109) is deposited such that the first layer of the further kind (109) at least partially surrounds the element of the first kind (102), as well as the layer of the second kind (106). Furthermore, the first layer of the further kind (109) is deposited such that a first section (110) of the first layer of the further kind (109) is superimposed on the first surface (107) of the layer of the second kind (106), and such that a further section (111) of the first layer of the further kind (109) is arranged at a first distance *l₃* (112) from the element of the first kind (102). In Fig. 2F, the layer of the second kind (106) is only superimposed on the first surface of the element of the first kind (102). As a result, the further section (111) of the first layer of the further kind (109) touches the element of the first kind (102), such that the first distance *l₃* = 0 nm. Fig. 2F further shows that as the first layer of the further kind (109) partially surrounds the element of the first kind (102), the first layer of the further kind (109) also has an even-further section (124) that touches the element of the first kind (102). The first section (110) and the further section (111) of the first layer of the further kind (109) have a first thickness *d_{3A}* (114) and a further thickness *d_{3B}* (115), respectively. Similarly, the even-further section (124) has an even-further thickness *d_{3C}* (125), which is the same as the further thickness *d_{3B}* (115). The first layer of the further kind (109) can be deposited using, e.g., chemical vapour deposition. Once the first layer of the further kind (109) has been deposited, an intermediate structure (101) is obtained.

As described in Fig. 1B, in Fig. 2G the first thickness *d_{3A}* (114), the further thickness *d_{3B}* (115) and the even-further thickness *d_{3C}* (125) are reduced using chemical-mechanical polishing (a first thickness-reducing technique). As shown in Fig. 1G, the first section (110) of the first layer of the further kind (109) is completely removed, *i.e., d_{3A}* = 0 nm. The method can be stopped at this stage, in which case the structure in Fig. 2G is defined as the layered structure (117). Alternatively, the method may be continued with the steps described in Figs 2H to 2J, in which case the layered structure is obtained after completion of the step described in Fig. 2J. Fig. 2G also shows a first surface (107) of the layer of the second kind (106), a first surface (116) of the further section (111) of the first layer of the further kind (109), and a first surface (150) of the even-further section (124) of the first layer of the further kind (109).

In Fig. 2H, the thickness d₂ of the of the layer of the second kind is reduced using wet etching (a further thickness-reducing technique). This results in the formation of a recess (126) in the first layer of the further kind (109). The recess (126) has a depth *D_{R}* (127). The wet etching completely removes the layer of the second kind, thereby exposing the first surface (103) of the element of the first kind (102). However, it is not required that the layer of the second kind is completely removed. Reducing the thickness *d₂* of the layer of the second kind of, *e.g.,* Fig. 2G, without completely removing the layer of the second kind will also lead to the formation of a recess.

In Fig. 2I, a further layer of the further kind (128) is deposited on the first surface (103) of the element of the first kind (102). The further layer of the further kind (128) has a thickness *d₄* (129). The further layer of the further kind (128) is deposited using chemical vapour deposition. While a further layer of the further kind (128) is deposited in Fig. 2I, it is also possible to deposit a layer of a kind that has a different chemical composition to the first layer of the further kind (109). However, a further layer of the further kind (128) is preferred.

In Fig. 2J, the thickness *d₄* (129) of the further layer of the further kind (128) is reduced using chemical-mechanical polishing. After the chemical-mechanical polishing, the layered structure (117) is obtained. The duration of the chemical-mechanical polishing in Fig. 2J is shorter than the duration of the chemical-mechanical polishing performed in Fig. 2G.

Fig. 2K (which is the same as Fig. 2I) shows how the heights of a layer and an element are defined. The height of the different elements and layers are all measured from a common plane (133), such as a first surface (134) of the wafer layer (119). The common plane (133) can be freely chosen. In Fig. 2K, the first surface (116) of the further section (111) of the first layer of the further kind (109) is arranged at a height *h_{3B}* (131), and the first surface (130) of the further layer of the further kind (128) is arranged at a height *h₄* (132). As a result of the step in Fig. 2J, the difference in height |*h_{3B}* - *h₄*| is reduced. Fig. 2L illustrates how a height *h₂* (145) of the first surface (107) of the layer of the second kind (106) is measured. As was indicated in Fig. 2K, the height *h₂* (145) is measured from a common plane (133). The definitions of the heights in Figs 2K and 2L are not just limited to the method described in Fig. 2, but indicates how height in general should be measured. This applies for any layer and element, regardless of whether these layers and elements are part of an initial layered structure, an intermediate layered structure, a layered structure, or an opto-electronic device. In general, the heights of a layer and an element are measured from a common plane to a first surface.

In Fig. 2, the thicknesses and heights of the various layers and elements, as well as the depth *D_{R}* (127) of the recess (126), are measured along a first direction (105). The first distance *l₃* (112) of the further section (111) of the first layer of the further kind (109) is measured along a further direction (113). The first direction (105) and the further direction (113) are illustrated in Fig. 2A.

In Figs 2A to 2L, at least one property varies between the element of the first kind (102) and the layer of the second kind (106), and between the layer of the second kind (106) and the first layer of the further kind (109). This at least one property includes a chemical composition. For example, the element of the first kind (102) is made from silicon nitride, the layer of the second kind (106) is made from silicon carbide, while the first layer of the further kind (109) is made from silicon dioxide. Furthermore, the at least one property also includes a material removal rate. When subjected to the chemical-mechanical polishing described in Fig. 2G, the first layer of the further kind (109) has a larger material removal rate than the layer of the second kind (106). The at least one property also includes a further etch rate. When subjected to the wet etching described in Fig. 2H, the layer of the second kind (106) has a further etch rate that is larger than both the further etch rates of the element of the first kind (102) and the first layer of the further kind (109).

Fig. 3 shows the steps of a third method (300), according to the invention, for producing a layered structure (117). The second method comprises the steps illustrated in Figs 3A to 3G.

Similar to Fig. 2A, in Fig. 3A an initial layered structure (118) is provided. The initial layered structure (118) comprises a wafer layer (119) and a layer of a first kind (121) superimposed on the wafer layer. The layer of a first kind (121) has a first surface (122). One or more layers of an additional kind (e.g., a layer comprising silicon dioxide, layers comprising a metal) may be arranged between the wafer layer (119) and the layer of the first kind (121).

In Fig. 3B, a masking layer (123) is deposited on the first surface (122) of the layer of the first kind (121), and at least one section of the masking layer (123) is removed to partially expose the layer of the first kind (121). The depositing of the masking layer (123) and the removal of the at least one section of the masking layer (123) can be done using, e.g., photolithography. In Fig. 3B, the masking layer (123) is a photoresist.

In Fig. 3C, the thickness of at least one section of the layer of the first kind (121) has been reduced, with the element of the first kind (102) obtained thereby. In Fig. 3C, the sections of the layer of the first kind (121) have been completely removed. It is also possible for the masking layer to be adapted arranged such that a plurality of elements of the first kind (102) can be obtained. For the purposes of illustration, however, Fig. 3C shows only on element of the first kind (102).

In Fig. 3D the masking layer (123) is removed.

In Fig. 3E, a layer of the second kind (106) is deposited such that the layer of the second kind (106) is superimposed on a first surface (103) of the element of the first kind (102). Furthermore, layer of the second kind (106) is deposited such that the layer of the second kind (106) partially surrounds the element of the first kind (102). The layer of the second kind (106) has a thickness d₂ (108). The layer of the second kind (106) is deposited using chemical vapour deposition.

In Fig. 3F, a first layer of the further kind (109) is deposited such that the first layer of the further kind (109) at least partially surrounds the element of the first kind (102). Furthermore, first layer of the further kind (109) is deposited such that a first section (110) of the first layer of the further kind (109) is superimposed on the first surface (107) of the layer of the second kind (106), and such that a further section (111) of the first layer of the further kind (109) is arranged at a first distance *l₃* (112) from the element of the first kind (102). The distance *l₃* (112) extends between the dashed lines shown in Fig. 3F, and correspond to a thickness of the layer of the second kind (106). Fig. 3F further shows that as the first layer of the further kind (109) partially surrounds the element of the first kind (102), the first layer of the further kind (109) also has an even-further section (124) that is also arranged at a distance from the element of the first kind (102). The first section (110) and the further section (111) of the first layer of the further kind (109) have a first thickness *d_{3A}* (114) and a further thickness *d_{3B}* (115), respectively. Similarly, the even-further section (124) has an even-further thickness *d_{3C}* (125), which is the same as the further thickness *d_{3B}* (115). The first layer of the further kind (109) can be deposited using, *e.g.,* chemical vapour deposition. Once the first layer of the further kind (109) has been deposited, an intermediate structure (101) is obtained.

In Fig. 3G the first thickness *d_{3A}* (114), the further thickness *d_{3B}* (115), and the even-further thickness *d_{3C}* (125) are reduced using chemical-mechanical polishing (a first thickness-reducing technique). As shown in Fig. 3G, the first section (110) of the first layer of the further kind (109) is completely removed, *i.e., d_{3A}* = 0 nm. Upon completion of the chemical-mechanical polishing, the layered structure (117) is obtained.

The method in Fig. 3 may also include the steps illustrated in Figs 2H to 2J. Where the layer of the second kind (106) is removed, as described in Fig. 2H, the method of Fig. 3 may be modified to only remove a section of the layer of the second kind (106) wherein said section is arranged above (in the sense of Fig. 3) the element of the first kind (102).

In Fig. 3, with the exception of the layer of the second kind (106), the thicknesses of the various layers and elements are measured along a first direction (105). The first distance *l₃* (112) of the further section (111) of the first layer of the further kind (109) is measured along a further direction (113). The first direction (105) and the further direction (113) are illustrated in Fig. 3A. For the layer of the second kind (106), the thickness d₂ (108) is measured along the first direction (105). *I.e.,* the thickness *d₂* (108) is measured perpendicular to the first surface (103) of the element of the first kind (102). A thickness of the layer of the second kind (106) on the sides of the element of the first kind (103) (in the sense of Fig. 3) is measured along the further direction (113).

In Figs 3A to 3G, at least one property varies between the element of the first kind (102) and the layer of the second kind (106), and between the layer of the second kind (106) and the first layer of the further kind (109). This at least one property includes a chemical composition. For example, the element of the first kind (102) is made from silicon nitride, the layer of the second kind (106) is made from silicon carbide, while the first layer of the further kind (109) is made from silicon dioxide. Furthermore, the at least one property also includes a material removal rate. When subjected to the chemical-mechanical polishing described in Fig. 3G, the first layer of the further kind (109) has a larger material removal rate than the layer of the second kind (106).

Fig. 4 shows the steps of a fourth method (300), according to the invention, for producing a layered structure (117). The fourth method comprises the steps illustrated in Figs 4A and 4B.

In Fig. 4A, an intermediate layered structure (101) is provided. The intermediate layered structure (101) comprises an element of a first kind (102) that has a first surface (103), wherein the first surface (103) is arranged at a height *h_{1X}* (135). The height *h_{1X}* (135) is measured along a first direction (105). As illustrated in Fig. 2K, the height is measured from a common plane (133). The element of the first kind (102) also has a thickness *d₁* (104), measured along the first direction (105). In Fig 4A, the common plane (133) is chosen such that the height *h_{1X}* (135) and the thickness *d₁* (104) are equal. The element of the first kind (102) is preferably a waveguide. The intermediate layered structure (101) further comprises a first layer of a further kind (109) that has a further section (111). The further section (111) is arranged at a first distance *l₃* from the element of the first kind (102), wherein the first distance *l₃* is measured along a further direction (113). The further direction (113) is perpendicular to the first direction (105). In Fig. 4A, the further section (111) of the first layer of the further kind (109) is arranged to touch the element of the first kind (102), *i.e., l₃* = 0 nm. The further section (111) of the first layer of the further kind (109) has a first surface (116) that is arranged at height *h_{3B}* (131), wherein *h_{3B}* (131) is measured along the first direction (105). The further section (111) of the first layer of the further kind (109) also has a further thickness *d_{3B}* (115), measured along the first direction (105). As is the case for the element of the first kind (102), the height *h_{3B}* (131) and the further thickness *d_{3B}* (115) of the further section (111) of the first layer of the further kind (109) are equal. Furthermore, Fig. 4A shows that *h_{3B}* (131) > *h_{1X}* (135), *i.e.,* |*h_{3B}* - *h_{1X}*| > 0 nm. It will be understood that the first layer of the further kind (109) of the intermediate structure (101) can also have an even-further section, as shown in, *e.g.,* Fig. 2G. The element of the first kind (102) has a higher oxidation rate than the further section (111) of the first layer of the further kind (109).

In Fig. 4B, the intermediate structure (101) is placed in an oxygen-rich environment, which leads to the oxidation of the element of the first kind (102). As a result, a layer of an even-further kind (136) is formed on the first surface (103) of the element of the first kind (102). The layer of the even-further kind (136) has a first surface (137) that is arranged at a height *h₅* (138), wherein the height *h₅* (138) is measured along the first direction (105). As a result of the oxidation, the height *h_{1X}* (135) of the element of the first kind (102) will be reduced to a new height *h_{1Y}* (139). The height *h_{1X}* (135) is thus the height of the element of the first kind (102) prior to the oxidation step, while the height *h_{1Y}* (139) is the height of the element of the first kind (102) after the oxidation step. As also shown in Fig. 4B, the height *h₅* (138) of the layer of the even-further kind (136) is equal to the height *h_{3B}* (131) of the further section (111) of the first layer of the further kind (109). In other words, |*h_{3B}* - *h₅*| < |*h_{3B}* - *h_{1X}*|. After completion of the oxidation step, the layered structure (117) is obtained.

Optionally, following the formation of the layer of the even-further kind (136), a thickness *d₅* (146) of the layer of the even-further kind (136) may be reduced using, e.g., chemical-mechanical polishing. This thickness reducing step may be performed when, *e.g., h₅* (138) > *h_{3B}* (131), and/or *h₅* (138) < *h_{3B}* (131), and/or |*h_{3B}* -*h₅*| > |*h_{3B}* - *h_{1X}*|.

The method of Fig. 4 may also be combined with the methods shown in Figs 1 to 3. For example, the method of Fig. 2 may be performed up to the step shown in Fig. 2H. However, instead of performing the step described in Fig. 2I (the depositing of a further layer of the first kind), the steps of Fig 4B may be performed (the intermediate layered structure provided in Fig. 4A corresponds to the intermediate layered structure of Fig. 2H). In addition, the step shown in Fig. 4B may be followed by the steps shown in Figs 2I and 2J.

Alternatively, the steps shown in Figs 4A and 4B may be followed by the steps of Figs 2I and 2J, without necessarily performing at least one of the steps shown in Figs 2A to 2H. For example, a first layer of a further kind is deposited on an element of the first kind such that a first section of the layer of the further kind is superimposed on a first surface of the element of the first kind, and such that a further section of the first layer of the further kind is arranged at a distance *l₃* from the element of the first kind (similar to Fig. 2F, but without the layer of the second kind). The element of the first kind and the first layer of the further kind is then subjected to chemical mechanical polishing, which result in the intermediate layered structure of Fig. 4A. The step shown in Fig. 4B is performed, optionally followed by the steps of Figs 2I and 2J.

Fig. 5 is a schematic illustration of a modulator (500), according to the invention, obtained by using a layered structure (117) according to the invention. Fig. 5 shows a layered structure (117) obtainable according to the method shown in Fig. 2. Alternatively, the layered structures obtainable according to the methods of Figs 3 and 4 may also be used. The modulator (500), an example of an opto-electronic device, is adapted and arranged to modulate an amplitude of an electromagnetic wave propagating in a waveguide (102). The modulator (500) comprises a layered structure (117). The layered structure (117) comprises a wafer layer (119) and an element of a first kind (102) superimposed on the wafer layer (119). The element of the first kind (102) is a waveguide. A first surface (103) of the waveguide (102) is arranged at a height *h₁* (144). A layer of an additional kind (120) (*e.g.,* a layer comprising silicon dioxide) is arranged between the wafer layer (119) and the waveguide (102). The layered structure (117) further comprises a layer of a second kind (106) superimposed on the waveguide (102). The layered structure (117) further comprises a further section (111) and an even-further section (124) of a first layer of a further kind (109). A first surface of the further section (111) is arranged at a height *h_{3B}* (131). Although not indicated in Fig. 5, a first surface of the even-further section (124) is arranged at a height that varies by less than 5 % from the height *h_{3B}* (131). The further section (111) and the even-further section (124) are arranged to touch the waveguide (102). The layered structure (117) has a first surface (140), which in Fig. 5 is formed by the first surfaces of the further section (111) and the even-further section (124) of the first layer of the further kind (109), and the first surface of the layer of the second kind (106) (see Fig. 2G). In Fig. 5, a height H of the first surface (140) is equal to the height *h_{3B}* (131). In general, a first surface (140) of the layered structure (117) should preferably be understood as the surface onto which at least one electrically conducting element is superimposed, more preferably deposited. In general, a first surface (140) of the layered structure (117) extends over at least an element of the first kind (102).

The modulator (500) in Fig. 5 also comprises a first electrically conducting element (141) and a further electrically conducting element (142). In Fig. 5, both the first and further electrically conducting elements (141) and (142) are made from a single layer of graphene. Furthermore, a dielectric layer (143) is arranged between the first and further electrically conducting elements (141) and (142). The dielectric layer (143) can comprise an oxide, such as aluminium oxide. An end of the first electrically conducting element (141) is in electrical contact with a first electrode (not shown), while an end of the further electrically conducting element (142) is in electrical contact with a further electrode (not shown).

The height of the largest discontinuity is determined as follows (Fig. 5 is used as an example): two points A and *B* are defined. Point *A* is located at a first edge of the layered structure (117). In Fig. 5, the first edge is an end of the graphene layer (142), where said end is in electrical contact with the further electrode. Point *B* is located at a further edge of the layered structure (117), where the further edge is opposite the first edge. In Fig. 5, the further edge is an end of the graphene layer (141), where said end is in electrical contact with the first electrode. The height *H* of the first surface (140) of the layered structure (117) is measured at points *A* and *B.* The height *H* is measured from a common plane (133), which in Fig. 5 is chosen as a lower surface of the wafer layer (119). The height *H* is then also measured at 5 nm intervals along the first surface (140) of the layered structure (117). The height of the largest discontinuity is defined as *H_{MAX}* - *H_{MIN},* where *H_{MAX}* is the largest height measured along the first surface (140), and *H_{MIN}* is the smallest height measured along the first surface (140).

The distance between the waveguide (102) and the first graphene layer (141) is defined as the maximum distance measured between the first surface (103) of the waveguide (102) and the first surface (140) of the layered structure (117). This distance is measured along the first direction (105).

Fig. 6 is a schematic illustration of examples of discontinuities in a first surface of a layered structure. Figs 6A to 6D show part of a layered structure that comprises an element of a first kind (102) and a further section (111) of a first layer of a further kind (109). In Figs 6A to 6D, the first surface of the layered structure is formed by at least a first surface (103) of the element of the first kind (102) and a first surface (116) of the further section (111) of the first layer of the further kind (109). Figs 6A and 6B show a step discontinuity in the first surface of the layered structure. The step discontinuity is located where the element of the first kind (102) and the further section (111) of the first layer of the further kind (109) touch each other. Figs 6C and 6D show a dish discontinuity in the first surface of the layered structure. In Fig. 6C the dish discontinuity is located in the element of the first kind (102), while in Fig. 6D the dish discontinuity is located in the further section (111) of the first layer of the further kind (109). If the height (measured along the first direction 105) of the first surface of the layered structure decreases by more than 10 nm over a 10 nm distance (measured along a further direction 113), this leads to any electrically conducting element deposited on the first surface of the layered structure being damaged.

Fig. 7 is a flow diagram showing a fifth method, according to the invention, for producing a layered structure. In step 701, an intermediate layered structure is provided, wherein the intermediate layered structure comprises an element of a first kind. The element of the first kind has a first surface and a thickness *d₁,* measured along a first direction, wherein *d₁* ≤ 1.5 µm. The element of the first kind is a waveguide. The intermediate layered structure further comprises a layer of a second kind superimposed on at least the first surface of the element of the first kind. The layer of the second kind has a first surface and a thickness *d₂,* measured along the first direction, wherein d₂ ≤ 100 nm. The layer of the second kind preferably touches the element of the first kind. The intermediate layered structure further comprises a first layer of a further kind that at least partially surrounds the element of the first kind, wherein a first section of the first layer of the further kind is superimposed on the first surface of the layer of the second kind, and a further section of the first layer of the further kind is arranged at a first distance *l₃* from the element of the first kind. The first distance *l₃* is measured along a further direction, wherein the further direction is perpendicular to the first direction. Furthermore, *l₃* ≤ 100 nm, while the first section has a first thickness *d_{3A}* and the further section has a further thickness *d_{3B},* measured along the first direction. The first section of the layer of the further kind preferably touches the layer of the second kind.

In step 702, the first thickness *d_{3A}* and the further thickness *d_{3B}* of the first layer of the further kind is reduced using chemical-mechanical polishing. The thickness *d_{3A}* is reduced such that the first section of the layer of the further kind is preferably completely removed. Furthermore, the material removal rate of the first section of the further kind, during the chemical-mechanical polishing, is larger than the material removal rate of the layer of the second kind.

In optional step 703, the thickness d₂ of the of the layer of the second kind is reduced using an etching method to form a recess in the first layer of the further kind. The layer of the second kind is preferably completely removed, such that the first surface of the element of the first kind is exposed. The etching method is chosen such that the etch rate of the layer of the second kind is larger than the etch rate of the first layer of the further kind, and preferably larger than the etch rate of the element of the first kind.

In optional step 704, a further layer of the further kind is deposited in the recess, such that the further layer of the further kind is superimposed on the first surface of the element of the first kind.

In optional step 705, a thickness *d₄* of the further layer of the further kind is reduced using chemical-mechanical polishing. The further layer of the further kind is not completely removed.

Fig. 8 is a flow diagram showing a sixth method, according to the invention, for producing a layered structure. In step 801, an intermediate layered structure is provided, wherein the intermediate layered structure comprises an element of a first kind. The element of the first kind is a waveguide. The element of the first kind has a first surface that is arranged at height *h₁ₓ,* wherein *h₁ₓ* is measured along a first direction. The element of the first kind has a thickness *d₁,* measured along the first direction, wherein *d₁* ≤ 1.5 µm. The intermediate layered structure further comprises a first layer of a further kind, wherein a further section of the first layer of the further kind is arranged at a first distance *l₃* from the element of the first kind. The first distance *l₃* is measured along a further direction, wherein the further direction is perpendicular to the first direction. Furthermore, *l₃* ≤ 100 nm. The further section has a first surface that is arranged at a height *h_{3B},* wherein *h_{3B}* is measured along the first direction, and |*h_{3B}* - *h_{1X}*| = 8 nm.

In step 802, a part of the element of the first kind is oxidised to form a layer of an even-further kind on the first surface of the element of the first kind. The layer of the even-further kind has a first surface that is arranged at a height *h₅,* wherein the height *h₅* is measured along the first direction Furthermore, |*h_{3B}* - *h₅*| < |*h_{3B}* - *h_{1X}*|, with *h_{1X}* being the height of the first surface of the element of the first kind prior to the oxidation step. Optionally, in step 803 a thickness *d₅* of the layer of the even-further kind is reduced. The steps described in 704 and 705 can optionally be performed after step 802.

Following the obtaining of the layered structure in Figs. 7 and 8, one or more electrically conducting elements may be superimposed on the layered structures, in one or more steps, to obtain an opto-electronic device. Examples of the opto-electronic device include a modulator and a photo-detector, preferably a modulator and a photo-detector that comprises at least one electrically conducting element in the form of a graphene layer.

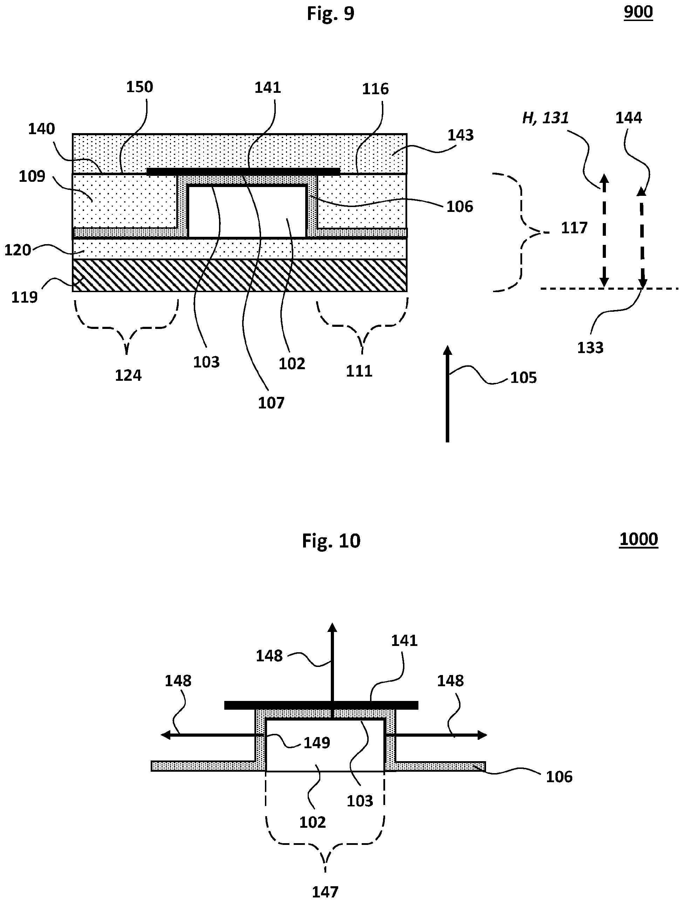

Fig. 9 is a schematic illustration of a photodetector (900), according to the invention. The photodetector (900) preferably comprises a layered structure (117) according to the invention. The layered structure (117) shown in Fig. 9 can be obtained according to the method shown in, *e.g.,* Fig. 3. The photodetector (900), an example of an opto-electronic device, is adapted and arranged to at least partially absorb an electromagnetic wave propagating in a waveguide (102). The layered structure (117) comprises a wafer layer (119) and an element of a first kind (102) superimposed on the wafer layer (119). The element of the first kind (102) is a waveguide. A first surface (103) of the waveguide (102) is arranged at a height *h₁* (144). A layer of an additional kind (120) (*e.g.,* a layer comprising silicon dioxide) is arranged between the wafer layer (119) and the waveguide (102). The layered structure (117) further comprises a layer of a second kind (106) that partially surrounds the waveguide (102). A first section (147) of the layer of a second kind (106) is superimposed on the first surface (103) of the waveguide (102). The layered structure (117) further comprises a further section (111) and an even-further section (124) of a first layer of a further kind (109). A first surface (116) of the further section (111) is arranged at a height *h_{3B}* (131). Although not indicated in Fig. 9 a first surface (150) of the even-further section (124) is arranged at a height that varies by less than 5 % from the height *h_{3B}*(131).

The further section (111) and the even-further section (124) do not touch the waveguide (102), but touch the layer of the second kind (106). The layered structure (117) has a first surface (140), which, in Fig. 9, is formed by the first surfaces (116) and (150) of the further section (111) and the even-further section (124) of the first layer of the further kind (109), respectively, and a first surface (107) of the layer of the second kind (106). In Fig. 9, a height *H* of the first surface (140) is equal to the height *h_{3B}*(131). In general, a first surface (140) of the layered structure (117) should preferably be understood as the surface onto which at least one electrically conducting element is superimposed, more preferably deposited. In general, a first surface (140) of the layered structure (117) extends over at least an element of the first kind (102).

The photodetector (900) in Fig. 9 also comprises a first electrically conducting element (141) made from a single layer of graphene. Furthermore, a dielectric layer (143) is superimposed on the first electrically conducting element (141). The dielectric layer (143) can comprise an oxide, such as aluminium oxide. The ends of the first electrically conducting element (141) is in electrical contact with two electrodes (not shown).

Fig. 10 is a schematic illustration showing further details of the photodetector of Fig. 9. For the purposes of illustration, most of the features shown in Fig. 9 have been omitted in Fig. 10. Fig. 10 shows the first section (147) of the layer of the second kind (106) superimposed on the first surface (103) of the waveguide (102). Fig. 10 also shows that the first section (147) of the layer of the second kind (106) is arranged between the waveguide (102) and the first electrically conducting element (141). Fig. 10 also shows how a thickness *d_{R}* of the layer of the second kind (106) is measured. The thickness *d_{R}* is measured perpendicular to a surface (149) of the waveguide (102), along the directions (148). The first surface (103) of the waveguide (102) forms part of the surface (149). The thickness *d*_{*R*.} *_{MAX} is* the maximum value of the thickness *d_{R}*.

Fig. 10 can also be used to illustrate the % of the surface (149) of the element of the first kind (102) that is surrounded by the layer of the second kind (106). Fig. 10 is a cross-sectional cut of the photodetector, made at a position where the layer of the second kind (106) is superimposed on the element of the first kind (102). From Fig. 10 it can be seen that three sides of the circumference of the element of the first kind (102) is surrounded by the layer of the second kind (106), which corresponds to roughly 65 % of the circumference of the element of the first kind (102) shown in the cross-sectional cut of Fig. 10. The % of the surface (149) of element of the first kind (102) that is surrounded by the layer of the second kind (106) is thus defined to also be roughly 65 %.

Although Figs 1 to 5, and 9 and 10 only show a single element of the first kind, it will be understood that a layered structure may comprise a plurality of elements of the first kind. The layered structure is preferably superimposed on a wafer or waver layer that will be cut into a plurality of integrated circuit dies.

### EXAMPLES

The invention is illustrated further by way of examples. The invention is not restricted to the examples. Where it is disclosed in the examples that one component is superimposed or deposited *"directly"* on another component, this should be understood to mean that the two components touch each other. In the examples below, an Ebara F-REX200M2 is used for the chemical-mechanical polishing.

### Example 1

Examples 1.1 and 1.2 are comparative examples. Examples 1.3 to 1.5 are examples according to the invention.

### Example 1.1

An intermediate layered structure, comprising a plurality of elements of the first kind, is provided. The elements of the first kind are waveguides. In a cross-sectional cut of the intermediate layered structure, made at a position of any element of the first kind, the intermediate layered structure has the following layers, arranged in this order:
i. A wafer layer made from crystalline silicon.
ii. A layer of silicon dioxide superimposed directly on the wafer layer.
iii. An element of a first kind superimposed directly on the silicon dioxide layer. The element of the first kind is made from silicon nitride. The element of the first kind has a thickness of 350 nm.
iv. A first section of a first layer of the further kind superimposed directly on the element of the first kind. The first layer of the further kind is made from silicon dioxide, with the first section having a thickness of 1000 nm.

The first layer of the further kind, of the intermediate layered structure, is also arranged partially around the elements of the first kind, such that a further section and an even-further section of the first layer of the further kind are arranged in contact with (touches) each element of the first kind.

The intermediate layered structure is subjected to chemical-mechanical polishing until the first sections of the first layer of the further kind are removed. A layered structure is thereby obtained. For each of the elements of the first kind, a first electrically conducting element in the form of a graphene layer is deposited directly on the layered structure (*cf.* Fig. 5; note that for Example 1.1, no layer of the second kind is present in the layered structure). A layer of aluminium oxide is then deposited directly on the first electrically conducting elements, followed by the deposition of second electrically conducting elements for each of the elements of the first kind (*cf.* Fig. 5). The second electrically conducting elements are also graphene layers. A plurality of modulators are thereby obtained.

### Example 12

Example 1.1 is repeated, but with the following difference: the intermediate layered structure is subjected to chemical-mechanical polishing, but only to reduce a thickness of the first sections of the first layer of the further kind. The first sections of the first layer of the further kind are thus not removed.

### Example 1.3

An intermediate layered structure, comprising a plurality of elements of the first kind, is provided. The elements of the first kind are waveguides. In a cross-sectional cut of the intermediate layered structure, made at a position of any element of the first kind, the intermediate layered structure has the following layers, arranged in this order:
i. A wafer layer made from crystalline silicon.
ii. A layer of silicon dioxide superimposed directly on the wafer layer.
iii. An element of a first kind superimposed directly on the silicon dioxide layer. The element of the first kind is made from silicon nitride. The element of the first kind has a thickness of 350 nm.
iv. A layer of a second kind superimposed directly on the element of the first kind. The layer of the second kind is only present on a first surface of the element of the first kind (see, *e.g.,* Fig. 2F), and the layer of the second kind is made from silicon carbide. The layer of the second kind has a thickness of 20 nm.
v. A first section of a first layer of the further kind superimposed directly on the layer of the second kind. The first layer of the further kind is made from silicon dioxide, with the first section having a thickness of 1000 nm.

The first layer of the further kind, of the intermediate layered structure, is also arranged partially around the elements of the first kind and the layer of the second kind, such that a further section and even-further section of the first layer of the further kind are arranged in contact with (touches) each element of the first kind (see Fig. 2F).

The intermediate layered structure is subjected to chemical-mechanical polishing until the first sections of the first layer of the further kind are removed (see Fig. 2G). During the chemical-mechanical polishing, a material removal rate of the first layer of the further kind is larger than a material removal rate of the layers of the second kind. A layered structure is thereby obtained. For each of the elements of the first kind, a first electrically conducting element in the form of a graphene layer is deposited directly on the layered structure (see Fig. 5). A layer of aluminium oxide is then deposited directly on the first electrically conducting elements, followed by the deposition of second electrically conducting elements for each of the elements of the first kind (see Fig. 5). The second electrically conducting elements are also graphene layers. A plurality of modulators are thereby obtained.

### Example 1.4

Example 1.4 is the same as Example 1.3, with the difference that prior to depositing the first electrically conducting elements, and subsequent to removing the first sections of the first layer of the further kind, the following steps are also performed (see Figs 2H to 2J).

Using wet etching, the layers of the second kind are removed. An etch rate of the layers of the second kind is larger than etch rates of both the first layer of the further kind and the elements of the first kind. The wet etching leads to the creation of recesses in the first layer of the further kind. A further layer of the further kind is deposited in the recesses such that a thickness of the further layer of the further kind is larger than the largest recess depth. The intermediate layered structure is subjected to a second chemical-mechanical polishing, and the layered structure is thereby obtained.

### Example 1.5

An intermediate layered structure, comprising a plurality of elements of the first kind, is provided. The elements of the first kind are waveguides. In a cross-sectional cut of the intermediate layered structure, made at a position of any element of the first kind, the intermediate layered structure has the following layers, arranged in this order:
i. A wafer layer made from crystalline silicon.
ii. A layer of silicon dioxide superimposed directly on the wafer layer.
iii. An element of a first kind superimposed directly on the silicon dioxide layer. The element of the first kind is made from silicon nitride. The element of the first kind has a thickness of 350 nm.

The intermediate layered structure has a first layer of a further kind that is arranged such that each element of the first kind is in contact with (touches) a further section and even-further section of the first layer of the further kind (*cf.* Figs 2H and 4A). Recesses are thus present in the first layer of the further kind. The further sections and the even-further sections have a height of 355 nm. The first layer of the further kind is made from silicon dioxide.

The intermediate layered structure is placed in an oxygen rich environment. The environment contains 98 wt-% oxygen and 100 % water saturation. The environment has a temperature of 800 °C and a pressure of 1 atmosphere.

The elements of the first kind have a higher oxidation rate that the first layer of the further kind. As a result, a layer of an even-further kind is formed on a first surface of each element of the first kind. Similar to the first layer of the further kind, the layers of the even-further kind are also made from silicon dioxide. A layered structure is thereby obtained. For each of the elements of the first kind, a first electrically conducting element in the form of a graphene layer is deposited directly on the layered structure (see Fig. 5). A layer of aluminium oxide is then deposited directly on the first electrically conducting elements, followed by the deposition of second electrically conducting elements for each of the elements of the first kind (see Fig. 5). The second electrically conducting elements are also graphene layers. A plurality of modulators are thereby obtained.

Table 1 shows a comparison of the technical effects of the methods of Examples 1.1 to 1.5. The number of "-" and "+" indicate the size of the effect, *e.g.,* "--" is less than "-", and "++" is larger than "+". Where indicated, Example 1.1 is used as a reference, and an improvement (or decrease) in a technical effect obtained by Examples 1.2 to 1.5 is thus with respect to Example 1.1.

**Table 1**

| | **Ex. 1.1** | **Ex. 1.2** | **Ex. 1.3** | **Ex. 1.4** | **Ex. 1.5** |
|---|---|---|---|---|---|
| Height of largest discontinuity | 10 nm | 1 nm | 4 nm | 1 nm | 2 nm |
| Reduction in damage to first graphene layers | Reference | ++ | + | ++ | + |
| Largest distance between waveguide and first graphene layer | 0 nm | 50 nm | 5 nm | 4 nm | 4nm |
| Uniformity of modulators | Reference | + | ++ | +++ | ++ |
| Bitrate | --- | ++ | + | +++ | ++ |
| Reduction in insertion loss | Reference | ++ | + | + | + |
| Reduction in energy consumption | Reference | Variable | + | + | + |

The technical effects in Table 1 are:
- Height of largest discontinuity: see Fig. 5. The height of the largest discontinuity of the layered structure. It is desired to have the height as small as possible.
- Reduction in damage to graphene layers: whether one or both of the graphene layers in the modulators, obtained in Examples 1.1 to 1.5, are damaged during production. Damage includes cracks in the graphene layers. A "-" indicates an increase in the damage for the modulators, while a "+" indicates a reduction in damage for the modulators. It is desired to reduce the damage.
- Largest distance between waveguide and first graphene layer: see Fig. 5. The largest distance between any of the waveguides and the corresponding first graphene layer. A smaller distance is desired.
- Uniformity of modulators: the variance in geometric properties between modulators, such as the distance between the waveguide and the first graphene layer. E.g., in Example 1.2 the first surface of the layered structure has large variations (15 nm to 50 nm) in the distance between the waveguides and the respective first graphene layers. This leads to modulators that have varying performance. A "-" indicates a smaller uniformity, while a "+" indicates a larger uniformity. A larger uniformity is desirable.
- Bitrate: the rate of data flow in digital networks, typically measured in bits per second. This is the bitrate that is achievable by using the modulators obtained according to the examples. A "-" indicates a smaller bitrate, while a "+" indicates a larger bitrate. It is desired to have a larger bitrate.
- Reduction in insertion loss: insertion loss is unwanted loss in the intensity of the electromagnetic waves, *i.e.,* losses not as a result of the modulation. A "-" indicates an increase in insertion loss, while a "+" indicates a reduction in the insertion loss of the modulators. A smaller insertion loss is desirable.
- Reduction in energy consumption: the energy required by the modulator to transmit one bit of data. A "-" indicates an increase in energy consumption, while a "+" indicates a reduction in the energy consumption. A smaller energy consumption is desirable. In Example 1.2, the obtained modulators have a large variance in energy consumption.

### Example 2

Examples 2.1 and 2.2 are comparative examples. Example 2.3 is an example according to the invention.

### Example 2.1

An intermediate layered structure, comprising a plurality of elements of the first kind, is provided. The elements of the first kind are waveguides. In a cross-sectional cut of the intermediate layered structure, made at a position of any element of the first kind, the intermediate layered structure has the following layers, arranged in this order:
i. A wafer layer made from crystalline silicon.
ii. A layer of silicon dioxide superimposed directly on the wafer layer.
iii. An element of a first kind superimposed directly on the silicon dioxide layer. The element of the first kind is made from silicon nitride. The element of the first kind has a thickness of 350 nm.
iv. A first section of a first layer of the further kind superimposed directly on the element of the first kind. The first layer of the further kind is made from silicon dioxide, with the first section having a thickness of 1000 nm.

The first layer of the further kind, of the intermediate layered structure, is also arranged partially around the elements of the first kind, such that a further section and an even-further section of the first layer of the further kind are arranged in contact with (touches) each element of the first kind.

The intermediate layered structure is subjected to chemical-mechanical polishing until the first sections of the first layer of the further kind are removed. A layered structure is thereby obtained. For each of the elements of the first kind, a first electrically conducting element in the form of a graphene layer is deposited directly on the layered structure (*cf.* Fig. 9). A plurality of photodetectors are thereby obtained.

### Example 2.2

Example 2.1 is repeated, but with the following difference: the intermediate layered structure is subjected to chemical-mechanical polishing, but only to reduce a thickness of the first sections of the first layer of the further kind. The first sections of the first layer of the further kind are thus not removed.

### Example 2.3

An intermediate layered structure, comprising a plurality of elements of the first kind, is provided. The elements of the first kind are waveguides. In a cross-sectional cut of the intermediate layered structure, made at a position of any element of the first kind, the intermediate layered structure has the following layers, arranged in this order:
i. A wafer layer made from crystalline silicon.
ii. A layer of silicon dioxide superimposed directly on the wafer layer.
iii. An element of a first kind superimposed directly on the silicon dioxide layer. The element of the first kind is made from silicon nitride. The element of the first kind has a thickness of 350 nm.
iv. A first section of a layer of a second kind superimposed directly on the element of the first kind (see, *e.g.,* Figs 3F, 9 and 10). The layer of the second kind is made from silicon carbide. The layer of the second kind has a thickness of 20 nm.
v. A first section of a first layer of the further kind superimposed directly on the first section of the layer of the second kind. The first layer of the further kind is made from silicon dioxide, with the first section of the layer of the further kind having a thickness of 1000 nm.

The layer of the second kind, of the intermediate layered structure, is arranged partially around the elements of the first kind (see, *e.g.,* Figs 3F, 9 and 10). The first layer of the further kind of the intermediate layered structure is also arranged partially around the elements of the first kind and the layer of the second kind. In contrast to Example 1.3, a further section and an even-further section of the first layer of the further kind are not in contact with (does not touch) the element of the first kind (see, *e.g.,* Figs 3F and 10E).

The intermediate layered structure is subjected to chemical-mechanical polishing until the first sections of the first layer of the further kind are removed (see Fig. 3G). During the chemical-mechanical polishing, a material removal rate of the first layer of the further kind is larger than a material removal rate of the layer of the second kind. A layered structure is thereby obtained. For each of the elements of the first kind, a first electrically conducting element in the form of a graphene layer is deposited directly on the layered structure (see Fig. 9). A plurality of photodetectors are thereby obtained.

Table 2 shows a comparison of the technical effects of the methods of Examples 2.1 to 2.3. The number of "-" and "+" indicate the size of the effect, *e.g.,* "--" is less than "-", and "++" is larger than "+". Where indicated, Example 2.1 is used as a reference, and an improvement (or decrease) in a technical effect obtained by Examples 2.2 and 2.3 is thus with respect to Example 2.1.

**Table 2**

| | **Ex. 2.1** | **Ex. 2.2** | **Ex. 2.3** |
|---|---|---|---|
| Height of largest discontinuity | 10 nm | 1 nm | 4 nm |
| Reduction in damage to first graphene layers | Reference | ++ | + |
| Largest distance between waveguide and first graphene layer | 0 nm | 50 nm | 5 nm |
| Uniformity of photodetectors | Reference | -- | ++ |

The technical effects in Table 2 are the same as those for Table 1.

### Example 3

Example 3 is a comparison of photodetectors. Examples 3.1 and 3.2 are comparative examples. Example 3.3 is an example according to the invention. The photodetector of Example 3.1 is obtained by the method described in Example 2.1. The photodetector of Example 3.2 is obtained by the method described in Example 2.2. The photodetector of Example 3.3 is obtained by the method described in Example 2.3. In other words, the photodetectors of Examples 3.1 and 3.2 have no layer of the second kind. The photodetector of Example 3.3 has a layer of the second kind that partially surrounds the waveguide (as illustrated in Figs 9 and 10).

Table 3 shows a comparison of the technical effects of the photodetectors of Examples 3.1 to 3.3. The number of "-" and "+" indicate the size of the effect, *e.g..,* "--" is less than "-", and "++" is larger than "+". Where indicated, Example 3.1 is used as a reference, and an improvement (or decrease) in a technical effect obtained by Examples 3.2 and 3.3 is thus with respect to Example 3.1.

**Table 3**

| | **Ex. 3.1** | **Ex. 3.2** | **Ex. 3.3** |
|---|---|---|---|
| Bitrate | --- | - | + |
| Responsivity | Reference | -- | ++ |
| Reduction in distance between maximum intensity of EM wave and graphene layer | Reference | No change | + |

The technical effects in Table 3 are:
- Bitrate: the rate of data flow in digital networks, typically measured in bits per second. This is the bitrate that is achievable by using the photodetectors according to the examples. A "-" indicates a smaller bitrate, while a "+" indicates a larger bitrate. It is desired to have a larger bitrate.
- Responsivity: the ratio of current output by the photodetector to optical power of the electromagnetic waves propagating in the waveguide of a photodetector. A "-" indicates a lower responsivity, while a "+" indicates a larger responsivity. It is desired to have a larger responsivity.
- Reduction in distance between maximum intensity of EM wave and graphene layer: in Examples 3.1 and 3.2, the maximum intensity of the electromagnetic waves propagating in the waveguides of the photodetectors is located near the centre of the waveguide. In Example 3.3, the maximum intensity is shifter closer to the graphene layer. A "-" indicates a larger distance (less reduction in distance) between the maximum intensity and the graphene layer, while a "+" indicates a smaller distance (larger reduction in distance) between the maximum intensity and the graphene layer. It is desired to have a smaller distance between the maximum intensity and the graphene layer.

### REFERENCE LIST

- 101: Intermediate layered structure
- 102: Element of the first kind
- 103: First surface of the element of the first kind
- 104: Thickness *d₁* of the element of the first kind
- 105: First direction
- 106: Layer of the second kind
- 107: First surface of the layer of the second kind
- 108: Thickness *d₂* of the layer of the second kind
- 109: First layer of the further kind
- 110: First section of the first layer of the further kind
- 111: Further section of the first layer of the further kind
- 112: First distance *l₃*
- 113: Further direction
- 114: First thickness *d_{3A}* of the first section of the first layer of the further kind
- 115: Further thickness *d_{3B}* of the further section of the first layer of the further kind
- 116: First surface of the further section of the first layer of the further kind
- 117: Layered structure
- 118: Initial layered structure
- 119: Wafer layer
- 120: Layer of the additional kind
- 121: Layer of the first kind
- 122: First surface of the layer of the first kind
- 123: Masking layer
- 124: Even-further section of the first layer of the further kind
- 125: Even-further thickness *d_{3C}* of the even-further section of the first layer of the further kind
- 126: Recess
- 127: Depth *D_{R}* of the recess
- 128: Further layer of the further kind
- 129: Thickness *d₄* of further layer of the further kind
- 130: First surface of the further layer of the further kind
- 131: Height *h_{3B}* of the further section of the first layer of the further kind
- 132: Height *h₄* of the further layer of the further kind
- 133: Common plane
- 134: First surface of wafer layer
- 135: Height *h_{1X}* of the element of the first kind
- 136: Layer of an even-further kind
- 137: First surface of the layer of the even-further kind
- 138: Height *h₅* of the layer of the even-further kind
- 139: Height *h_{1Y}* of the element of the first kind
- 140: First surface of the layered structure
- 141: First electrically conducting element
- 142: Further electrically conducting element.
- 143: Dielectric layer
- 144: Height *h₁* of the element of the first kind
- 145: Height *h₂* of the layer of the second kind
- 146: Thickness *d₅* of the layer of the even-further kind
- 147: First section of the layer of the second kind
- 148: Direction for measuring thickness *d_{R}* of the layer of the second kind
- 149: Surface of waveguide
- 150: First surface of the even-further section of first layer of the further kind

## Claims

1. A method for producing a layered structure (117), comprising the steps of
a. providing an intermediate layered structure (101) that comprises
i. an element of a first kind (102), wherein the element of the first kind (102)
A. has a first surface (103),
B. has a thickness *d₁* (104), measured along a first direction (105), wherein *d₁* ≤ 1.5 µm;
ii. a layer of a second kind (106) superimposed on at least the first surface (103) of the element of the first kind (102), wherein the layer of the second kind (106)
A. has a first surface (107),
B. has a thickness *d₂* (108), measured along the first direction (105), wherein *d₂* ≤ 100 nm;
iii. a first layer of a further kind (109) that at least partially surrounds the element of the first kind (102), wherein
A. a first section (110) of the first layer of the further kind (109) is superimposed on the first surface (107) of the layer of the second kind (106),
B. a further section (111) of the first layer of the further kind (109) is arranged at a first distance *l₃* (112) from the element of the first kind (102), wherein
I./ the first distance *l₃* (112) is measured along a further direction (113), wherein the further direction (113) is perpendicular to the first direction (105), and
II./ *l₃* ≤ 100 nm,
C. the first section (110) has a first thickness *d_{3A}* (114) and the further section (111) has a further thickness *d_{3B}* (115), measured along the first direction (105);
b. reducing the first thickness *d_{3A}* (114) using a first thickness-reducing technique, wherein at least one or all of the following applies:
i. *d_{3A}* is reduced by at least 20 %,
ii. after reduction, *d_{3A}* ≤ 100 nm;
wherein
at least one property varies between the layer of the second kind (106) and the element of the first kind (102), the layer of the second kind (106) and the first layer of the further kind (109), or both.

2. The method according to claim 1, wherein the at least one property is at least one or all of the following:
a. a hardness;
b. a chemical reaction rate;
c. an etch rate;
d. a material removal rate;
e. a chemical composition;
f. an oxidation rate;
g. an optical attenuation coefficient;
h. a refractive index;
i. an electrical conductivity;
j. a thermal conductivity;
k. a laser ablation rate.

3. The method according to any of the preceding claims, wherein at least one or all of the following applies:
a. the at least one property is a first etch rate;
b. the at least one property is a first chemical reaction rate;
c. the at least one property is a first material removal rate;
d. the at least one property is a hardness.

4. The method according to any of the preceding claims, wherein at least one or all of the following applies:
a. the thickness *d₂* of the layer of the second kind is *d₂* ≤ 80 nm;
b. the first distance *l₃* is *l₃* ≤ 80 nm.

5. The method according to any of the preceding claims, wherein at least one or all of the following applies:
a. the element of the first kind comprises at least one or all of the following: silicon, oxygen, aluminium, iridium, tantalum, titanium, nitrogen, lithium, niobium, indium, phosphorus, gallium, arsenic, barium, at least one lanthanide, a chalcogenide, at least one polymer, a resin, a combination of at least two thereof;
b. the element of the first kind is an optical element;
c. the element of the first kind is adapted and arranged for the propagation of electromagnetic waves that have wavelengths in the range from 300 nm to 3000 nm.

6. The method according to any of the preceding claims, wherein at least one or all of the following applies:
a. the layer of the second kind comprises at least one or all of the following: at least one metal, at least one metal alloy, at least one oxide, at least one nitride, at least one carbide, a combination of at least two thereof;
b. the layer of the second kind comprises at least one or all of the following: titanium, tungsten, aluminium, molybdenum, carbon, nitrogen, oxygen, silicon, germanium, a combination of at least two thereof.
c. a refractive index of the layer of the second kind is larger than a refractive index of the element of the first kind;
d. the layer of the second kind has a refractive index that is in the range of 1.5 to 6.

7. A method for producing a layered structure (117), comprising the steps of
a. providing an intermediate layered structure (101) that comprises
i. an element of a first kind (102), wherein the element of the first kind (102)
A. has a first surface (103) that is arranged at height *h_{1X}* (135), wherein *h_{1X}* (135) is measured along a first direction (105),
B. has a thickness *d₁* (104), measured along the first direction (105), wherein *d₁* ≤ 1.5 µm;
ii. a first layer of a further kind (109), wherein
A. a further section (111) of the first layer of the further kind (109) is arranged at a first distance *l₃* (112) from the element of the first kind (102), wherein
I./ the first distance *l₃* (112) is measured along a further direction (113), wherein the further direction (113) is perpendicular to the first direction (105), and
II./ *l₃* ≤ 100 nm,
B. the further section (111) has a first surface (116) that is arranged at a height *h_{3B}* (131), wherein *h_{3B}* (131) is measured along the first direction (105),
C. |*h_{3B}* - *h_{1X}*| > 0 nm;
b. Oxidising at least a part of the element of the first kind (102) to form a layer of an even-further kind (136) on the first surface (103) of the element of the first kind (102), wherein
I. the layer of the even-further kind (136) has a first surface (137) that is arranged at a height *h₅* (138), wherein the height *h₅* (138) is measured along the first direction (105), and
II. |*h_{3B}* - *h₅*| < |*h_{3B}* - *h_{1X}*|, with *h_{1X}* (135) being the height of the first surface (103) of the element of the first kind (102) prior to the oxidation step.

8. The method according to claim 7, wherein an oxidation rate of the element of the first kind is larger than an oxidation rate of the further section of the first layer of the further kind.

9. A layered structure obtainable by any of the methods according to any of the claims 1 to 8.

10. A layered structure (117) comprising
a. an element of a first kind (102), wherein the element of the first kind (102)
i. has a first surface (103) that is arranged at height *h₁* (144), wherein *h₁* (144) is measured along a first direction (105),
ii. has a thickness *d₁* (104), measured along the first direction (105), wherein *d₁* ≤ 1.5 µm;
b. a first layer of a further kind (109), wherein
i. a further section (111) of the first layer of the further kind (109) is arranged at a first distance *l₃* (112) from the element of the first kind (102), wherein
A. the first distance *l₃* (112) is measured along a further direction (113), wherein the further direction (113) is perpendicular to the first direction (105), and
B. *l₃* ≤ 100 nm,
ii. the further section (111) of the first layer of the further kind (109) has a first surface (116) that is arranged at a height *h_{3B}* (131), wherein *h_{3B}* (131) is measured along the first direction (105),
wherein at least one or all of the following applies:
I. |*h_{3B}-h₁*| ≤ 15 nm;
II. a gradient of the first surface of the layered structure is less than or equal to 0.1.

11. A layered structure (117) comprising
a. an element of a first kind (102), wherein the element of the first kind (102)
i. has a first surface (103) that is arranged at height *h₁* (144), wherein *h₁* (144) is measured along a first direction (105),
ii. has a thickness *d₁* (104), measured along the first direction (105), wherein *d₁* ≤ 1.5 µm;
b. a levelling layer (106, 136) superimposed on the first surface (103) of the element of the first kind (102), wherein the levelling layer (106, 136)
i. has a first surface that is arranged at height *h_{L},* wherein *h_{L}* is measured along a first direction (105),
ii. has a thickness *d_{L},* measured along the first direction (105), wherein *d_{L}* ≤ 100 nm;
c. a first layer of a further kind (109), wherein
i. a further section (111) of the first layer of the further kind (109) is arranged at a first distance *l₃* (112) from the element of the first kind (102), wherein
A. the first distance *l₃* (112) is measured along a further direction (113), wherein the further direction (113) is perpendicular to the first direction (105), and
B. *l₃* ≤ 100 nm,
ii. the further section (111) of the first layer of the further kind (109) has a first surface (116) that is arranged at a height *h_{3B}* (131), wherein *h_{3B}* (131) is measured along the first direction (105),
wherein at least one or all of the following applies:
I. |*h_{3B}* - *h_{L}*| ≤ 15 nm;
II. a gradient of the first surface of the layered structure is less than or equal to 0.1.

12. A method for producing an opto-electronic device, comprising the steps of
a. providing a layered structure according to any of the claims 9 to 11;
b. superimposing at least one electrically conducting element on the layered structure.

13. An opto-electronic device obtainable according to the method of claim 12.

14. An electronic device comprising
a. an opto-electronic device according to claim 13;
b. at least one electronic constituent in electrical connection with the opto-electronic device.

15. A use of the layered structure according to any of the claims 9 to 11 for producing an opto-electronic device.
